(19) Europäisches Patentamt
European Patent Office
Office européen des brevets

(11) **EP 4 761 538 A1**

(12) **EUROPEAN PATENT APPLICATION**
published in accordance with Art. 153(4) EPC

(43) Date of publication:
**17.06.2026 Bulletin 2026/25**

(21) Application number: **24905997.3**

(22) Date of filing: **25.11.2024**

(51) International Patent Classification (IPC):
***H10K 59/121*** (2023.01)    ***H10K 59/131*** (2023.01)

(52) Cooperative Patent Classification (CPC):
**H10K 59/121; H10K 59/131; H10K 59/35**

(86) International application number:
**PCT/CN2024/134124**

(87) International publication number:
**WO 2025/130512 (26.06.2025 Gazette 2025/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.12.2023 CN 202311785367**

(71) Applicants:
• **Boe Technology Group Co., Ltd.**
**Beijing 100015 (CN)**
• **Chengdu BOE Optoelectronics Technology Co.,
Ltd.**
**Chengdu, Sichuan 611731 (CN)**

(72) Inventors:
• **FANG, Fei**
**Beijing 100176 (CN)**

• **SHI, Ling**
**Beijing 100176 (CN)**
• **ZHOU, Weifeng**
**Beijing 100176 (CN)**
• **HE, Dexing**
**Beijing 100176 (CN)**
• **ZHANG, Yuxin**
**Beijing 100176 (CN)**
• **LIANG, Ke**
**Beijing 100176 (CN)**
• **LI, Lu**
**Beijing 100176 (CN)**

(74) Representative: **Durán-Corretjer, S.L.P.**
**Còrsega, 329
(Paseo de Gracia/Diagonal)
08037 Barcelona (ES)**

(54) **DISPLAY SUBSTRATE AND DISPLAY APPARATUS**

(57)     A display substrate, comprising a base, at least one first display unit located in each display island region, and a plurality of second display units located in a second display region and arranged in an array. The second display region is located on at least one side of the first display region. The first display region comprises a plurality of display island regions and a plurality of light-transmissive regions which are arranged in an array. The first display unit comprises N first light-emitting elements and M first pixel circuits, M and N being both integers greater than 1, and M being less than N. At least one first pixel circuit is connected to at least two first light-emitting elements. A second display unit comprises M second light-emitting elements and M second pixel circuits, the M second pixel circuits being connected on a one-to-one basis to the M second light-emitting elements. The arrangement mode of the N first light-emitting elements of the first display unit is different from the arrangement mode of the M second light-emitting elements of the second display unit.

FIG. 4

## Description

The present application claims the priority to Chinese Patent Application No. 202311785367.4, entitled "Display Substrate and Display Apparatus", filed on December 22, 2023, to the China National Intellectual Property Administration, the contents of which should be regarded as being incorporated herein by reference.

Technical Field

The present disclosure relates to, but is not limited to, the field of display technologies, in particular to a display substrate and a display apparatus.

Background

An organic Light Emitting Diode (OLED) and a Quantum dot Light Emitting Diode (QLED) are active light emitting display devices, and have advantages of self-illumination, a wide viewing angle, a high contrast ratio, low power consumption, an extremely high reaction speed, lightness and thinness, flexibility, and a low cost, etc.

Summary

The following is a summary of subject matters described herein in detail. This summary is not intended to limit the protection scope of claims.

Embodiments of the present application provide a display substrate and a display apparatus.

In one aspect, an embodiment provides a display substrate including a base substrate. The base substrate includes: a first display region and a second display region located on at least one side of the first display region; the first display region includes a plurality of display island regions and a plurality of light-transmitting regions arranged in an array. A display island region includes: at least one first display unit; the at least one first display unit includes: N first light emitting elements and M first pixel circuits, where M and N are both integers greater than 1, and M is less than N; at least one first pixel circuit of the M first pixel circuits is connected with at least two first light emitting elements and configured to drive the at least two first light emitting elements to emit light. The second display region includes a plurality of second display units arranged in an array; at least one second display unit of the plurality of second display units includes: M second light emitting elements and M second pixel circuits connected with the M second light emitting elements in one-to-one correspondence. An arrangement of the N first light emitting elements of the at least one first display unit is different from an arrangement of the M second light emitting elements of the at least one second display unit.

In some exemplary embodiments, in the first display region, the display island regions and the light-transmitting regions are alternately disposed and arranged in alignment in a first direction, and the display island regions and the light-transmitting regions are alternately disposed and arranged in alignment in a second direction; wherein the first direction intersects the second direction.

In some exemplary embodiments, the M first pixel circuits of the at least one first display unit and the M second pixel circuits of the at least one second display unit are arranged in alignment in a first direction or a second direction. Herein the first direction intersects the second direction.

In some exemplary embodiments, the at least one first display unit includes: six first light emitting elements and four first pixel circuits, the four first pixel circuits being sequentially arranged in a first direction. The six first light emitting elements include: two first light emitting elements emitting light of a first color, two first light emitting elements emitting light of a second color, and two first light emitting elements emitting light of a third color. The two first light emitting elements emitting light of the first color is electrically connected with a same first pixel circuit; the two first light emitting elements emitting light of the third color is electrically connected with a same first pixel circuit; and the two first light emitting elements emitting light of the second color are electrically connected with two first pixel circuits in one-to-one correspondence.

In some exemplary embodiments, the six first light emitting elements are divided into two groups of first light emitting elements arranged sequentially in the first direction, each group of first light emitting elements including: one first light emitting element emitting light of the first color, one first light emitting element emitting light of the second color, and one first light emitting element emitting light of the third color. In each group of first light emitting elements, the first light emitting element emitting light of the first color and the first light emitting element emitting light of the second color are sequentially arranged in a second direction, and the first light emitting element emitting light of the third color is located on a same side of the first light emitting element emitting light of the first color and the first light emitting element emitting light of the second color in the first direction; the second direction intersects the first direction.

In some exemplary embodiments, the six first light emitting elements are divided into two groups of first light emitting elements arranged sequentially in the first direction, each group of first light emitting elements including: one first light emitting element emitting light of the first color, one first light emitting element emitting light of the second color, and one first light emitting element emitting light of the third color. In each group of first light emitting elements, the first light emitting element emitting light of the first color, the first light emitting element emitting light of the second color, and the first light emitting element emitting light of the third color are sequentially arranged in the first direction.

In some exemplary embodiments, in the first display region, connection orders of first pixel circuits with the first light emitting elements in first display units within display island regions in adjacent rows are different.

In some exemplary embodiments, in the first display region, four first pixel circuits located in a display island region in an f-th row can be sequentially connected with two first light emitting elements emitting light of the first color, one first light emitting element emitting light of the second color, two first light emitting elements emitting light of the third color, and another first light emitting element emitting light of the second color. Four first pixel circuits located in a first display unit within a display island region in an (f-1)-th row can be sequentially connected with two first light emitting elements emitting light of the third color, one first light emitting element emitting light of the second color, two first light emitting elements emitting light of the first color, and another first light emitting element emitting light of the second color; wherein f is an integer greater than 1.

In some exemplary embodiments, the at least one second display unit includes: four second light emitting elements and four second pixel circuits; the four second pixel circuits are sequentially arranged in the first direction. The four second light emitting elements include one second light emitting element emitting light of the first color, two second light emitting elements emitting light of the second color, and one second light emitting element emitting light of the third color; the second light emitting element emitting light of the first color and the second light emitting element emitting light of the third color are arranged in a same row, and the two second light emitting elements that emit light of the second color are arranged in a same row; the second light emitting elements emitting light of the first color, a second light emitting elements emitting light of the second color, the second light emitting element emitting light of the third color, and a second light emitting elements emitting light of the second color are sequentially arranged in the first direction.

In some exemplary embodiments, the light of the first color is red light, the light of the second color is green light, and the light of the third color is blue light.

In some exemplary embodiments, the M first pixel circuits of the first display unit within the display island region are connected with a first scan transmission section and a second scan transmission section extending in a first direction; the first scan transmission section is configured to transmit a first scan signal, and the second scan transmission section is configured to transmit a second scan signal. First scan transmission sections located within adjacent display island regions in a same row are connected through first scan connection sections; second scan transmission sections located within adjacent display island regions in a same row are connected through second scan connection sections. The second scan connection sections are located on a side of the first scan connection sections away from the base substrate, and orthographic projections of the first scan connection sections on the base substrate are at least partially overlapped with orthographic projections of the second scan connection sections on the base substrate.

In some exemplary embodiments, first pixel circuits of first display units located within display island regions in a same row is also connected with first reset control lines and first initial signal lines extending in the first direction, the first initial signal lines being located on a side of the first reset control lines away from the base substrate; the first scan connection sections are located on a side of the first initial signal lines away from the base substrate. The orthographic projections of the first scan connection sections on the base substrate are at least partially overlapped with orthographic projections of the first initial signal lines on the base substrate; the orthographic projections of the first initial signal lines on the base substrate are at least partially overlapped with orthographic projections of the first reset control lines on the base substrate.

In some exemplary embodiments, the M first pixel circuits of the first display unit within the display island region are connected with a light emitting control transmission section extending in the first direction; the light emitting control transmission section is configured to transmit a light emitting control signal; light emitting control transmission sections located within adjacent display island regions in a same row are connected through light emitting control connection sections. The light emitting control connection sections and the first scan connection sections are located on both sides of light-transmitting regions between adjacent display island regions in a second direction, and the second direction intersects the first direction.

In some exemplary embodiments, first pixel circuits of first display units located within the display island regions in the same row are also connected with second reset control lines and second initial signal lines extending in the first direction, the second initial signal lines being located on a side of the second reset control lines away from the base substrate; the light emitting control connection sections are located on a side of the second initial signal lines away from the base substrate. Orthographic projections of the light emitting control connection sections on the base substrate are at least partially overlapped with orthographic projections of the second initial signal lines on the base substrate; the orthographic projections of the second initial signal lines on the base substrate are at least partially overlapped with orthographic projections of the second reset control lines on the base substrate.

In some exemplary embodiments, the M first pixel circuits of the first display unit within the display island region are also connected with an initial signal transmission section extending in the first direction; the initial signal transmission section is configured to transmit a third initial signal. Initial signal transmission sections located within adjacent display island regions in a same row are connected through initial signal connection sections. The light emitting control connection sections are located on a side of the initial signal connection sections away from the base substrate; orthographic projections of the initial signal connection sections on the base substrate are partially overlapped with orthographic projections of the light emitting control connection sections on the base substrate.

In some exemplary embodiments, a plurality of first pixel circuits located within a display island region in a k-th row and h-th column and a plurality of first pixel circuits located within a display island region in a (k+1)-th row and (h+1)-th column are centrally symmetrical about a connection point of the display island region in the k-th row and h-th column and the display island region in the (k+1)-th row and (h+1)-th column; wherein k and h are both integers greater than 0.

In some exemplary embodiments, in the first display region, first pixel circuits located in an i-th row within display island regions in a k-th row and first pixel circuits located in an (i-1)-th row within display island regions in a (k-1)-th row share a first reset control line, and first pixel circuits located in an (i+e)-th row within display island regions in a k-th row and first pixel circuits located in an (i+e+1)-th row within display island regions in a (k+1)-th row share a second reset control line, wherein i is an integer greater than 1, and e is an integer greater than or equal to 0.

In some exemplary embodiments, in the first display region, the first pixel circuits located in the i-th row within the display island regions in the k-th row and the first pixel circuits located in the (i-1)-th row within the display island regions in the (k-1)-th row share a first initial signal line, and the first pixel circuits located in the (i+e)-th row within the display island regions in the k-th row and the first pixel circuits located in the (i+e+1)-th row within the display island regions in the (k+1)-th row share a second initial signal line.

In some exemplary embodiments, the display island region includes two first display units arranged in a first direction or arranged in a second direction; the first direction intersects the second direction.

In another aspect, an embodiment provides a display apparatus, including the display substrate described above, and a sensor located on a non-display side of the display substrate. An orthographic projection of the sensor on the display substrate is at least partially overlapped with a first display region of the display substrate.

In another aspect, an embodiment provides a display substrate, including a base substrate. the base substrate includes: a first display region and a second display region located on at least one side of the first display region; the first display region includes a plurality of display island regions and a plurality of light-transmitting regions arranged in an array. A display island region includes: at least one group of first pixel circuits and a plurality of first light emitting elements, each group of first pixel circuits including M first pixel circuits, at least one of the M first pixel circuits being connected with at least two first light emitting elements; M is an integer greater than 1. The second display region includes: a plurality of groups of second pixel circuits and a plurality of second light emitting elements, each group of second pixel circuits including M second pixel circuits, and at least one second pixel circuit being connected with at least one second light emitting element. A quantity of first light emitting elements to which each group of first pixel circuits is connected is greater than a quantity of second light emitting elements to which each group of second pixel circuits is connected; an arrangement density of second pixel circuits in the second display region is greater than or equal to an arrangement density of first pixel circuits in the first display region. First pixel circuits and second pixel circuits located in a same column are connected with a same data line.

In some exemplary embodiments, each group of first pixel circuits includes four first pixel circuits connected with six first light emitting elements, the six first light emitting elements includes: two first light emitting elements emitting light of a first color, two first light emitting elements emitting light of a second color, and two first light emitting elements emitting light of a third color. Each group of second pixel circuits includes four second pixel circuits connected with four second light emitting elements, the four second light emitting elements includes one second light emitting element emitting light of the first color, two second light emitting elements emitting light of the second color, and one second light emitting element emitting light of the third color.

In some exemplary embodiments, an arrangement of the six first light emitting elements is different from an arrangement of the four second light emitting elements.

In some exemplary embodiments, an arrangement density of the first pixel circuits in the first display region in a first direction is 0.4 to 0.6 times that of the second pixel circuits in the second display region in the first direction; an arrangement density of the first pixel circuits in the first display region in a second direction is 0.4 to 0.6 times that of the second pixel circuits in the second display region in the second direction.

Other features and advantages of the present application will be set forth in the following specification, and in part will become apparent from the specification, or may be learned by practice of the present application. Other advantages of the present application may be achieved and obtained through solutions described in the specification and drawings.

Brief Description of Drawings

Accompanying drawings are intended to provide an understanding of technical solutions of the present application and form a part of the specification, and are used to explain the technical solutions of the present application together with embodiments of the present application, and do not constitute a limitation on the technical solutions of the present application.

FIG. 1 is a schematic diagram of a display substrate according to at least one embodiment of the present disclosure.

FIG. 2 is an equivalent circuit diagram of a pixel circuit according to at least one embodiment of the present disclosure.

FIG. 3 is a working timing diagram of the pixel circuit provided in FIG. 2.

FIG. 4 is a partial schematic diagram of a display area according to at least one embodiment of the present disclosure.

FIG. 5 is a schematic diagram of a signal correspondence between a first display region and a second display region according to at least one embodiment of the present disclosure.

FIG. 6 is a partial top view of a first display region according to at least one embodiment of the present disclosure.

FIG. 7 is a schematic diagram of the first display region after a shielding layer is formed in FIG. 6.

FIG. 8A is a schematic diagram of the first display region after a first semiconductor layer is formed in FIG. 6.

FIG. 8B is a schematic diagram of a first semiconductor layer in FIG. 8A.

FIG. 9A is a schematic diagram of the first display region after a first conductive layer is formed in FIG. 6.

FIG. 9B is a schematic diagram of the first conductive layer and the first semiconductor layer in FIG. 9A.

FIG. 9C is a schematic diagram of the first conductive layer of FIG. 9A.

FIG. 10A is a schematic diagram of the first display region after a second conductive layer is formed in FIG. 6.

FIG. 10B is a schematic diagram of the second conductive layer in FIG. 10A.

FIG. 11A is a schematic diagram of the first display region after a second semiconductor layer is formed in FIG. 6.

FIG. 11B is a schematic diagram of the second semiconductor layer in FIG. 11A.

FIG. 12A is a schematic diagram of the first display region after a third conductive layer is formed in FIG. 6.

FIG. 12B is a schematic diagram of the third conductive layer in FIG. 12A.

FIG. 13 is a schematic diagram of the first display region after a fifth insulation layer is formed in FIG. 6.

FIG. 14A is a schematic diagram of the first display region after a fourth conductive layer is formed in FIG. 6.

FIG. 14B is a schematic diagram of the fourth conductive layer in FIG. 14A.

FIG. 15 is a schematic diagram of the first display region after a seventh insulation layer is formed in FIG. 6.

FIG. 16A is a schematic diagram of the first display region after a fifth conductive layer is formed in FIG. 6.

FIG. 16B is a schematic diagram of the fifth conductive layer in FIG. 16A.

FIG. 17 is a schematic diagram of the first display region after an eighth insulation layer is formed in FIG. 6.

FIG. 18A is a schematic diagram of the first display region after a sixth conductive layer is formed in FIG. 6.

FIG. 18B is a schematic diagram of the sixth conductive layer in FIG. 18A.

FIG. 19 is a schematic diagram of the first display region after a ninth insulation layer is formed in FIG. 6.

FIG. 20A is a schematic diagram of the first display region after an anode layer is formed in FIG. 6.

FIG. 20B is a schematic diagram of the anode layer in FIG. 20A.

FIG. 21 is a schematic diagram of a light-transmitting region in FIG. 6.

FIG. 22 is another partial top view of a first display region according to at least one embodiment of the present disclosure.

FIG. 23 is a schematic diagram of the first display region after a shielding layer is formed in FIG. 22.

FIG. 24A is a schematic diagram of the first display region after a first semiconductor layer is formed in FIG. 22.

FIG. 24B is a schematic diagram of the first semiconductor layer in FIG. 24A.

FIG. 25A is a schematic diagram of the first display region after a first conductive layer is formed in FIG. 22.

FIG. 25B is a schematic diagram of the first conductive layer in FIG. 25A.

FIG. 26A is a schematic diagram of the first display region after a second conductive layer is formed in FIG. 22.

FIG. 26B is a schematic diagram of the second conductive layer in FIG. 26A.

FIG. 27A is a schematic diagram of the first display region after a second semiconductor layer is formed in FIG. 22.

FIG. 27B is a schematic diagram of the second semiconductor layer in FIG. 27A.

FIG. 28A is a schematic diagram of the first display region after a third conductive layer is formed in FIG. 22.

FIG. 28B is a schematic diagram of the third conductive layer in FIG. 28A.

FIG. 29A is a schematic diagram of the first display region after a fourth conductive layer is formed in FIG. 22.

FIG. 29B is a schematic diagram of the fourth conductive layer in FIG. 29A.

FIG. 30A is a schematic diagram of the first display region after a fifth conductive layer is formed in FIG. 22.

FIG. 30B is a schematic diagram of the fifth conductive layer in FIG. 30A.

FIG. 31A is a schematic diagram of the first display region after a sixth conductive layer is formed in FIG. 22.

FIG. 31B is a schematic diagram of the sixth conductive layer in FIG. 31A.

FIG. 32 is a schematic diagram of the first display region after an anode layer is formed in FIG. 22.

FIG. 33 is a schematic diagram of a light-transmitting region in FIG. 22.

FIG. 34 is another schematic diagram of a signal correspondence between a first display region and a second display region according to at least one embodiment of the present disclosure.

FIG. 35 is another partial schematic diagram of a display area according to at least one embodiment of the present disclosure.

FIG. 36 is a partial top view of a first display region according to at least one embodiment of the present disclosure.

FIG. 37A is a schematic diagram of the first display region after an anode layer is formed in FIG. 36.

FIG. 37B is a schematic diagram of the anode layer in FIG. 37A.

FIG. 38 is another partial schematic diagram of a display area according to at least one embodiment of the present disclosure.

FIG. 39 is another partial schematic diagram of a display area according to at least one embodiment of the present disclosure.

FIG. 40 is a schematic diagram of a display apparatus according to at least one embodiment of the present disclosure.

Detailed Description

The embodiments of the present disclosure will be described in detail hereinafter with reference to the accompanying drawings. A plurality of embodiments is described in the present application. However, the description is exemplary and unrestrictive. Moreover, it is apparent to those of ordinary skills in the art that there may be more embodiments and implementation solutions within the scope of the embodiments described in the present application. Although many possible combinations of features are shown in the drawings and discussed in the implementations, many other combinations of the disclosed features are also possible. Unless expressly limited, any feature or element of any embodiment may be used in combination with, or may replace, any other feature or element in any other embodiment.

The present application includes and conceives combinations of features and elements well known to those of ordinary skills in the art. The embodiments, features, and elements that have been disclosed in the present application may also be combined with any conventional feature or element to form unique inventive solutions. Any feature or element of any embodiment may also be combined with a feature or an element from another inventive solution to form another unique inventive solution. Therefore, it should be understood that any feature shown or discussed in the present application may be implemented independently or in any appropriate combination. Therefore, the embodiments are not to be limited except the limitations by the appended claims and equivalents thereof. In addition, many modifications and variations may be made within the protection scope of the appended claims.

In addition, when a representative embodiment is described, a method or a process may have been already presented as a specific sequence of acts in the specification. However, to an extent that the method or the process does not depend on the specific sequence of the acts described herein, the method or the process should not be limited to the acts with the specific sequence. Those of ordinary skills in the art will understand that other sequences of acts may also be possible. Therefore, the specific sequence of the acts illustrated in the specification should not be interpreted as a limitation on claims. Moreover, execution of the acts in the claims for the method or the process should not be limited to the written sequence, and it may be easily understood by those skilled in the art that these sequences may be changed and still remain within the spirit and scope of the embodiments of the present application.

In the description of the present application, it should be understood that terms indicating orientation or positional relationship such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", and "circumferential" are based on the orientation or positional relationship shown in the accompanying drawings, they are employed for ease of description of the specification and simplification of the description only, but do not indicate or imply that a referred apparatus or element must have a particular orientation, or is constructed and operated in a particular orientation, and therefore cannot be construed as limitations on the present disclosure.

In addition, terms such as "first" and "second" are used for descriptive purposes only and cannot be interpreted as indicating or implying relative importance or implicitly indicating a quantity of technical features indicated. Thus, features defined by "first", "second", and the like may explicitly or implicitly include at least one of the features.

In the description of the present application, "plurality" refers to at least two, for example, two or three, unless otherwise clearly specified.

In the present application, unless otherwise clearly specified and defined, terms such as "installed", "interconnected", "connected", "fixed" should be broadly understood, for example, a "connection" may be a fixed connection, or a detachable connection, or an integral connection; it may be a mechanical connection or an electrical connection; it may be a direct connection, or an indirect connection through middleware, or internal communication between two elements or an interaction between two elements, unless otherwise clearly specified. For those of ordinary skills in the art, meanings of the above terms in the present application may be understood according to situations.

In the present application, an "electrical connection" includes a case that constituent elements are connected together through an element with a certain electrical effect. The "element with a certain electrical effect" is not particularly limited as long as electrical signals between the connected constituent elements can be transmitted. Examples of the "element with a certain electrical effect" not only include an electrode and a wiring, but also include a switching element such as a transistor, a resistor, an inductor, a capacitor, and other elements with a plurality of functions, etc.

In the present application, unless otherwise clearly specified and defined, a first feature being "above" or "under" a second feature may mean that the first feature and the second feature are in direct contact, or the first feature and second feature are in indirect contact through an intermediate medium. Moreover, the first feature being "over", "above", and "on" the second feature may mean that the first feature is directly above or obliquely above the second feature, or simply mean that a horizontal height of the first feature is greater than that of the second feature. The first feature being "below", "beneath", and "under" the second feature may mean that the first feature is directly below or obliquely below the second feature, or simply mean that a horizontal height of the first feature is less than that of the second feature.

In the present application, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the present application, the channel region refers to a region through which the current mainly flows.

In the present application, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the present application. In addition, the gate may also be referred to as a control electrode.

In the present application, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus may include a state in which the angle is above 85° and below 95°.

In the present application, a circle, oval, triangle, rectangle, trapezoid, pentagon, hexagon, or the like is not strictly defined, and it may be an approximate circle, oval, triangle, rectangle, trapezoid, pentagon, hexagon, or the like. There may be some small deformations caused by tolerance, and there may be a chamfer, an arc edge, deformation or the like.

A "light transmittance" in the present application refers to an ability of light to pass through a medium, and is a percentage of luminous flux passing through a transparent or translucent body to the incident luminous flux.

In the present application, "about" and "substantially" refer to that a boundary is not defined strictly and a case within a range of process and measurement errors is allowed. In the present application, "same" may include completely identical and substantially identical cases, and "substantially same" refers to a case where a value differs by less than 10%.

In the present application, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along other directions. "A extends along the B direction" in the present application always means "the main body portion of A extends along the B direction".

With continuous development of display technologies, a camera is usually installed on a display device to meet needs of shooting or face recognition. In order to maximize a screen-to-body ratio, technologies such as bangs screen, water-drop screen, and in-screen punch hole have appeared successively. These technologies reduce the area occupied by the camera by digging a hole locally in a display region and placing the camera under a hole-digging region, thus increasing the screen-to-body ratio. However, the above technologies need to dig out part of the display region, which will cause some regions in a display picture unable to be displayed, and make it impossible to further improve the screen-to-body ratio. In order to avoid punching holes in the display region and under a premise of ensuring practicability of the display substrate, a true full-screen will be achieved by adopting a pixel circuit built-out method or a pixel circuit built-in method in the full display with camera (FDC) region.

The pixel circuit built-out method means that the pixel circuits connected with the light emitting elements in the FDC region is provided in the normal display region, and the light transmittance of the FDC region is improved by arranging the light emitting elements and the pixel circuits separately. Because no pixel circuit is provided in the FDC region, there is no light-shielding layer other than the anodes of the light emitting elements in this region, and a higher light transmittance can be achieved. However, in this mode, the pixel circuits and the light emitting elements need to be electrically connected through conductive connection lines, the size (e.g., aperture) of the FDC region of the display substrate using the pixel circuit built-out method is limited due to the limitation of the space for the arrangement of the conductive connection lines. Increasing the aperture of the FDC region usually requires an increased mask process of the conductive connection lines, resulting in increased cost. Moreover, the material of the conductive connection line is usually a transparent conductive material, such as indium tin oxide (ITO). Due to the large square resistance of ITO, the load of the conductive connection line is large, which easily affects the brightness of the light emitting elements in the FDC region and reduces the brightness of the FDC region, which leads to a display defect in the FDC region, such as a vertical display defect (Mura). Moreover, the use of conductive connection wires tends to introduce more via holes, which will result in a decrease in the aperture ratio of the FDC region, and is not conducive to optimization of light transmittance of the FDC region.

The pixel circuit built-in method refers to the provision of light emitting elements and the pixel circuits connected with the light emitting elements in the FDC region. Compared with the pixel circuit built-out method, the built-in method eliminates the need for long conductive connection lines for the electric connection between the pixel circuits and the light emitting elements in the FDC region, which can avoid the display defect of the FDC region caused by the conductive connection lines. Moreover, the built-in method does not limit the size of the FDC region and can support the FDC region with large aperture. However, for complex pixel circuits, due to the large number of wires, it is difficult to improve the light transmittance of the FDC region through layout compression of the pixel circuits, resulting in a failure to meet the light transmittance required for functions such as under-screen shooting or under-screen face recognition.

For the pixel circuit built-in method, some light emitting elements and pixel circuits in the FDC region can be deleted, so that the retained light emitting elements and pixel circuits can not be compressed, thereby achieving the light transmittance requirement of the under-screen function. However, when the light transmittance is improved by deleting some light emitting elements and pixel circuits in the FDC region, the display effect is easily affected.

The present embodiment provides a display substrate and a display apparatus, which can not only improve the light transmittance of an under-screen camera area, but also make up for the loss of display effect caused by deleting some light emitting elements and pixel circuits in the FDC region.

The present embodiment provides a display substrate, including a base substrate, at least one first display unit located in a display island region, and a plurality of second display units located in a second display region and arranged in an array. The base substrate includes a first display region and a second display region located on at least one side of the first display region. The first display region includes a plurality of display island regions and a plurality of light-transmitting regions arranged in an array. The at least one first display unit includes N first light emitting elements and M first pixel circuits, M and N are both integers greater than 1, and M is less than N. At least one first pixel circuit of the M first pixel circuits is connected with at least two first light emitting elements and configured to drive the at least two first light emitting elements to emit light. The at least one second display unit includes M second light emitting elements and M second pixel circuits, and the M second pixel circuits are connected with the M second light emitting elements in one-to-one correspondence. An arrangement of the N first light emitting elements of the at least one first display unit is different from an arrangement of the M second light emitting elements of the at least one second display unit.

In some examples, shapes and sizes of the plurality of display island regions of the first display region may be substantially the same, and shapes and sizes of the plurality of light-transmitting regions may be substantially the same. The light-transmitting regions may be formed by reducing the first pixel circuits and the first light emitting elements, and the number of the deleted first pixel circuits corresponding to the light-transmitting regions may be less than or equal to a total number of the first pixel circuits included in the plurality of display island regions.

In some examples, at least one first pixel circuit within the first display unit may be connected with at least two first light emitting elements, and at least one first pixel circuit may be connected with at least one first light emitting element. For example, the first display unit may include four first pixel circuits, wherein two of the first pixel circuits may be connected with the first light emitting elements in a one-drive-two manner, and two of the first pixel circuits may be connected with the first light emitting elements in a one-drive-one manner. In this example, "one drive F" means that one pixel circuit is connected with F light emitting elements, and the pixel circuit drives the connected F light emitting elements to emit light, and F is an integer greater than or equal to 1. For example, "one drive one" means that one pixel circuit is connected with one light emitting element and drives the connected one light emitting element to emit light; "one drive two" means that one pixel circuit is connected with the two light emitting elements and drives the two connected light emitting elements to emit light. However, the present embodiment is not limited thereto. In other examples, the first pixel circuits in the first display unit may be connected with the first light emitting elements in another one-drive-more manner such as in one-drive three manner or in one-drive four manner.

In some examples, the second pixel circuits in the second display unit may be connected with the second light emitting elements in a one-drive-one manner. An arrangement density of the second pixel circuits in the second display region may be greater than or equal to an arrangement density of the first pixel circuits in the first display region. For example, an arrangement density of the first pixel circuits in the first display region in a first direction may be 0.4 to 0.6 times that of the second pixel circuits in the second display region in the first direction, such as may be 0.45 to 0.55 times, such as may be about 0.5 times; alternatively, an arrangement density of the first pixel circuits in the first display region in a column direction may be 0.4 to 0.6 times that of the second pixel circuits in the second display region in the column direction, such as may be 0.45 to 0.55 times, such as may be about 0.5 times. In this example, by reducing the first pixel circuits of the first display region, the light transmittance of the first display region can be improved.

In some examples, the light transmittance of the second display region may be less than the light transmittance of the first display region.

The display substrate provided in this embodiment adopts a pixel circuit built-in method to reduce the first pixel circuits and the first light emitting elements in the first display region to form the light-transmitting regions, and an arrangement of the first light emitting elements is different from an arrangement of the second light emitting elements, which can ensure the display effect of the first display region on the basis of improving the light transmittance of the first display region, and make up for the loss of display effect caused by reducing some light emitting elements and pixel circuits in the first display region.

In some exemplary embodiments, each display island region may include one first display unit. In other examples, at least one display island region may include a plurality of first display units, e.g. include two first display units. The two first display units within the display island region may be arranged in the first direction, or may be arranged in the second direction. Herein, the first direction may intersect the second direction, for example, the first direction may be perpendicular to the second direction. In some examples, the first direction may be parallel to a row direction of display island regions arranged in array, and the second direction may be parallel to a column direction of display island regions arranged in array. The present embodiment is not limited thereto.

In some exemplary embodiments, in the first display region, a plurality of display island regions and a plurality of light-transmitting regions are alternately disposed and arranged in alignment in the first direction, and a plurality of display island regions and a plurality of light-transmitting regions are alternately disposed and arranged in alignment in the second direction. Herein, the second direction may intersect the first direction. However, the present embodiment is not limited thereto. In other examples, in the second direction, the plurality of display island regions may be arranged continuously and in a staggered manner. The arrangement of the display island regions and the light-transmitting regions of the first display region in this example is advantageous in improving the light transmittance of the first display region.

In this example, alternately disposing A and B in direction C, means that A and B are arranged at intervals in the direction C, that is, A and B are periodically arranged in an order of A and B along the direction C. The arrangement of A and B in alignment in direction C means that center lines of A and B in a direction perpendicular to direction C substantially coincide, and edge extension lines of A and B may substantially coincide. A and B being arranged in a staggered manner in direction C means that center lines of A and B in a direction perpendicular to direction C are substantially parallel and do not coincide.

In some exemplary embodiments, the M first pixel circuits of the at least one first display unit and the M second pixel circuits of the at least one second display unit are arranged in alignment in the first direction or the second direction. In this example, the first pixel circuits of the first display region and the second pixel circuits of the second display region may share signal wirings extending in the first direction (including, for example, a first scan line, a second scan line, a light emitting control line, etc.), and may share signal wires extending in the second direction (including, for example, data lines, etc.), thereby facilitating wiring arrangement.

In some exemplary embodiments, at least one first display unit may include six first light emitting elements and four first pixel circuits, and the four first pixel circuits are sequentially arranged in the first direction. The six first light emitting elements include: two first light emitting elements emitting light of a first color, two first light emitting element emitting light of a second color, and two first light emitting elements emitting light of a third color. The two light emitting element emitting light of the first color is electrically connected with a same first pixel circuit; the two first light emitting element emitting light of the third color is electrically connected with a same first pixel circuit; and the two first light emitting elements emitting light of the second color are electrically connected with two first pixel circuits in one-to-one correspondence. For example, the light of the first color may be red light, the light of the second color may be green light, and the light of the third color may be blue light. The first light emitting elements in the first display region of the present example may be arranged in an RGB manner, which is beneficial to improving the display effect of the first display region.

In some exemplary embodiments, the six first light emitting elements of the first display unit may be divided into two groups of first light emitting elements, and the two groups of first light emitting elements are sequentially arranged in the first direction. Each group of first light emitting elements includes one first light emitting element emitting light of the first color, one first light emitting element emitting light of the second color, and one first light emitting element emitting light of the third color. In each group of first light emitting elements, the first light emitting element emitting light of the first color and the first light emitting element emitting light of the second color may be arranged sequentially in the second direction, and the first light emitting element emitting light of the third color may be located on a same side of the first light emitting element emitting light of the first color and the first light emitting element emitting light of the second color in the first direction. Alternatively, in each group of first light emitting elements, the first light emitting element emitting light of the first color, the first light emitting element emitting light of the second color, and the first light emitting element emitting light of the third color may be sequentially arranged in the first direction. The arrangement of the first light emitting elements in the first display region of the present example can optimize the display effect of the first display region.

In some exemplary embodiments, at least one second display unit may include: four second light emitting elements and four second pixel circuits; the four second pixel circuits are sequentially arranged in the first direction. The four second light emitting elements may include one second light emitting element emitting light of the first color, two second light emitting elements emitting light of the second color, and one second light emitting element emitting light of the third color. The second light emitting element emitting light of the first color and the second light emitting element emitting light of the third color are arranged in a same row, and the two second light emitting elements that emit light of the second color are arranged in a same row; the second light emitting elements emitting light of the first color, a second light emitting elements emitting light of the second color, the second light emitting element emitting light of the third color, and a second light emitting elements emitting light of the second color are sequentially arranged in the first direction. For example, the first color light is red light, the second color light is green light, and the third color light is blue light. In this example, the second display region may adopt an arrangement of RGBG, and the display effect of the second display region can be guaranteed.

In some exemplary embodiments, in the first display region, connection orders of first pixel circuits with the first light emitting elements in first display units within display island regions in adjacent rows are different. In some examples, four first pixel circuits of the first display unit located in a display island region in an f-th row can be sequentially connected with two first light emitting elements emitting light of the first color, one first light emitting element emitting light of the second color, two first light emitting elements emitting light of the third color, and another first light emitting element emitting light of the second color. The four first pixel circuits of a first display unit within a display island region in an (f-1)-th row can be sequentially connected with two first light emitting elements emitting light of the third color, one first light emitting element emitting light of the second color, two first light emitting elements emitting light of the first color, and another first light emitting element emitting light of the second color. Herein, f may be an integer greater than 1. The connection mode of the first pixel circuits with the first light emitting elements in the display island regions of the present example may be beneficial to optimizing display uniformity in the first display region.

In some exemplary embodiments, in the first display region, the M first pixel circuits of the first display unit within the display island region are connected with a first scan transmission section and a second scan transmission section extending in a first direction. The first scan transmission section is configured to transmit the first scan signal, and the second scan transmission section is configured to transmit the second scan signal. First scan transmission sections in a same row located within adjacent display island regions are connected through first scan connection sections; second scan transmission sections located in a same row within adjacent display island regions may be connected through second scan connection sections. For example, the first scan lines may include first scan transmission sections and first scan connection sections connected at intervals in a first direction, the first scan transmission sections and the first scan connection sections being located at different films; the second scan lines may include second scan transmission sections and second scan connection sections connected at intervals in the first direction, and the second scan transmission section and the second scan connection section are located at different films. The second scan connection sections may be located on a side of the first scan connection sections away from the base substrate, and orthographic projections of the first scan connection sections on the base substrate may at least partially overlapped with orthographic projections of the second scan connection sections on the base substrate. For example, the first scan transmission sections may be located in the first conductive layer, and the first scan connection sections may be located in the fourth conductive layer; the second scan transmission sections may be located in the third conductive layer, and the second scan connection sections may be located in the fifth conductive layer. In this example, the transmission wirings of the first scan signal and the second scan signal are segmented and cross-layer connected, so that the first scan connection sections and the second scan connection sections can be overlapped in wiring, which is beneficial to increasing the area of the light-transmitting region, and further improving the light transmittance of the first display region.

In some exemplary embodiments, first pixel circuits of first display units located within display island regions in a same row may be connected with first reset control lines and first initial signal lines extending in the first direction, and the first initial signal lines may be located on a side of the first reset control lines away from the base substrate. The first scan connection sections may be located on a side of the first initial signal lines away from the base substrate. The orthographic projections of the first scan connection sections on the base substrate may be at least partially overlapped with orthographic projections of the first initial signal lines on the base substrate, and the orthographic projections of the first initial signal lines on the base substrate may be at least partially overlapped with orthographic projections of the first reset control lines on the base substrate. For example, the first initial signal lines may be located in the third conductive layer, the first reset control lines may be located in the first conductive layer, and the first scan connection sections may be located in the fourth conductive layer. In this example, the first reset control lines, the first initial signal lines, and the first scan connection sections being overlapped in wiring can be beneficial to increasing the area of the light-transmitting region, thereby improving the light transmittance of the first display region.

In some exemplary embodiments, the M first pixel circuits of the first display unit within the display island region may be connected with a light emitting control transmission section extending in the first direction; the light emitting control transmission section may be configured to transmit a light emitting control signal. Light emitting control transmission sections located within adjacent display island regions in a same row may be connected through light emitting control connection sections. For example, light emitting control lines may include light emitting control transmission sections and light emitting control connection sections connected at intervals in the first direction, and the light emitting control transmission sections and the light emitting control connection sections are located in different films. For example, the light emitting control transmission sections may be located in the first conductive layer, and the light emitting control connection sections may be located in the fourth conductive layer. The light emitting control connection sections and the first scan connection sections may be located on both sides of light-transmitting regions between adjacent display island regions in the column direction. In this example, the first scan connection sections and the light emitting control connection sections bypass the light-transmitting region from both sides of the light-transmitting regions in the column direction, so that the wiring space can be optimized, and the area of the light-transmitting region can be increased, thereby improving the light transmittance of the first display region.

In some exemplary embodiments, first pixel circuits of first display units located within the display island regions in a same row may be connected with second reset control lines and second initial signal lines extending in the first direction, and the second initial signal lines may be located on a side of the second reset control lines away from the base substrate; the light emitting control connection sections may be located on a side of the second initial signal lines away from the base substrate. Orthographic projections of the light emitting control connection sections on the base substrate may be at least partially overlapped with orthographic projections of the second initial signal lines on the base substrate. The orthographic projections of the second initial signal lines on the base substrate may be at least partially overlapped with orthographic projections of the second reset control lines on the base substrate. For example, the second reset control lines may be located in the first conductive layer, the second initial signal line may be located in the third conductive layer, and the light emitting control connection sections may be located in the fourth conductive layer. In this example, the second reset control lines, the second initial signal lines, and the light emitting control connection sections being overlapped in wiring can be beneficial to increasing the area of the light-transmitting region, thereby improving the light transmittance of the first display region.

In some exemplary embodiments, the M first pixel circuits of the first display unit within the display island region may be connected with an initial signal transmission section extending in the first direction; the initial signal transmission section may be configured to transmit a third initial signal. Initial signal transmission sections located within adjacent display island regions in a same row may be connected through initial signal connection sections. For example, the third initial signal lines may include initial signal transmission sections and initial signal connection sections connected at intervals in the first direction, and the initial signal transmission sections and the initial signal connection sections may be located in different films. The light emitting control connection sections are located on a side of the initial signal connection sections away from the base substrate. Orthographic projections of the initial signal connection sections on the base substrate may be partially overlapped with orthographic projections of the light emitting control connection sections on the base substrate. For example, the initial signal transmission sections may be located in the third conductive layer, the initial signal connection sections may be located in the second conductive layer, and the light emitting control connection sections may be located in the fourth conductive layer. In this example, the initial signal connection sections and the light emitting control connection sections are overlapped in wiring can be beneficial to increasing the area of the light-transmitting region, thereby improving the light transmittance of the first display region.

In some exemplary embodiments, a plurality of first pixel circuits located within a display island region in a k-th row and h-th column and a plurality of first pixel circuits located within a display island region in a (k+1)-th row and (h+1)-th column may be centrally symmetrical about a connection point of the display island region in the k-th row and h-th column and the display island region in the (k+1)-th row and (h+1)-th column. Herein k and h are both integers greater than 0. In this example, first pixel circuits within display island regions in even-numbered rows or odd-numbered rows are mirrored to the first pixel circuits within display island regions in adjacent odd-numbered rows or even-numbered rows so that the first pixel circuits in display island region in adjacent rows and adjacent columns are centrally symmetrical, which can be beneficial to reduce the wiring space in the display island regions and increase the area of the light-transmitting region, thereby improving the light transmittance of the first display region.

In some exemplary embodiments, in the first display region, first pixel circuits located in an i-th row within display island regions in a k-th row and first pixel circuits located in an (i-1)-th row within display island regions in a (k-1)-th row may share a first reset control line, and first pixel circuits located in an (i+e)-th row within display island regions in a k-th row and first pixel circuits located in an (i+e+1)-th row within display island regions in a (k+1)-th row may share a second reset control line, wherein i is an integer greater than 1, and e is an integer greater than or equal to 0. In some examples, a row of first pixel circuits may be disposed for display island regions in each row, and e may be 0; the first pixel circuits located in the i-th row within the display island regions in the k-th row and the first pixel circuits located in the (i-1)-th row within the display island regions in the (k-1)-th row may share a first reset control line, and the first pixel circuits located in the i-th row within the display island regions in the k-th row and first pixel circuits located in an (i+1)-th row within display island regions in a (k+1)-th row may share a second reset control line. In other examples, the display island regions in each row includes at least two rows of first pixel circuits, and e may be greater than or equal to 1. For example, the display island regions in each row may include two rows of first pixel circuits, and e may be 1. The first pixel circuits located in the i-th row within the display island regions in the k-th row and the first pixel circuits located in the (i-1)-th row within the display island regions in the (k-1)-th row may share a first reset control line, and first pixel circuits located in the (i+1)-th row within the display island regions in the k-th row and first pixel circuits located in an (i+2)-th row within display island regions in a (k+1)-th row may share a second reset control line. In this example, by disposing two adjacent rows of first pixel circuits in display island regions in adjacent rows to share the first reset control lines or the second reset control lines, it is beneficial to reduce the wiring space and increase the area of the light-transmitting region, thereby improving the light transmittance of the first display region.

In some exemplary embodiments, in the first display region, the first pixel circuits located in the i-th row within the display island regions in the k-th row and the first pixel circuits located in the (i-1)-th row within the display island regions in the (k-1)-th row may share a first initial signal line, and the first pixel circuits located in the (i+e)-th row within the display island regions in the k-th row and the first pixel circuits located in the (i+e+1)-th row within the display island regions in the (k+1)-th row may share a second initial signal line. In some examples, a row of first pixel circuits may be disposed for display island regions in each row, and e may be 0; the first pixel circuits located in the i-th row within the display island regions in the k-th row and the first pixel circuits located in the (i-1)-th row within the display island regions in the (k-1)-th row may share a first initial signal line, and the first pixel circuits located in the i-th row within the display island regions in the k-th row and the first pixel circuits located in the (i+1)-th row within the display island regions in the (k+1)-th row may share a second initial signal line. In other examples, display island regions in each row includes at least two rows of first pixel circuits, and e may be greater than or equal to 1. For example, the display island regions in each row may include two rows of first pixel circuits, and e may be 1. The first pixel circuits located in the i-th row within the display island regions in the k-th row and the first pixel circuits located in the (i-1)-th row within the display island regions in the (k-1)-th row may share a first initial signal line, and the first pixel circuits located in the (i+1)-th row within the display island regions in the k-th row and the first pixel circuits located in the (i+2)-th row within the display island regions in the (k+1)-th row may share a second initial signal line. In this example, by disposing two adjacent rows of first pixel circuits in display island regions in adjacent rows to share the first initial signal lines or the second initial signal lines, it is beneficial to reduce the wiring space and increase the area of the light-transmitting region, thereby improving the light transmittance of the first display region.

Solutions of the embodiments will be described below through some examples.

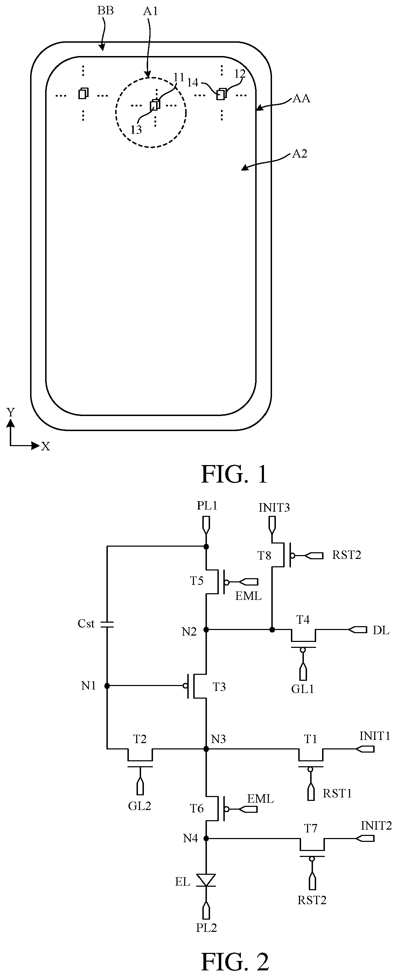

FIG. 1 is a schematic diagram of a display substrate according to at least one embodiment of the present disclosure. In some examples, as shown in FIG. 1, the display substrate may include a display area AA and a peripheral area BB located at a periphery of the display area AA. The display area AA may include at least a first display region A1 and a second display region A2, and the second display region A2 may at least partially surround the first display region A1. For example, the second display region A2 may surround a periphery of the first display region A1. The peripheral region BB may surround a periphery of the second display region A2. However, the present embodiment is not limited thereto.

In some examples, as shown in FIG. 1, the first display region A1 may be referred to as a Full Display with Camera (FDC) region. The second display region A2 may also be referred to as a normal display region. A light transmittance of the first display region A1 may be greater than a light transmittance of the second display region A2. For example, an orthographic projection of a sensor (such as a camera and other hardware) on the display substrate may be located in the first display region A1 of the display substrate. In some examples, as shown in FIG. 1, the first display region A1 may be circular, and a size of the orthographic projection of the sensor on the display substrate may be less than or equal to a size of the first display region A1. In some other examples, the first display region A1 may be rectangular, and a size of the orthographic projection of the sensor on the display substrate may be less than or equal to a size of an inscribed circle of the first display region A1. The present embodiment is not limited thereto.

In some examples, as shown in FIG. 1, the first display region A1 may be located at a middle position on a top of the display area AA. The second display region A2 may surround a periphery of the first display region A1. However, the present embodiment is not limited thereto. For example, the first display region A1 may be located in other positions such as an upper left corner, a lower left corner, a lower right corner or an upper right corner of the display area AA. For example, the second display region A2 may surround at least one side of the first display region A1.

In some examples, as shown in FIG. 1, the display area AA may be in a shape of a rectangle, e.g., a rounded rectangle. The first display region A1 may be circular or elliptical. However, the present embodiment is not limited thereto. For example, the first display region A1 may be rectangular, semicircular, pentagonal, or another shape.

In some examples, the display area AA may be provided with a plurality of sub-pixels. At least one sub-pixel may include a pixel circuit and a light emitting element. The pixel circuit may be configured to drive a light emitting element connected thereto. For example, the pixel circuit may be configured to provide a drive current for driving the light emitting element to emit light. The pixel circuit may include a plurality of transistors and at least one capacitor. For example, the pixel circuit may have a 3T1C, 4T1C, 5T1C, 5T2C, 6T1C, 7T1C, or 8T1C structure. In the aforementioned circuit structures, T refers to a thin film transistor, C refers to a capacitor, the number before T represents a quantity of thin film transistors in the circuit, and the number before C represents a quantity of capacitors in the circuit.

In some examples, the light emitting element may be any one of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, or the like under drive of a pixel circuit corresponding to the light emitting element. A color of light emitted by the light emitting element may be determined as required. In some examples, the light emitting element may include an anode, a cathode, and an organic light emitting layer located between the anode and the cathode. The anode of the light emitting element may be electrically connected with a corresponding pixel circuit. However, the present embodiment is not limited thereto.

FIG. 2 is an equivalent circuit diagram of a pixel circuit according to at least one embodiment of the present disclosure. The pixel circuit in this example is described by taking an 8T1C structure as an example. In some examples as,

shown in FIG. 2, the pixel circuit of this example may include eight transistors (i.e., a first transistor T1 to an eighth transistor T8) and one storage capacitor Cst. The first transistor T1 may be referred to as a first reset transistor, the second transistor T2 may be referred to as a threshold compensation transistor, the third transistor T3 may be referred to as a drive transistor, the fourth transistor T4 may be referred to as a data writing transistor, the fifth transistor T5 may be referred to as a first light emitting control transistor, the sixth transistor T6 may be referred to as a second light emitting control transistor, the seventh transistor T7 may be referred to as a second reset transistor, and the eighth transistor T8 may be referred to as a third reset transistor. A light emitting element EL may include an anode, a cathode and an organic light emitting layer disposed between the anode and the cathode.

In some examples, the first transistor T1, the third transistor T3 to the eighth transistor T8 may be first-type transistors, which may be, for example, P-type transistors, and the second transistor T2 may be a second-type transistor, which may be, for example, an N-type transistor. However, the present embodiment is not limited thereto. For example, the plurality of transistors of the pixel circuit may be all P-type transistors, or all N-type transistors.

In some examples, for the first-type transistors (e.g., including the first transistor T1 and the third transistor T3 to the eighth transistor T8) of the pixel circuit, a low temperature poly silicon thin film transistor may be used, and for the second-type transistor (e.g., including the second transistor T2) of the pixel circuit, an oxide thin film transistor may be used. Low Temperature Poly Silicon (LTPS) is used for an active layer of a low temperature poly silicon thin film transistor and an oxide semiconductor (Oxide) is used for an active layer of an oxide thin film transistor. A low temperature poly silicon thin film transistor has advantages such as a high mobility rate and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPS+Oxide) display substrate, and advantages of both the low temperature poly silicon thin film transistor and the oxide thin film transistor may be utilized, which may achieve low-frequency drive, power consumption reducing, and display quality being improved.

In some examples, as shown in FIG. 2, the pixel circuits may be electrically connected with a first scan line GL1, a second scan line GL2, a data line DL, a first power supply line PL1, a second power supply line PL2, a light emitting control line EML, a first initial signal line INIT1, a second initial signal line INIT2, a third initial signal line INIT3, a first reset control line RST1, and a second reset control line RST2. The first power supply line PL1 may be configured to provide a constant first voltage signal VDD to the pixel circuit, the second power supply line PL2 may be configured to provide a constant second voltage signal VSS to the pixel circuit, and the first voltage signal VDD is greater than the second voltage signal VSS. The first scan line GL1 may be configured to provide a first scan signal SCAN1 to the pixel circuit. The second scan line GL2 may be configured to provide a second scan signal SCAN2 to the pixel circuit. The data line DL may be configured to provide a data signal to the pixel circuit. The light emitting control line EML may be configured to provide a light emitting control signal EM to the pixel circuit. The first reset control line RST1 may be configured to provide a first reset control signal RESET1 to the pixel circuit. The second reset control line may be configured to provide a second reset control signal RESET2 to the pixel circuit.

In some examples, as shown in FIG. 2, a gate of the third transistor T3 is electrically connected with a first node N1, a first electrode of the third transistor T3 is electrically connected with a second node N2, and a second electrode of the third transistor T3 is electrically connected with a third node N3. A gate of the fourth transistor T4 is electrically connected with the first scan line GL1, a first electrode of the fourth transistor T4 is electrically connected with the data line DL, and a second electrode of the fourth transistor T4 is electrically connected with the second node N2. A gate of the second transistor T2 is electrically connected with the second scan signal line GL2, a first electrode of the second transistor T2 is electrically connected with the third node N3, and a second electrode of the second transistor T2 is electrically connected with the first node N1. A gate of a fifth transistor T5 is electrically connected with the light emitting control line EML, a first electrode of the fifth transistor T5 is electrically connected with the first power supply line PL1, and a second electrode of the fifth transistor T5 is electrically connected with the second node N2. A gate of a sixth transistor T6 is electrically connected with the light emitting control line EML, a first electrode of the sixth transistor T6 is electrically connected with the third node N3, and a second electrode of the sixth transistor T6 is electrically connected with a fourth node N4. A gate of the first transistor T1 is electrically connected with the first reset control line RST1, a first electrode of the first transistor T1 is electrically connected with the first initial signal line INIT1, and a second electrode of the first transistor T1 is electrically connected with the third node N3. The first transistor T1 may be configured to reset the third node N3. A gate of a seventh transistor T7 is electrically connected with the second reset control line RST2, a first electrode of the seventh transistor T7 is electrically connected with the second initial signal line INIT2, and a second electrode of the seventh transistor T7 is electrically connected with the fourth node N4. The seventh transistor T7 may be configured to reset the fourth node N4. A gate of the eighth transistor T8 is electrically connected with the second reset control line RST2, a first electrode of the eighth transistor T8 is electrically connected with the third initial signal line INIT3, and a second electrode of the eighth transistor T8 is electrically connected with the second node N2. The eighth transistor T8 may be configured to reset the second node N2. A first electrode of the storage capacitor Cst is electrically connected with the first node N1, and a second electrode of the storage capacitor Cst is electrically connected with the first power supply line PL1.

In the example, the first node N1 is a connection point of the storage capacitor Cst, the second transistor T2, and the third transistor T3, the second node N2 is a connection point of the fifth transistor T5, the fourth transistor T4, the eighth transistor T8, and the third transistor T3, the third node N3 is a connection point of the first transistor T1, the third transistor T3, the second transistor T2, and the sixth transistor T6, and the fourth node N4 is a connection point of the sixth transistor T6, the seventh transistor T7, and the light emitting element EL.

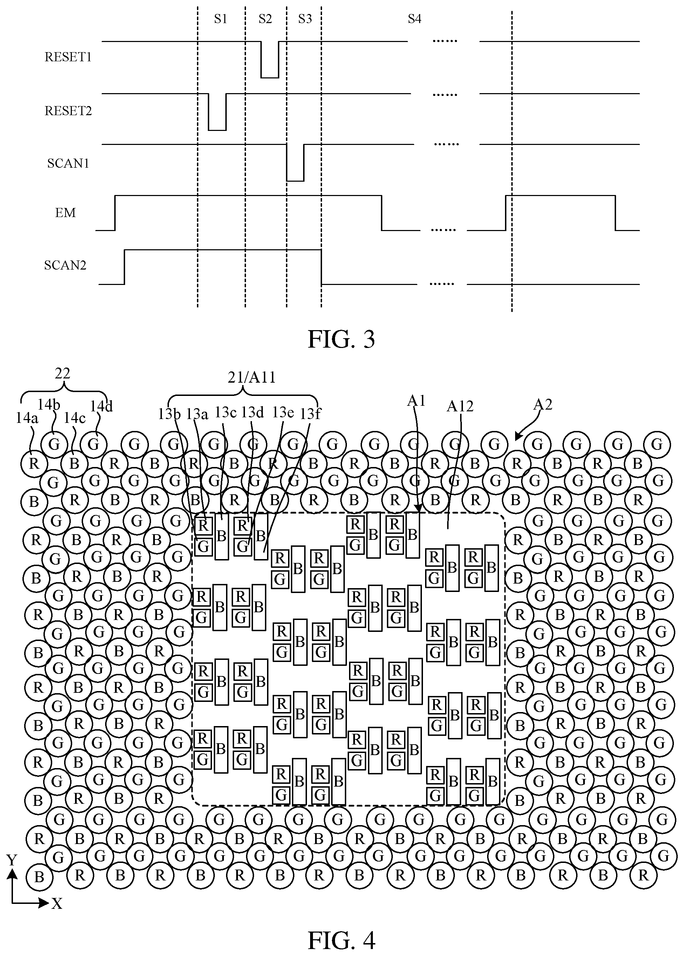

FIG. 3 is a working timing diagram of the pixel circuit provided in FIG. 2. A working process of the pixel circuit shown in FIG. 2 will be described below with reference to FIG. 3. Herein, the first transistor T1, the third transistor T3 to the eighth transistor T8 of the pixel circuit are P-type transistors, and the second transistor T2 is an N-type transistor.

In some examples, as shown in FIGS. 2 and 3, during one frame of display period, the working process of the pixel circuit may at least include a first stage S1, a second stage S2, a third stage S3, and a fourth stage S4.

The first stage S1 is referred to as a first reset stage. In the first stage S1, the second reset control signal RESET2 provided by the second reset control line RST2 is a low-level signal, used to turn on the seventh transistor T7 and the eighth transistor T8, and the second scan signal SCAN2 provided by the second scan line GL2 is a high-level signal, used to turn on the second transistor T2. The eighth transistor T8 is turned on so that the third initial signal provided by the third initial signal line INIT3 is provided to the second node N2. The seventh transistor T7 is turned on so that the second initial signal provided by the second initial signal line INIT2 is provided to the fourth node N4 to initialize the fourth node N4. The first scan signal SCAN1 provided by the first scan line GL1 is a high-level signal, the first reset control signal RESET1 provided by the first reset control line RST1 is a high-level signal, and the light emitting control signal EM provided by the light emitting control line EML is a high-level signal, so that the fourth transistor T4, the first transistor T1, the fifth transistor T5 and the sixth transistor T6 are turned off. In this stage, the light emitting element EL does not emit light.

The second stage S2 is referred to as a second reset stage. In the second stage S2, the first reset control signal RESET1 provided by the first reset control line RST1 is a low-level signal, and the first transistor T1 is turned on. The second scan signal SCAN2 provided by the second scan line GL2 is a high-level signal, and the second transistor T2 is turned on. The first transistor T1 and the second transistor T2 are turned on such that a first initial signal provided by the first initial signal line INIT1 is provided to the first node N1 to initialize the first node N1. The second reset control signal RESET2 provided by the second reset control line RST2 is a high-level signal, the first scan signal SCAN1 provided by the first scan line GL1 is a high-level signal, and the light emitting control signal EM provided by the light emitting control line EML is a high-level signal, so that the seventh transistor T7, the eighth transistor T8, the fourth transistor T4, the fifth transistor T5 and the sixth transistor T6 are turned off. In this stage, the light emitting element EL does not emit light.

The third stage S3 is referred to as a data writing stage or a threshold compensation stage. The first scan signal SCAN1 provided by the first scan line GL1 is a low-level signal, and the fourth transistor T4 is turned on. The second scan signal SCAN2 provided by the second scan line GL2 is a high-level signal, and the second transistor T2 is turned on. In this stage, the first electrode of the storage capacitor Cst is at a low level and the third transistor T3 is turned on. The second transistor T2, the fourth transistor T4 and the third transistor T3 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first electrode (i.e., the first node N1) of the storage capacitor Cst is Vdata-|Vth|, wherein Vdata is the data voltage output by the data line DL, and Vth is the threshold voltage of the third transistor T3. The first reset control signal RESET1 provided by the first reset control line RST1 is a high-level signal, the second reset control signal RESET2 provided by the second reset control line RST2 is a high-level signal, and the light emitting control signal EM provided by the light emitting control line EML is a high-level signal, so that the first transistor T1, the seventh transistor T7, the eighth transistor T8, the fifth transistor T5 and the sixth transistor T6 are turned off.

In the fourth stage S4, the light emitting control signal EM provided by the light emitting control line EML can be switched from the high-level signal to a low-level signal, so that the fifth transistor T5 and the sixth transistor T6 are turned on. The second scan signal SCAN2 provided by the second scan line GL2 is a low-level signal, so that the second transistor T2 is turned off. The first scan signal SCAN1 provided by the first scan line GL1, the first reset control signal RESET1 provided by the first reset control line RST1, and the second reset control signal RESET2 provided by the second reset control line RST2 are high-level signals, so that the fourth transistor T4, the first transistor T1, the seventh transistor T7, and the eighth transistor T8 are turned off. The first voltage signal VDD outputted by the first power supply line PL1 may provide a drive voltage to the anode of the light emitting element EL through the turned-on fifth transistor T5, the third transistor T3, and the sixth transistor T6, driving the light emitting element EL to emit light.

In a driving process of the pixel circuit, a drive current flowing through the third transistor T3 is determined by a voltage difference between the gate and the first electrode of the third transistor T3. Because a voltage of the first node N1 is Vdata-|Vth|, the drive current of the third transistor T3 is as follows:

$$I = K \times (Vgs-Vth)^2 = K \times [(VDD-Vdata+|Vth|)-Vth]^2 = K \times [VDD-Vdata]^2$$

Herein, I is the drive current flowing through the third transistor T3, that is, a drive current for driving the light emitting element, K is a constant, Vgs is the voltage difference between the gate and the first electrode of the third transistor T3, Vth is the threshold voltage of the third transistor T3, Vdata is the data voltage outputted by the data line DL, and VDD is the first voltage signal outputted by the first power supply line PL1.

It may be seen from the above formula that a current flowing through the light emitting element is independent of the threshold voltage of the third transistor T3. Therefore, the pixel circuit according to this embodiment may better compensate the threshold voltage of the third transistor T3. Moreover, the pixel circuit provided in the present embodiment may improve display defect caused by low frequency and improve a display effect of the light emitting element.

In some examples, as shown in FIG. 1, the first display region A1 may include: a plurality of first pixel circuits 11 and a plurality of first light emitting elements 13; the second display region A2 may include a plurality of second pixel circuits 12 and a plurality of second light emitting elements 14. At least one first pixel circuit 11 may be electrically connected with at least one first light emitting element 13, and may be configured to drive the connected at least one first light emitting element 13 to emit light. At least one second region pixel circuit 12 may be electrically connected with at least one second light emitting element 14, and may be configured to drive the connected at least one second light emitting element 14 to emit light. In this example, the first light emitting element is driven to emit light by a pixel circuit built-in method in the first display region A1.

FIG. 4 is a partial schematic diagram of a display area according to at least one embodiment of the present disclosure. FIG. 4 schematically illustrates an arrangement of a plurality of first light emitting elements in a first display region and a plurality of second light emitting elements in a second display region. FIG. 4 is schematically illustrated by taking eight row and four column display island regions in the first display region as an example. A quantity of the display island regions in the first display region is not limited in this example.

In some examples, as shown in FIG. 4, the first display region A1 may include: a plurality of display island regions A11 and a plurality of light-transmitting regions A12 arranged in an array. In a first direction X (parallel to a row direction), the display island regions A11 and the light-transmitting regions A12 may be alternately disposed and arranged in alignment. In a second direction Y (parallel to a column direction), the display island regions A11 and the light-transmitting regions A12 may be alternately disposed and arranged in alignment. However, the present embodiment is not limited thereto. In other examples, display islands of adjacent rows may be disposed in a staggered manner, e.g., at least one first pixel circuit within the display islands of adjacent rows may be disposed in alignment.

In some examples, shapes and sizes of the plurality of display island regions A11 may be substantially the same, and shapes and sizes of the plurality of light-transmitting regions A12 may be substantially the same. For example, the display island regions A11 may have a substantially rectangular island shape.

In some examples, as shown in FIG. 4, the at least one display island region A11 may include a first display unit 21. The first display unit 21 may include six first light emitting elements and four first pixel circuits. The six first light emitting elements may include two first light emitting elements 13a and 13d that emit light of a first color, two first light emitting elements 13b and 13e that emit light of a second color, and two first light emitting elements 13c and 13f that emit light of a third color. For example, the first color light may be red light, the second color light may be green light, and the third color light may be blue light. The present embodiment is not limited thereto.

In some examples, as shown in FIG. 4, the six first light emitting elements of the first display unit 21 may be divided into two groups of first light emitting elements, and each group of first light emitting elements may include three first light emitting elements that emit light of different colors. For example, a first group of first light emitting elements may include: three first light emitting elements 13a, 13b, and 13c; a second group of first light emitting elements may include three first light emitting elements 13d, 13e, and 13f. The first group of first light emitting elements and the second group of first light emitting elements may be sequentially arranged in the first direction X. In the first group of first light emitting elements, the first light emitting elements 13a and 13b may be sequentially arranged in the second direction Y, and the first light emitting element 13c may be located on a same side of the first light emitting elements 13a and 13b in the first direction X. For example, the first light emitting element 13a may be located on a side of the first light emitting element 13b in the second direction Y, and the first light emitting element 13c may be located on a side of the first light emitting elements 13a and 13b in the first direction X. In the second group of first light emitting elements, the first light emitting elements 13d and 13e may be sequentially arranged in the second direction Y, and the first light emitting element 13f may be located on a same side of the first light emitting elements 13d and 13e in the first direction X. For example, the first light emitting element 13d may be located on a side of the first light emitting element 13e in the second direction Y, and the first light emitting element 13f may be located on a side of the first light emitting elements 13d and 13e in the first direction X. In this example, three first light emitting elements of each group of the first light emitting elements of the first display unit 21 that emit light of different colors may be arranged in Pentile RGB.

In some examples, as shown in FIG. 4, the second display region A2 may include a plurality of second display units 22 arranged in an array. At least one second display unit 22 may include four second light emitting elements and four second pixel circuits. The four second light emitting elements may include a second light emitting element 14a that emits light of the first color, two second light emitting elements 14b and 14d that emit light of the second color, and a second light emitting element 14c that emits light of the third color. The four second light emitting elements may be electrically connected with the four second pixel circuits in one-to-one correspondence. Each second pixel circuit may be configured to drive a corresponding one second light emitting element to emit light. In one second display unit 22, second light emitting elements 14a, 14b, 14c, and 14d may be sequentially arranged in different columns in the first direction X, second light emitting elements 14a and 14c may be arranged in a same row, and second light emitting elements 14b and 14d may be arranged in a same row. In the second display region A2, the plurality of second light emitting elements 14a and 14c may be arranged in same rows at intervals, the plurality of second light emitting elements 14b and 14d may be arranged in same rows at intervals, and the rows in which the second light emitting elements 14a and 14c located and the rows in which the second light emitting elements 14b and 14d located may be disposed at intervals in the second direction Y, so that the plurality of second light emitting elements 14a and 14c may be arranged at intervals in same columns, and the plurality of second light emitting elements 14b and 14d may be arranged at intervals in same columns. In this example, the plurality of second light emitting elements in the second display region may be arranged in an RGBG manner.

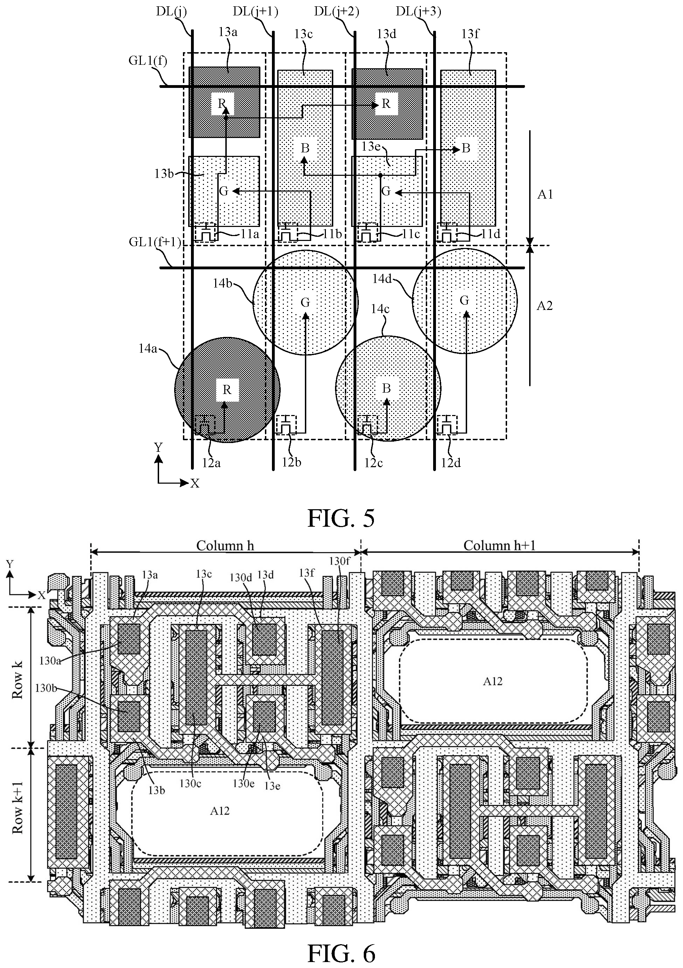

FIG. 5 is a schematic diagram of a signal correspondence between a first display region and a second display region according to at least one embodiment of the present disclosure. FIG. 5 is illustrated by taking one first display unit in the first display region A1 and one second display unit in the second display region A2 as an example.

In some examples, as shown in FIG. 5, four first pixel circuits of the first display unit may include first pixel circuits 11a, 11b, 11c, and 11d sequentially arranged in the first direction X. The first pixel circuit 11a may be connected with two first light emitting elements 13a and 13d that emit light of the first color, and may be configured to drive the two first light emitting elements 13a and 13d to emit light. The first pixel circuit 11b may be connected with one first light emitting element 13b that emits light of the second color, and may be configured to drive the first light emitting element 13b to emit light. The first pixel circuit 11c may be connected with two first light emitting elements 13c and 13f that emit light of the third color, and may be configured to drive the two third light emitting elements 13c and 13f to emit light. The first pixel circuit 11d may be connected with one first light emitting element 13e that emits light of the second color, and may be configured to drive the first light emitting element 13e to emit light. In this example, each of the first pixel circuits 11a and 11c is connected with first light emitting elements in a one-drive-two manner, and each of the first pixel circuits 11b and 11d is connected with a first light emitting element in a one-drive-one manner.

In some examples, as shown in FIG. 5, an orthographic projection of the first pixel circuit 11a on the base substrate may be at least partially overlapped with orthographic projections of the first light emitting elements 13a and 13b on the base substrate. An orthographic projection of the first pixel circuit 11b on the base substrate may be at least partially overlapped with an orthographic projection of the first light emitting element 13c on the base substrate. An orthographic projection of the first pixel circuit 11c on the base substrate may be at least partially overlapped with orthographic projections of the first light emitting elements 13d and 13e on the base substrate. An orthographic projection of the first pixel circuit 11d on the base substrate may be at least partially overlapped with an orthographic projection of the first light emitting element 13f on the base substrate. In this example, orthographic projections of the first pixel circuits and the connected first light emitting elements on the base substrate may partially overlap, or may not overlap.

In some examples, as shown in FIG. 5, four second pixel circuits of the second display unit may include second pixel circuits 12a, 12b, 12c, and 12d sequentially arranged in the first direction X. The second pixel circuit 12a may be connected with one second light emitting element 14a that emits light of the first color, and may be configured to drive the second light emitting element 14a to emit light. The second pixel circuit 12b may be connected with one second light emitting element 14b that emits light of the second color, and may be configured to drive the second light emitting element 14b to emit light. The second pixel circuit 12c may be connected with one second light emitting element 14c that emits light of the third color, and may be configured to drive the second light emitting element 14c to emit light. The second pixel circuit 12d may be connected with one second light emitting element 14d that emits light of the second color, and may be configured to drive the second light emitting element 14d to emit light. In this example, each of the four second pixel circuits may be connected with a second light emitting element in a one-drive-one manner.

In some examples, as shown in FIG. 5, an orthographic projection of the second pixel circuit 12a on the base substrate may be at least partially overlapped with an orthographic projection of the second light emitting element 14a on the base substrate. An orthographic projection of the second pixel circuit 12b on the base substrate may be at least partially overlapped with an orthographic projection of the second light emitting element 14b on the base substrate. An orthographic projection of the second pixel circuit 12c on the base substrate may be at least partially overlapped with an orthographic projection of the second light emitting element 14c on the base substrate. An orthographic projection of the second pixel circuit 12d on the base substrate may be at least partially overlapped with an orthographic projection of the second light emitting element 14d on the base substrate. In this example, orthographic projections of the second pixel circuits and the connected second light emitting elements on the base substrate may at least partially overlap.

In some examples, as shown in FIG. 5, four first pixel circuits of the first display unit may be arranged in alignment with four second pixel circuits of the second display unit in the second direction Y. For example, the first pixel circuit 11a and the second pixel circuit 12a may be arranged in alignment with each other in the second direction Y, the first pixel circuit 11b and the second pixel circuit 12b may be arranged in alignment with each other in the second direction Y, the first pixel circuit 11c and the second pixel circuit 12c may be arranged in alignment with each other in the second direction Y, and the first pixel circuit 11d and the second pixel circuit 12d may be arranged in alignment with each other in the second direction Y.

In some examples, as shown in FIG. 5, the first pixel circuit 11a of the first display unit and the second pixel circuit 12a of the second display unit may be located in a same column of pixel circuits, and may be connected with a same data line (for example, a data line DL (j)) extending in the second direction Y. The first pixel circuit 11b of the first display unit and the second pixel circuit 12b of the second display unit may be located in a same column of pixel circuits, and may be connected with a same data line (for example, a data line DL (j+1)) extending in the second direction Y. The first pixel circuit 11c of the first display unit and the second pixel circuit 12c of the second display unit may be located in a same column of pixel circuits, and may be connected with a same data line (for example, a data line DL (j+2)) extending in the second direction Y. The first pixel circuit 11d of the first display unit and the second pixel circuit 12d of the second display unit may be located in a same column of pixel circuits, and may be connected with a same data line (for example, a data line DL (j+3)) extending in the second direction Y. Herein j may be a positive integer.

In some examples, as shown in FIG. 5, the four first pixel circuits of the first display unit may be pixel circuits arranged in a same row, and may be connected with a same first scan line (for example, a first scan line GL1 (f)) extending in the first direction X. The four second pixel circuits of the second display unit are arranged in a same row of pixel circuits, and are connected with a same first scan line (for example, a first scan line GL1 (f+1)) extending in the first direction X. Herein f may be a positive integer.

In some examples, as shown in FIGS. 4 and 5, the plurality of second light emitting elements in the second display region A2 may be arranged in an RGBG manner, and the second pixel circuits and the second light emitting elements may be in a one-drive-one correspondence. The plurality of first light emitting elements in the first display region A1 may be arranged in a Pentile RGB manner, and by reducing the quantity of first pixel circuits, four first pixel circuits may drive six first light emitting elements to emit light. By taking one RGB unit as a first pixel unit and taking one RGBG unit as a second pixel unit, two first pixel units can be arranged in a pixel space corresponding to one second pixel unit, and a resolution (PPI) of the first display region can be equivalent to a resolution of the second display region. Furthermore, since a display effect of an RGB arrangement mode having a resolution (PPI) of "a" can be equivalent to a display effect of an RGBG arrangement mode having a PPI of $a \times [2^{\wedge}(1/2)]$, in this example, a display effect of the first display region can be optimized by disposing an arrangement mode of the first light emitting elements to be different from an arrangement mode of the second light emitting elements on a basis of reducing the quantity of the pixel circuits in the first display region to improve a light transmittance of the first display region, thereby improving a display uniformity of the first display region and the second display region.

FIG. 6 is a partial top view of a first display region according to at least one embodiment of the present disclosure. FIG. 6 schematically illustrates a partial top view of two rows (e.g., a k-th row and a (k+1)-th row) and two columns (e.g., a h-th column and a (h+1)-th column) display island regions, where k and h are both integers greater than 0. In some examples, as shown in FIG. 6, the first display region may include: a plurality of display island regions and a plurality of light-transmitting regions A12. A single light-transmitting region A12 may be surrounded by two display island regions in the first direction X and surrounded by two display island regions in the second direction Y.

In some examples, in a direction perpendicular to the display substrate, the display substrate may include a base substrate, and a circuit structure layer and a light emitting structure layer disposed on the base substrate. The light emitting structure layer may be located on a side of the circuit structure layer away from the base substrate. The circuit structure layer of the first display region may include a plurality of first pixel circuits, and the light emitting structure layer of the first display region may include a plurality of first light emitting elements.

In some examples, the circuit structure layer may include: a shielding layer, a first semiconductor layer, a first conductive layer, a second conductive layer, a second semiconductor layer, a third conductive layer, a fourth conductive layer, a fifth conductive layer, and a sixth conductive layer disposed on the base substrate. A buffer layer may be disposed between the shielding layer and the first semiconductor layer. A first insulation layer may be disposed between the first semiconductor layer and the first conductive layer, a second insulation layer may be disposed between the first conductive layer and the second conductive layer, a third insulation layer may be disposed between the second conductive layer and the second semiconductor layer, a fourth insulation layer may be disposed between the second semiconductor layer and the third conductive layer, a fifth insulation layer may be disposed between the third conductive layer and the fourth conductive layer, a sixth insulation layer and a seventh insulation layer may be disposed between the fourth conductive layer and the fifth conductive layer, an eighth insulation layer may be disposed between the fifth conductive layer and the sixth conductive layer, and a ninth insulation layer may be disposed on a side of the sixth conductive layer away from the base substrate. In some examples, the buffer layer and the first insulation layer to the sixth insulation layer may be inorganic insulation layers, and the seventh insulation layer to the ninth insulation layer may be organic insulation layers. The present embodiment is not limited thereto. In other examples, disposing the shielding layer may be omitted. In some other examples, an insulation layer may be disposed between the fourth conductive layer and the fifth conductive layer. In some other examples, two insulation layers may be disposed on a side of the sixth conductive layer away from the base substrate to improve a flattening effect of an anode layer.

In some examples, the light emitting structure layer may include an anode layer, a pixel definition layer, an organic light emitting layer, and a cathode layer disposed sequentially on the circuit structure layer. The anode layer may be electrically connected with a pixel circuit of the circuit structure layer, the organic light emitting layer may be connected with the anode layer, the cathode layer may be connected with the organic light emitting layer, and the organic light emitting layer may emit light of corresponding colors under drive of the anode layer and the cathode layer.

A structure of the display substrate will be described below through an example of a manufacturing process of the display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are disposed in a same layer" in the present disclosure means that A and B are formed simultaneously through a same patterning process, or distances between surfaces of A and B close to a base substrate and the base substrate are substantially the same, or the surfaces of A and B close to the base substrate are in direct contact with a same film layer. A "thickness" of a film layer is a dimension of the film layer in a direction perpendicular to the display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A overlaps with the boundary of the orthographic projection of B. A "shape of A" as used in the present disclosure refers to a shape of the orthographic projection of A on the base substrate.

The film or layer of the circuit structure layer will be described below by taking four first pixel circuits (including, for example, the first pixel circuits 11a, 11b, 11c, and 11d) in one display island region of the first display region (for example, a display island region located in the h-th column and the k-th row) as an example. The example is illustrated by taking an example that a first pixel circuit has the aforementioned 8T1C structure. The first pixel circuit 11a may include: a first transistor 31a, a second transistor 32a, a third transistor 33a, a fourth transistor 34a, a fifth transistor 35a, a sixth transistor 36a, a seventh transistor 37a, an eighth transistor 38a, and a storage capacitor; and the first pixel circuit 11b may include: a first transistor 31b, a second transistor 32b, a third transistor 33b, a fourth transistor 34b, a fifth transistor 35b, a sixth transistor 36b, a seventh transistor 37b, an eighth transistor 38b, and a storage capacitor. A connection relationship between eight transistors and a storage capacitor in each first pixel circuit may be referred to the equivalent circuit diagram shown in FIG. 2.

In some examples, the manufacturing process of the display substrate includes the following acts.

(1) A base substrate is provided. In some examples, the base substrate may be a rigid substrate or a flexible substrate. For example, the rigid substrate may be made of, but not limited to, one or more of glass and quartz. The flexible substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible base substrate may include a first flexible material layer, a first inorganic material layer, a second flexible material layer and a second inorganic material layer which are stacked. The first flexible material layer and the second flexible material layer may be made of a material such as Polyimide (PI), Polyethylene Terephthalate (PET), or a polymer soft film on which surface treatment is performed, and a material of the first inorganic material layer and the second inorganic material layer may be Silicon Nitride (SiNx,x>0) or Silicon Oxide (SiOy,y>0), etc., which are used to improve resistance to water and oxygen of the base substrate.

(2) A shielding layer is formed. In some examples, a shielding thin film is deposited on the base substrate, and the shielding thin film is patterned by a patterning process to form a shielding layer disposed on the base substrate. In some examples, the shielding layer may also be referred to as a Bottom Shielding Metal (BSM).

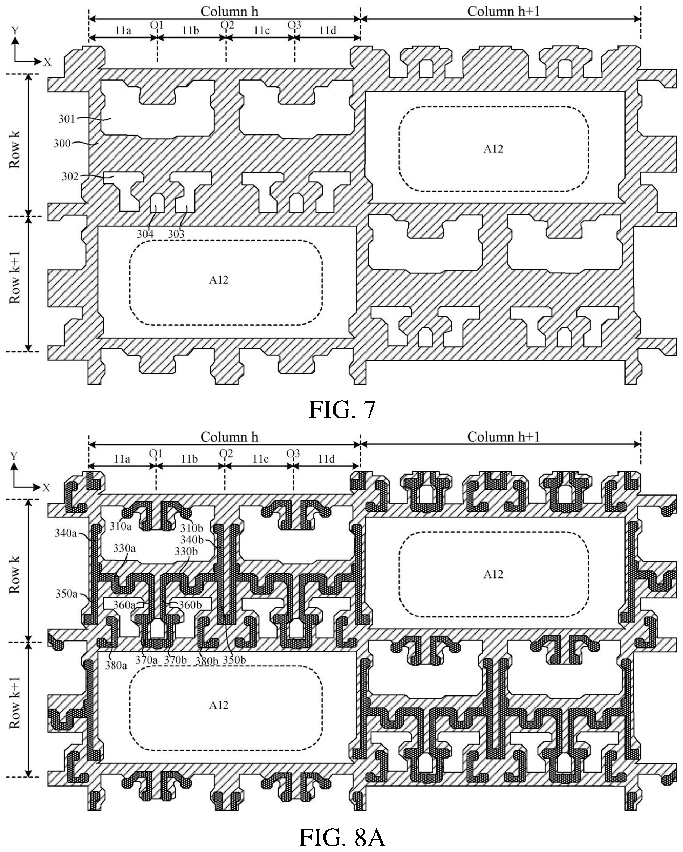

FIG. 7 is a schematic diagram of the first display region after a shielding layer is formed in FIG. 6. In some examples, as shown in FIG. 7, the shielding layer of the first display region may at least include: a shielding block 300 located in the display island region. Each display island region may be provided with one shielding block 300. In adjacent columns of display island regions, the shielding blocks 300 of display island regions in adjacent rows may be interconnected into an integral structure. The plurality of shielding blocks 300 in the first display region may be interconnected into an integral structure.

In some examples, as shown in FIG. 7, a shielding block 300 in a display island region may include: two first hollow portions 301, two second hollow portions 302, two third hollow portions 303, and two fourth hollow portions 304. The shielding block 300 may be substantially symmetrical with respect to a second centerline O2. The two first hollow portions 301 may be substantially symmetrical with respect to the second centerline O2, and a single first hollow portion 301 may be substantially symmetrical with respect to a first centerline O1 or a third centerline O3. The second hollow portions 302, the third hollow portions 303, and the fourth hollow portions 304 may be located on a side of the first hollow portions 301 in an opposite direction of the second direction Y, and a fourth hollow portion 304 may be located between a second hollow portion 302 and a third hollow portion 303 in the first direction X. One second hollow portion 302 and one third hollow portion 303 may be substantially symmetrical about the first midline O1, and the other second hollow portion 302 and the other third hollow portion 303 may be substantially symmetrical about the third midline O3. One fourth hollow portion 304 may be substantially symmetrical with respect to the first centerline O1, and the other fourth hollow portion 304 may be substantially symmetrical with respect to the third centerline O3. In this example, disposing a light-shielding block in a display island region can produce a light-shielding effect for the first-type transistors of a first pixel circuit in the display island region, and by disposing hollow portions in the light-shielding block, it is possible to avoid parasitic capacitance with other metal film layers, which affects the display effect, due to use of a large area of metal.

In some examples, the shielding layer may extend to a peripheral area and be electrically connected with a first power supply line in the peripheral area to access to a first voltage signal to avoid affecting other signal wires.

(3) A first semiconductor layer is formed. In some examples, a buffer thin film and a first semiconductor thin film are sequentially deposited on a base substrate on which the aforementioned pattern is formed, and the first semiconductor thin film is patterned by a patterning process to form a buffer layer and a first semiconductor layer disposed on the buffer layer. In some examples, a material of the first semiconductor layer may be amorphous silicon (a-Si), polycrystalline silicon (p-Si), hexathiophene or polythiophene, or other materials.

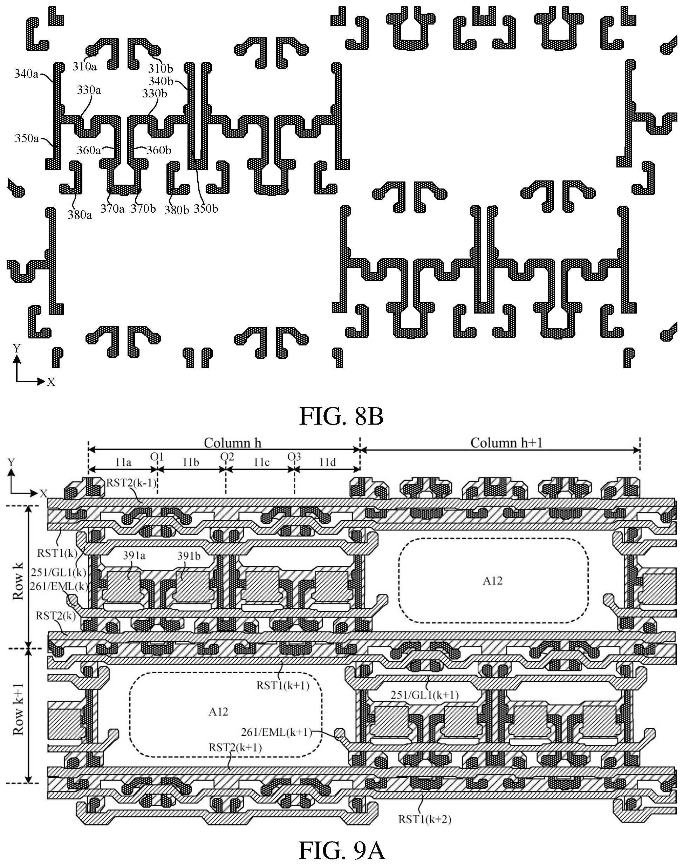

FIG. 8A is a schematic diagram of the first display region after a first semiconductor layer is formed in FIG. 6. FIG. 8B is a schematic diagram of the first semiconductor layer in FIG. 8A. In some examples, as shown in FIGS. 8A and 8B, the first semiconductor layer of the first display region may include at least active layers of a plurality of first-type transistors of a plurality of first pixel circuits (e.g., including: a first active layer 310a of a first transistor, a third active layer 330a of a third transistor, a fourth active layer 340a of a fourth transistor, a fifth active layer 350a of a fifth transistor, a sixth active layer 360a of a sixth transistor, a seventh active layer 370a of a seventh transistor, and an eighth active layer 380a of an eighth transistor of the first pixel circuit 11a; a first active layer 310b of a first transistor, a third active layer 330b of a third transistor, a fourth active layer 340b of a fourth transistor, a fifth active layer 350b of a fifth transistor, a sixth active layer 360b of a sixth transistor, a seventh active layer 370b of a seventh transistor, and an eighth active layer 380b of an eighth transistor of the first pixel circuit 11b).

In some examples, as shown in FIGS. 8A and 8B, within a display island region, the patterns of the first semiconductor layers of the first pixel circuits 11a and 11b may be substantially symmetrical with respect to the first centerline O1, the patterns of the first semiconductor layers of the first pixel circuits 11b and 11c may be substantially symmetrical with respect to the second centerline O2, and the patterns of the first semiconductor layers of the first pixel circuits 11c and 11d may be substantially symmetrical with respect to the third centerline O3. The patterns of the first semiconductor layers of the first pixel circuits 11a and 11b and the patterns of the first semiconductor layers of the first pixel circuits 11c and 11d may be substantially symmetrical with respect to the second centerline O2. The patterns of the first semiconductor layer of different display island regions may be independent of each other.

In some examples, as shown in FIGS. 8A and 8B, third active layers, fourth active layers, the fifth active layers, sixth active layers, and seventh active layers of four first pixel circuits within a display island region may be interconnected into an integral structure. The seventh active layer 370a of the first pixel circuit 11a and the seventh active layer 370b of the first pixel circuit 11b may be directly connected, the fifth active layer 350b of the first pixel circuit 11b and the fifth active layer of the first pixel circuit 11c may be directly connected, and the seventh active layer of the first pixel circuit 11c and the seventh active layer of the first pixel circuit 11d may be directly connected.

In some examples, as shown in FIGS. 8A and 8B, they are illustrated by taking the pattern of the first semiconductor layer of the first pixel circuit 11a as an example. The first active layer 310a and the fourth active layer 340a of the first pixel circuit 11a may be located on a side of the third active layer 330a in the second direction Y, and the fifth active layer 350a, the sixth active layer 360a, the seventh active layer 370a, and the eighth active layer 380a may be located on a side of the third active layer 330a in the opposite direction of the second direction Y. The first active layer 310a, the sixth active layer 360a, and the seventh active layer 370a may be disposed in alignment with each other in the second direction Y.

In some examples, the third active layer 330a may be substantially u-shaped, the fourth active layer 340a may be substantially I-shaped, and the fifth active layer 350a, the sixth active layer 360a, the seventh active layer 370a, and the eighth active layer 380a may be substantially L-shaped. However, the present embodiment is not limited thereto. Arrangements and shapes of the patterns of the first semiconductor layers of the first pixel circuits 11b, 11c, and 11d are similar to an arrangement and a shape of the pattern of the first semiconductor layer of the first pixel circuit 11a, and therefore will not be repeated here.

In some examples, an active layer of each transistor may include: a first region, a second region, and a channel region located between the first region and the second region. A material of the first semiconductor layer may include, for example, polysilicon. The channel region may be not doped with impurities, and has characteristics of a semiconductor. The first region and the second region may be doped regions on both sides of the channel region, and are doped with impurities, and thus have conductivity. The impurities may be different according to a type of a transistor. In some examples, a doped region of the active layer may be interpreted as a source electrode or a drain electrode of a transistor. A part of active layers between transistors may be interpreted as a wiring doped with impurities, and may be used for electrically connecting the transistors. The present embodiment is not limited thereto.

In some examples, as shown in FIG. 8A, an orthographic projection of the shielding layer of the first display region on the base substrate may be partially overlapped with an orthographic projection of the first semiconductor layer on the base substrate. An orthographic projection of the blocking block 300 of the display island region on the base substrate may cover orthographic projections of the third active layers, the fourth active layers, the fifth active layers, the sixth active layers, the seventh active layers, and the eighth active layers of the four first pixel circuits on the base substrate, and be partially overlapped with orthographic projections of the first active layers on the base substrate. For example, the orthographic projection of the blocking block 300 on the base substrate may cover orthographic projections of channel regions of active layers of the first-type transistors of the four first pixel circuits on the base substrate. **In** this example, by disposing a shielding layer to shield the channel regions of the active layers of the first-type transistors located in the first semiconductor layer, it is possible to avoid external light from affecting the transistors of the pixel circuits, thereby ensuring the performance of the transistors.

(4) A first conductive layer is formed. In some examples, a first insulation thin film and a first conductive thin film are deposited sequentially on the base substrate on which the aforementioned structures are formed, and the first conductive thin film is patterned by a patterning process to form a first insulation layer and a first conductive layer disposed on the first insulation layer. In some examples, the first conductive layer may also be referred to as a first gate metal layer, and the first insulation layer may also be referred to as a first gate insulation layer.

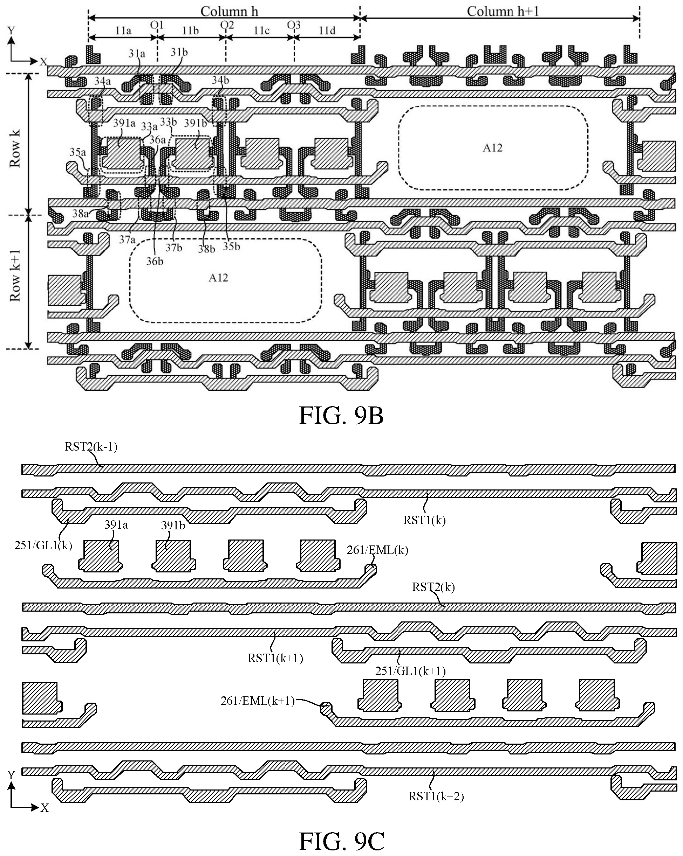

FIG. 9A is a schematic diagram of a first display region after a first conductive layer is formed in FIG. 6. FIG. 9B is a schematic diagram of the first conductive layer and the first semiconductor layer in FIG. 9A. FIG. 9C is a schematic diagram of the first conductive layer of FIG. 9A. In some examples, as shown in FIGS. 9A to 9C, the first conductive layer of the first display region may at least include first scan transmission sections 251 of a plurality of first scan lines (e.g., including first scan lines GL1(k) and GL1(k+1)), light emitting control transmission sections 261 of a plurality of light emitting control lines (e.g., including light emitting control lines EML(k) and EML(k+1)), a plurality of first reset control lines (e.g., including first reset control lines RST1(k), RST1(k+1) and RST1(k+2)), a plurality of second reset control lines (e.g., including second reset control lines RST2(k-1), RST2(k) and RST2(k+1)), and first electrodes of storage capacitors of a plurality of first pixel circuits (e.g., including first electrodes 391a, 391b).

In some examples, the first scan transmission sections 251 and the light emitting control transmission sections 261 may be located in the display island region where the connected first pixel circuits are located. A first scan transmission section 251 of a first scan line GL1(k) may be located on a side of first electrodes (for example, the first electrodes 391a, 391b) of a storage capacitor of a first pixel circuit in the second direction Y, and a first reset control line RST1(k) may be located on a side of the first scan transmission section 251 of the first scan line GL1(k) in the second direction Y. A light emitting control transmission section 261 of a light emitting control line EML(k) may be located on a side of the first electrodes (for example, the first electrodes 391a, 391b) of the storage capacitor of the first pixel circuit in the opposite direction of the second direction Y, and a second reset control line RST2(k) may be located on a side of the light emitting control transmission section 261 of the light emitting control line EML(k) in the opposite direction of the second direction Y. A first reset control line RST1(k+1) may be located on a side of the second reset control line RST2(k) in the opposite direction of the second direction Y.

In some examples, the first reset control line RST1(k) may be located on a side of a light-transmitting region A12 in a k-th row and (h+1)-th column in the second direction Y, and a line segment of the first reset control line RST1(k) close to the light-transmitting region A12 may be in a substantially straight line shape extending in the first direction X. The second reset control line RST2(k) may be located on a side of the light-transmitting region A12 in the k-th row and (h+1)-th column in the opposite direction of the second direction Y, and a line segment of the second reset control line RST2(k) close to the light-transmitting region A12 may be in a substantially straight line shape extending in the first direction X. The first scan line GL1(k) may bypass the light-transmitting region A12 from the side of the light-transmitting region A12 in the second direction Y through a first scan connection line, and the light emitting control line EML(k) may bypass the light-transmitting region A12 from the side of the light-transmitting region A12 in the opposite direction in the second direction Y through a light emitting control connection line. A wiring arrangement mode of the first conductive layer of the present example can be beneficial to increasing an area of the light-transmitting region, thereby improving a light transmittance of the first display region.

In some examples, a shape of a line segment of the first reset control line RST1(k) located in the display island region where the connected first pixel circuits are located may be substantially a bend line shape extending in the first direction X. For example, in a display island region in a k-th row and h-th column, overlapping areas of the first reset control line RST1(k) with first active layers of four first pixel circuits may serve as gate electrodes of first transistors of the four first pixel circuits (e.g., including a gate electrode of the first transistor 31a, and a gate electrode of the first transistor 31b).

In some examples, a shape of the first scan transmission section 251 of the first scan line GL1(k) may be substantially a bend line shape extending in the first direction X. For example, in the display island region in the k-th row and h-th column, overlapping areas of the first scan transmission section 251 of the first scan line GL1(k) with fourth active layers of the four first pixel circuits may serve as gate electrodes of fourth transistors of the four first pixel circuits (for example, including a gate electrode of the fourth transistor 34a and a gate electrode of the fourth transistor 34b).

In some examples, a shape of the light emitting control transmission section 261 of the light emitting control line EML(k) may be substantially a bend line shape extending in the first direction X. For example, in the display island region in the k-th row and h-th column, overlapping areas of light emitting control transmission section 261 of the light emitting control line EML(k) with fifth active layers of the four first pixel circuits may serve as gate electrodes of fifth transistors of the four first pixel circuits (for example, including gate electrodes of the fifth transistors 35a, 35b), and overlapping areas of light emitting control transmission section 261 of the light emitting control line EML(k) with sixth active layers of the four first pixel circuits may serve as gate electrodes of sixth transistors of the four first pixel circuits (for example, including gate electrodes of the sixth transistor 36a, 36b).

In some examples, a shape of a line segment of the second reset control line RST2(k) located in the display island region where the connected first pixel circuits are located may be substantially a bend line shape extending in the first direction X. For example, in the display island region in the k-th row and h-th column, overlapping areas of the second reset control line RST2(k) with seventh active layers of four first pixel circuits may serve as gate electrodes of seventh transistors of the four first pixel circuits (e.g., including gate electrodes of the seventh transistors 37a and 37b), and overlapping areas of the second reset control line RST2(k) with eighth active layers of the four first pixel circuits may serve as gate electrodes of eighth transistors of the four first pixel circuits (e.g., including gate electrodes of the eighth transistors 38a and 38b).

In some examples, a first electrode 391a of a storage capacitor of the first pixel circuit 11a may simultaneously serve as a gate electrode of the third transistor 33a, and a first electrode 391b of a storage capacitor of the first pixel circuit 11b may simultaneously serve as a gate electrode of the third transistor 33b. Orthographic projections of the first electrodes 391a and 391b on the base substrate may be in a substantially rectangular shape. The present embodiment is not limited thereto.

(5) A second conductive layer is formed. In some examples, a second insulation thin film and a second conductive thin film are deposited sequentially on the base substrate on which the aforementioned structures are formed, and the second conductive thin film is patterned by a patterning process to form a second insulation layer and a second conductive layer disposed on the second insulation layer. In some examples, the second conductive layer may also be referred to as a second gate metal layer and the second insulation layer may also be referred to as a second gate insulation layer.

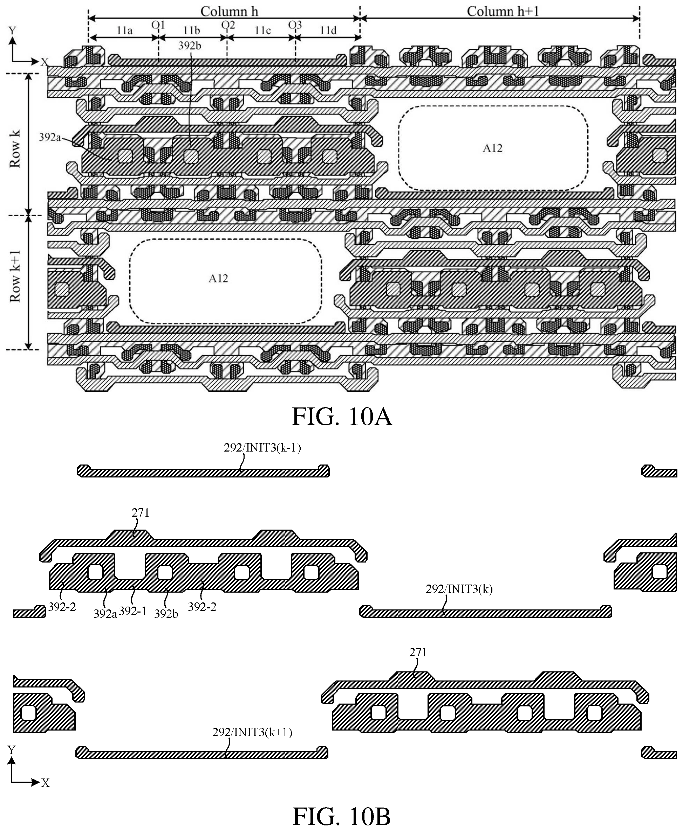

FIG. 10A is a schematic diagram of a first display region after a second conductive layer is formed in FIG. 6. FIG. 10B is a schematic diagram of the second conductive layer in FIG. 10A. In some examples, as shown in FIGS. 10A and 10B, the second conductive layer of the first display region may include at least second scan auxiliary transmission sections 271 of a plurality of second scan auxiliary lines (e.g., including second scan auxiliary lines GL2b(k), GL2b(k)), second electrodes of storage capacitors of a plurality of first pixel circuits (e.g., including second electrodes 392a, 392b), and initial signal connection sections 292 of a plurality of third initial signal lines (e.g., including third initial signal lines INIT3(k-1), INIT3(k), INIT3(k+1)).

In some examples, a second scan auxiliary transmission section 271 of a second scan auxiliary line GL2b(k) may be located in a display island region where first pixel circuits connected are located. A shape of a second scan auxiliary transmission section 271 may be substantially a bend line shape extending in the first direction X. For example, in the display island region in the k-th row and h-th column, the second scan auxiliary transmission section 271 of the second scan auxiliary line GL2b(k) may be located on a side of the second electrodes (for example, the second electrodes 392a and 392b) of the storage capacitors of the first pixel circuits in the second direction Y.

In some examples, in a display island region, an orthographic projection of a second electrode of a storage capacitor of each first pixel circuit on the base substrate may have a substantially rectangular structure with a hollow region, and an orthographic projection of the hollow region on the base substrate may be substantially in a shape of a rectangle, and the rectangle may have rounded corners or chamfers. The second electrode 392a of the storage capacitor of the first pixel circuit 11a and the second electrode 392b of the storage capacitor of the first pixel circuit 11b may be electrically connected through a first plate connection block 392-1, the second electrode 392b of the storage capacitor of the first pixel circuit 11b and the second electrode of the storage capacitor of the first pixel circuit 11c may be electrically connected through a second plate connection block 392-2, and the second electrode of the storage capacitor of the first pixel circuit 11c and the second electrode of the storage capacitor of the first pixel circuit 11d may be electrically connected through another first plate connection block 392-1. A side of the second electrode 392a of the storage capacitor of the first pixel circuit 11a away from the first pixel circuit 11b may be connected with one second plate connection block 392-2, and a side of the second electrode of the storage capacitor of the first pixel circuit 11d away from the first pixel circuit 11c may be electrically connected with another second plate connection block 392-2. A length of a first plate connection block 392-1 in the second direction Y may be smaller than the length of a second plate connection block 392-2 in the second direction Y. A second electrode of a storage capacitor may subsequently be electrically connected with a first power supply line through a second plate connection block. In this example, the second electrodes of the storage capacitors of the four first pixel circuits in the first display island region may be interconnected into an integral structure, which is beneficial to ensuring uniform transmission of the first voltage signal in the first direction X.

In some examples, an initial signal connection section 292 of the third initial signal lines INIT3(k) may be located a display island region in an adjacent row and column of a display island region where first pixel circuits connected are located. For example, the initial signal connection section 292 of the third initial signal line INIT3(k) connected with the first pixel circuits in the display island region in the k-th row and h-th column may be located in a display island region in a (k+1)-th row and (h+1)-th column, and may be located on a side of the light-transmitting region A12 in a k-th row and (h+1)-th column in the opposite direction of the second direction Y. A shape of the initial signal connection section 292 may be substantially a straight line shape extending in the first direction X. The initial signal connection section 292 may be configured to connect initial signal transmission sections within adjacent display island regions to be formed subsequently, to achieve transmission of a third initial signal in the first direction X within the first display region.

(6) A second semiconductor layer is formed. In some examples, a third insulation thin film and a second semiconductor thin film are sequentially deposited on the base substrate on which the aforementioned patterns are formed, and the second semiconductor thin film is patterned by a patterning process to form a third insulation layer and a second semiconductor layer disposed on the third insulation layer. In some examples, a material of the second semiconductor layer may include Indium Gallium Zinc Oxide (IGZO). In some examples, the third insulation layer may also be referred to as a third gate insulation layer.

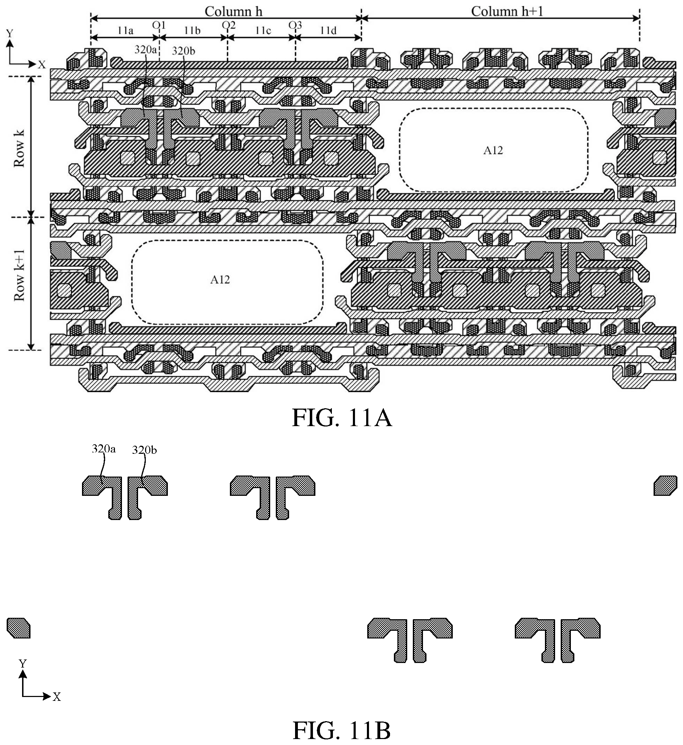

FIG. 11A is a schematic diagram of a first display region after a second semiconductor layer is formed in FIG. 6. FIG. 11B is a schematic diagram of the second semiconductor layer in FIG. 11A. In some examples, as shown in FIGS. 11A and 11B, the second semiconductor layer of the first display region may at least include: active layers of second-type transistors of a plurality of first pixel circuits (e.g., including: the second active layer 320a of the second transistor 32a of the first pixel circuit 11a, and the second active layer 320b of the second transistor 32b of the first pixel circuit 11b).

In some examples, in a display island region, the patterns of the second semiconductor layers of the first pixel circuits 11a and 11b may be substantially symmetrical with respect to the first centerline O1, the patterns of the second semiconductor layers of the first pixel circuits 11b and 11c may be substantially symmetrical with respect to the second centerline O2, and the patterns of the second semiconductor layers of the first pixel circuits 11c and 11d may be substantially symmetrical with respect to the third centerline O3. The patterns of the second semiconductor layers of the first pixel circuits 11a and 11b and the patterns of the second semiconductor layers of the first pixel circuits 11c and 11d may be substantially symmetrical with respect to the second centerline O2.

In some examples, the second active layers 320a and 320b may be substantially in an inverted L-shape. An overlapping area of the second scan auxiliary transmission section 271 of the second scan auxiliary line GL2b(k) with the second active layer 320a may serve as a bottom gate of the second transistor 32a, and an overlapping area of the second scan auxiliary transmission section 271 of the second scan auxiliary line GL2b(k) with the second active layer 320b may serve as a bottom gate of the second transistor 32b.

In some examples, an orthographic projection of the second semiconductor layer on the base substrate may be partially overlapped with an orthographic projection of the shielding layer on the base substrate. Orthographic projections of channel regions of the second active layers on the base substrate and the orthographic projection of the shielding layer on the base substrate may not overlap. For example, orthographic projections of channel regions of the second active layers 320a and 320b on the base substrate may be located within an orthographic projection of a first hollow region 301 on the base substrate.

(7) A third conductive layer is formed. In some examples, a fourth insulation thin film and a third conductive thin film are sequentially deposited on the base substrate on which the aforementioned patterns are formed, and the third conductive thin film is patterned by a patterning process to form a fourth insulation layer and a third conductive layer disposed on the fourth insulation layer. In some examples, the third conductive layer may also be referred to as a third gate metal layer, and the fourth insulation layer may also be referred to as a fourth gate insulation layer.

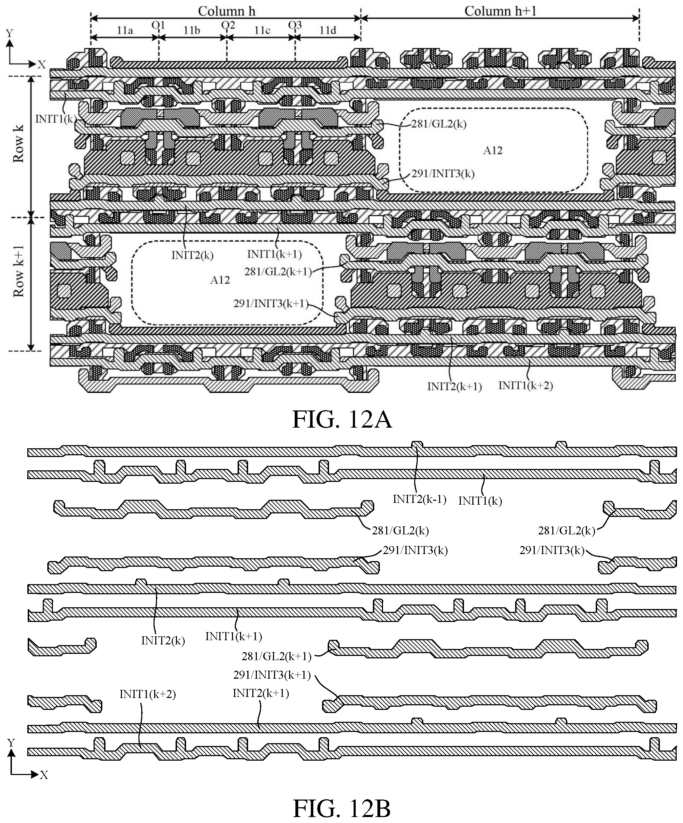

FIG. 12A is a schematic diagram of a first display region after a third conductive layer is formed in FIG. 6. FIG. 12B is a schematic diagram of the third conductive layer in FIG. 12A. In some examples, as shown in FIGS. 12A and 12B, the third conductive layer of the first display region may include at least second scan transmission sections 281 of a plurality of second scan lines (for example, including second scan lines GL2(k), GL2(k+1)), a plurality of first initial signal lines (for example, including first initial signal lines INIT1(k), INIT1(k+1), INIT1(k+2)), a plurality of second initial signal lines (for example, including second initial signal lines INIT2(k-1), INIT2(k), INIT2(k+1)), and initial signal transmission sections 291 of a plurality of third initial signal lines (for example, including third initial signal lines INIT3 (k), INIT2(k+1)).

In some examples, in a display island region, the first initial signal line INIT1(k) and the second scan transmission section 281 of the second scan line GL2(k) may be located on a side of a storage capacitor in the second direction Y, and the second initial signal line INIT2(k) and the initial signal transmission section 291 of the third initial signal line INIT3(k) may be located on a side of the storage capacitor in the opposite direction of the second direction Y. The first initial signal line INIT1(k) may be located on a side of the second scan transmission section 281 of the second scan line GL2(k) in the second direction Y, the initial signal transmission section 291 of the third initial signal line INIT3(k) and the second initial signal line INIT2(k) may be located on a side of the second scan transmission section 281 of the second scan line GL2(k) in the opposite direction of the second direction Y, and the second initial signal line INIT2(k) may be located on a side of the initial signal transmission section 291 of the third initial signal line INIT3(k) in the opposite direction of the second direction Y.

In some examples, the first initial signal line INIT1(k) may be located on a side of the light-transmitting region A12 in the k-th row and (h+1)-th column in the second direction Y. The second initial signal line INIT2(k) may be located on a side of the light-transmitting region A12 in the k-th row and (h+1)-th column in the opposite direction of the second direction Y. A shape of a line segment of the first initial signal line INIT 1(k) located within the display island region where first pixel circuits connected are located may be substantially a bend line shape extending in the first direction X. A shape of a line segment of the first initial signal line INIT1(k) close to the light-transmitting region A12 may be substantially a straight line shape extending in the first direction X. A shape of a line segment of the second initial signal line INIT2(k) located in the display island region where first pixel circuits connected are located may be substantially a bend line shape extending in the first direction X. A shape of a line segment of the second initial signal line INIT2(k) close to the light-transmitting region A12 may be substantially a straight line shape extending in the first direction X. A wiring arrangement of the third conductive layer of the present example may be beneficial to increase the area of the light-transmitting region and improve the light transmittance of the first display region.

In some examples, an orthographic projection of the first initial signal line INIT1(k) on the base substrate may be at least partially overlapped with an orthographic projection of the first reset control line RST1(k) on the base substrate. For example, the orthographic projection of the first initial signal line INIT1(k) on the base substrate may contain the orthographic projection of the first reset control line RST1(k) on the base substrate. An orthographic projection of the second scanning transport segment 281 of the second scan line GL2(k) on the base substrate may be partially overlapped with an orthographic projection of the second scan auxiliary transmission sections 271 of the second scan auxiliary line GL2b(k) on the base substrate. An orthographic projection of the initial signal transmission section 291 of the third initial signal line INIT3(k) on the base substrate may be partially overlapped with an orthographic projection of the light emitting control transmission section 261 of the light emitting control line EML(k) on the base substrate. An orthographic projection of the second initial signal line INIT2(k) on the base substrate may be at least partially overlapped with an orthographic projection of the second reset control line RST2(k) on the base substrate. For example, the orthographic projection of the second initial signal line INIT2(k) on the base substrate may contain the orthographic projection of the second reset control line RST2(k) on the base substrate. In the example, wires of different conductive layers (for example, including the first conductive layer, the second conductive layer, and the third conductive layer) are stacked to avoid occupying too much wiring space, which is beneficial to saving wiring space, thereby improving a light transmittance of the first display region.

(8) A fifth insulation layer is formed. In some examples, a fifth insulation thin film is deposited on the base substrate on which the aforementioned patterns are formed, and the fifth insulation thin film is patterned by a patterning process to form a fifth insulation layer. In some examples, the fifth insulation layer may also be referred to as an interlayer insulation layer.

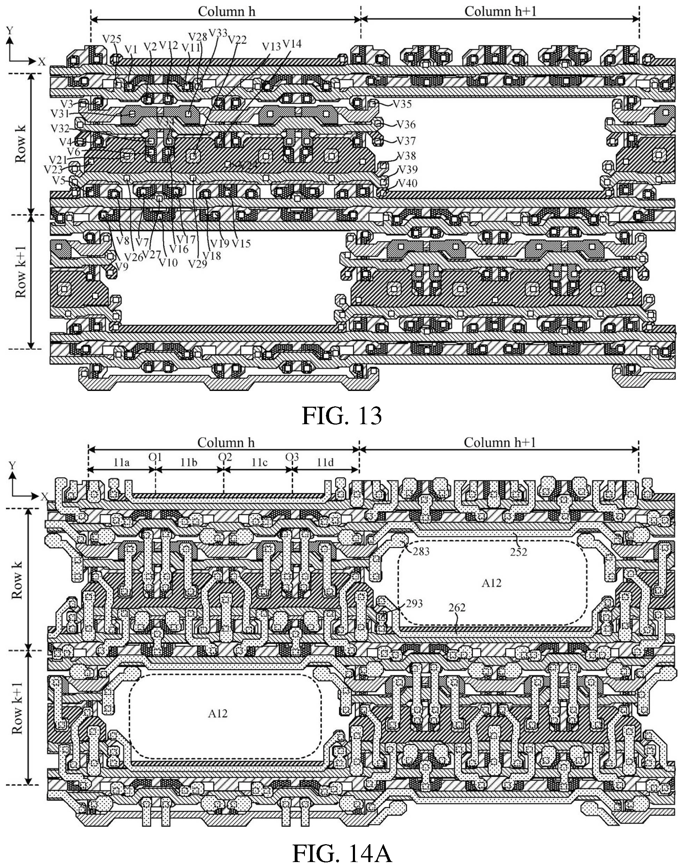

FIG. 13 is a schematic diagram of a first display region after a fifth insulation layer is formed in FIG. 6. In some examples, as shown in FIG. 13, the fifth insulation layer of the first display region may be provided with a plurality of vias, for example, may include a first type of vias (such as including a first via V1 to a nineteenth via V19), a second type of vias (such as including a twenty-first via V21, a twenty-second via V22, a thirty-fifth via V35, and a thirty-eighth via V38), a third type of vias (such as including a twenty-third via V23, a twenty-fourth via V24, a thirty-seventh via V37, and a fortieth via V40), a plurality of a fourth type of vias (such as including a thirty-first via V31 to a thirty-fourth via V34), and a plurality of a fifth type of vias (such as including a twenty-fifth via V25 to a twenty-ninth via V29, a thirty-sixth via V36, and a thirty-ninth via V39).

In some examples, a fifth insulation layer, a fourth insulation layer, a third insulation layer, a second insulation layer, and a first insulation layer within the first type of vias may be removed to expose part of a surface of the first semiconductor layer. A fifth insulation layer, a fourth insulation layer, a third insulation layer, and a second insulation layer within the second type of vias may be removed to expose part of a surface of the first conductive layer. A fifth insulation layer, a fourth insulation layer, and a third insulation layer within the third type of vias may be removed to expose part of a surface of the second conductive layer. A fifth insulation layer and a fourth insulation layer within the fourth type of vias may be removed to expose part of a surface of the second semiconductor layer. A fifth insulation layer within the fifth type of vias may be removed to expose part of a surface of the third conductive layer.

In some examples, the first type of vias, the second type of vias, and the third type of vias may be formed by a same patterning process, and the fourth type of vias and the fifth type of vias may be formed by a same patterning process.

(9) A fourth conductive layer is formed. In some examples, a fourth conductive thin film is deposited on the base substrate on which the aforementioned patterns are formed, and the fourth insulation thin film is patterned by a patterning process to form a fourth conductive layer on the fifth insulation layer. In some examples, the fourth conductive layer may also be referred to as a first source-drain metal layer.

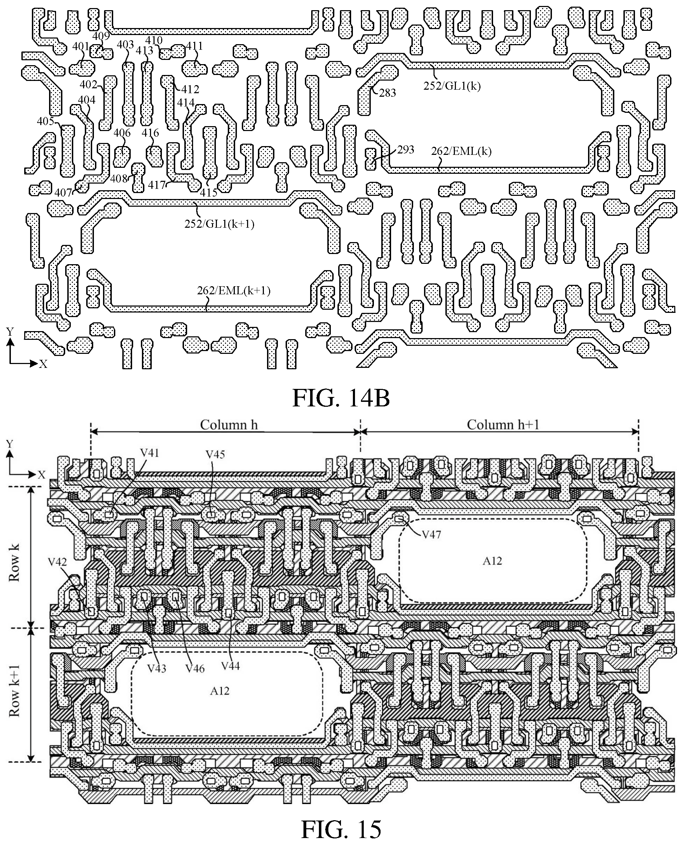

FIG. 14A is a schematic diagram of a first display region after a fourth conductive layer is formed in FIG. 6. FIG. 14B is a schematic diagram of a fourth conductive layer in FIG. 14A. In some examples, as shown in FIGS. 14A and 14B, the fourth conductive layer of the first display region may include at least a plurality of pixel connection electrodes (for example, including a first pixel connection electrode 401 to a seventeenth pixel connection electrode 417), a plurality of wire transition electrodes (for example, including a first wire transition electrode 283 and a second wire transition electrode 293), first scan connection sections 252 of a plurality of first scan lines (for example, including first scan lines GL1(k), GL1(k+1)), and light emitting control connection sections 262 of a plurality of light emitting control lines (for example, including light emitting control lines EML(k), EML(k+1)).

In some examples, the first pixel connection electrode 401 may be in a substantially rectangular shape. The first pixel connection electrode 401 may be electrically connected with the fourth active layer 340a of the fourth transistor 34a of the first pixel circuit 11a through a third via V3.

In some examples, a shape of a second pixel connection electrode 402 may be substantially a strip shape extending in the second direction Y. One end of the second pixel connection electrode 402 may be electrically connected with the second active layer 320a of the second transistor 32a of the first pixel circuit 11a through a thirty-first via V31, and the other end may be electrically connected with the first electrode 391a of the storage capacitor of the first pixel circuit 11a through a twenty-first via V21. The second pixel connection electrode 402 is electrically connected with a gate electrode of the third transistor 33a, the first electrode 391a of the storage capacitor, and a first electrode of the second transistor 32a, and the second pixel connection electrode 402 may serve as a first node of the first pixel circuit 11a.

In some examples, a shape of the third pixel connection electrode 403 may be substantially a strip shape extending in the second direction Y. One end of the third pixel connection electrode 403 may be electrically connected with a first active layer 310a of the first transistor 31a of the first pixel circuit 11a through a second via V2, the other end may be electrically connected with a second active layer 320a of the second transistor 32a through a thirty-second via V32, and may be electrically connected with a third active layer of the third transistor 33a through a sixth via V6. The third pixel connection electrode 403 may serve as a third node of the first pixel circuit 11a.

In some examples, a shape of the fourth pixel connection electrode 404 may be substantially a bend line shape extending in the second direction Y. The fourth pixel connection electrode 404 may be electrically connected with a fourth active layer 340a of the fourth transistor 34a of the first pixel circuit 11a through a fourth via V4, and may be electrically connected with an eighth active layer 380a of the eighth transistor 38a through an eighth via V8.

In some examples, a shape of a fifth pixel connection electrode 405 may be substantially a strip shape extending in the second direction Y. The fifth pixel connection electrode 405 may be electrically connected with a fifth active layer 350a of the fifth transistor 35a of the first pixel circuit 11a through a fifth via V5, and may be electrically connected with a second plate connection block 392-2 to which the second electrode 392a of the storage capacitor of the first pixel circuit 11a is connected through a twenty-third via V23, thereby achieving electrical connection with the second electrode 392a of the storage capacitor of the first pixel circuit 11a.

In some examples, a sixth pixel connection electrode 406 may be in a substantially rectangular shape. The sixth pixel connection electrode 406 may be electrically connected with a sixth active layer 360a of the sixth transistor 36a of the first pixel circuit 11a through a seventh via V7.

In some examples, a seventeenth pixel connection electrode 407 may be substantially L-shaped. The seventh pixel connection electrode 407 may be electrically connected with the eighth active layer 380a of the eighth transistor 38a of the first pixel circuit 11a through a ninth via V9, and may be electrically connected with the initial signal transmission section 291 of the third initial signal line INIT3(k) through a twenty-sixth via V26.

In some examples, a shape of an eighth pixel connection electrode 408 may be substantially a strip shape extending in the second direction Y. The eighth pixel connection electrode 408 may be electrically connected with the seventh active layer 370a of the seventh transistor 37a of the first pixel circuit 11a through a tenth via V10, and may be electrically connected with the second initial signal line INIT2 (k) through a twenty-seventh via V27.

In some examples, a shape of a ninth pixel connection electrode 409 may be substantially in a shape like figure 8 lied flat. One end of the ninth pixel connection electrode 409 may be electrically connected with the first active layer 310a of the first transistor 31a of the first pixel circuit 11a through the first via V1, and the other end may be electrically connected with the first initial signal line INIT1(k) through a twenty-fifth via V25.

In some examples, a shape of a tenth pixel connection electrode 410 may be substantially in a shape like figure 8 lied flat. One end of the tenth pixel connection electrode 410 may be electrically connected with a first active layer 310b of the first transistor 31b of the first pixel circuit 11b through an eleventh via V11, and the other end may be electrically connected with the first initial signal line INIT1(k) through a twenty-eighth via V28.

In some examples, a shape of an eleventh pixel connection electrode 411 may be substantially in a rectangular shape. The eleventh pixel connection electrode 411 may be electrically connected with a fourth active layer 340b of the fourth transistor 34b of the first pixel circuit 11b through a thirteenth via V13.

In some examples, a shape of a twelfth pixel connection electrode 412 may be substantially in a strip shape extending in the second direction Y. One end of the twelfth pixel connection electrode 412 may be electrically connected with a second active layer 320b of the second transistor 32b of the first pixel circuit 11b through a thirty-third via V31, and the other end may be electrically connected with a first electrode 391b of a storage capacitor of the first pixel circuit 11b through a twenty-second via V22. The twelfth pixel connection electrode 412 is electrically connected with a gate electrode of the third transistor 33b, a first electrode 391b of the storage capacitor, and a first electrode of the second transistor 32b, and the twelfth pixel connection electrode 412 may serve as a first node of the first pixel circuit 11b.

In some examples, a shape of a thirteenth pixel connection electrode 413 may be substantially in a strip shape extending in the second direction Y. One end of the thirteenth pixel connection electrode 413 may be electrically connected with the first active layer 310b of the first transistor 31b of the first pixel circuit 11b through a twelfth via V12, the other end may be electrically connected with the second active layer 320b of the second transistor 32b through a thirty-fourth via V34, and may be electrically connected with a third active layer 330b of the third transistor 33b through a sixteenth via V16. The thirteenth pixel connection electrode 413 may serve as a third node of the first pixel circuit 11b.

In some examples, a shape of a fourteenth pixel connection electrode 414 may be substantially in a bend line shape extending in the second direction Y. The fourteenth pixel connection electrode 414 may be electrically connected with the fourth active layer 340b of the fourth transistor 34b of the first pixel circuit 11b through a fourteenth via V14, and may be electrically connected with an eighth active layer 380b of the eighth transistor 38b through an eighteenth via V18.

In some examples, a shape of a fifteenth pixel connection electrode 415 may be substantially in a strip shape extending in the second direction Y. The fifteenth pixel connection electrode 415 may be electrically connected with a fifth active layer 350b of the fifth transistor 35b of the first pixel circuit 11b through a fifteenth via V15, and may be electrically connected with a second plate connection block 392-2 to which the second electrode 392b of the storage capacitor of the first pixel circuit 11b is connected through a twenty-fourth via V24, thereby achieving electrical connection with the second electrode 392b of the storage capacitor of the first pixel circuit 11b.

In some examples, a shape of a sixteenth pixel connection electrode 416 may be substantially in a rectangular shape. The sixteenth pixel connection electrode 416 may be electrically connected with a sixth active layer 360b of the sixth transistor 36b of the first pixel circuit 11b through a seventeenth via V17.

In some examples, a shape of a seventeenth pixel connection electrode 417 may be substantially L-shaped. The seventeenth pixel connection electrode 417 may be electrically connected with an eighth active layer 380b of the eighth transistor 38b of the first pixel circuit 11b through a nineteenth via V19, and may be electrically connected with the initial signal transmission section 291 of the third initial signal line INIT3(k) through a twenty-ninth via V29.

In some examples, in a display island region, the first pixel circuits 11a and 11b may be substantially symmetrical with respect to the second centerline O2, the first pixel circuits 11c and 11d may be substantially symmetrical with respect to the third centerline O3, and the first pixel circuits 11a and 11b, and the first pixel circuits 11c and 11d may be substantially symmetrical with respect to the first centerline O1.

In some examples, a shape of the first wire transition electrode 283 may be substantially L-shaped. The first wire transition electrode 283 may be connected with the second scan auxiliary transmission section 271 of the second scan auxiliary line GL2b(k) through a thirty-seventh via V37, and may be connected with the second scan transmission section 281 of the second scan line GL2(k) through a thirty-sixth via V36.

In some examples, a shape of the second wire transition electrode 293 may be substantially in a rectangular shape. The second wire transition electrode 293 may be connected with the initial signal transmission section 291 located in the third conductive layer through a thirty-ninth via V39, and may be connected with the initial signal connection section 292 located in the second conductive layer through a fortieth via V40. In this example, both ends of an initial signal connection section 292 may be respectively connected with initial signal transmission sections 291 located in two adjacent display island regions in a same row through a second wire transition electrode 293, thereby achieving transmission of a third initial signal in the first direction X.

In some examples, a shape of the first scan connection section 252 of the first scan line GL1(k) may be substantially in a bend line shape extending in the first direction X. The first scan connection section 252 of the first scan line GL1(k) may be located on the side of the light-transmitting region A12 in the k-th row and (h+1)-th column in the second direction Y. The first scan connection section 252 may be located, for example, in a display island region in a (k-1)-th row and (h+1)-th column. An orthographic projection of the first scan connection section 252 on the base substrate may be partially overlapped with orthographic projections of the first reset control line RST1(k) and the first initial signal line INIT1(k) on the base substrate. One end of the first scan connection section 252 may be connected with the first scan transmission section 251 located in the first conductive layer within the display island region in the k-th row and h-th column through a thirty-fifth via V35, and the other end may be connected with the first scan transmission section within the display island region in the k-th row and (h+1)-th column. The first scan connection section 252 may connect first scan transmission sections in two adjacent display island regions in the first direction X, thereby achieving transmission of a first scan signal in the first direction X.

In some examples, a shape of the light emitting control connection section 262 of the light emitting control line EML(k) may be substantially in a bend line shape extending along the first direction X. The light emitting control connection section 262 of the light emitting control line EML(k) may be located on the side of the light-transmitting region A12 in the k-th row and (h+1)-th column in the opposite direction of the second direction Y. The light emitting control connection section 262 may, for example, be located within the display island region in the (k+1)-th row and (h+1)-th column. An orthographic projection of the light emitting control connection section 262 on the base substrate may be partially overlapped with orthographic projections of the second reset control line RST2(k), the second initial signal line INIT2(k), and the initial signal connection section 292 on the base substrate. One end of the light emitting control connection section 262 may be connected with the light emitting control transmission section 261 located in the first conductive layer within the display island region in the k-th row and h-th column through a thirty-eighth via V38, and the other end may be connected with the light emitting control transmission section in the display island region in the k-th row and (h+1)-th column. The light emitting control connection section 262 may connect light emitting control transmission sections within two adjacent display island regions in the first direction X, thereby achieving transmission of a light emitting control signal in the first direction X.

(10) A sixth insulation layer and a seventh insulation layer are formed. In some examples, a sixth insulation thin film is deposited on the base substrate on which the aforementioned patterns are formed, then a seventh insulation thin film is coated, and the seventh insulation thin film and the sixth insulation thin film are patterned by a patterning process to form a sixth insulation layer and a seventh insulation layer. In some examples, the sixth insulation layer may also be referred to as a passivation layer and the seventh insulation layer may also be referred to as a first planarization layer.

FIG. 15 is a schematic diagram of the first display region after a seventh insulation layer is formed in FIG. 6. In some examples, as shown in FIG. 15, the seventh insulation layer in the first display region may be provided with a plurality of vias, which, for example, may include a forty-first via V41 to a forty-seventh via V47. The seventh insulation layer and the sixth insulation layer within the forty-first via V41 to the forty-seventh via V47 may be removed to expose part of a surface of the fourth conductive layer.

(11) A fifth conductive layer is formed. In some examples, a fifth conductive thin film is deposited on the base substrate on which the aforementioned patterns are formed, and the fifth conductive thin film is patterned by a patterning process to form a fifth conductive layer on the seventh insulation layer. In some examples, the fifth conductive layer may also be referred to as a second source-drain metal layer.

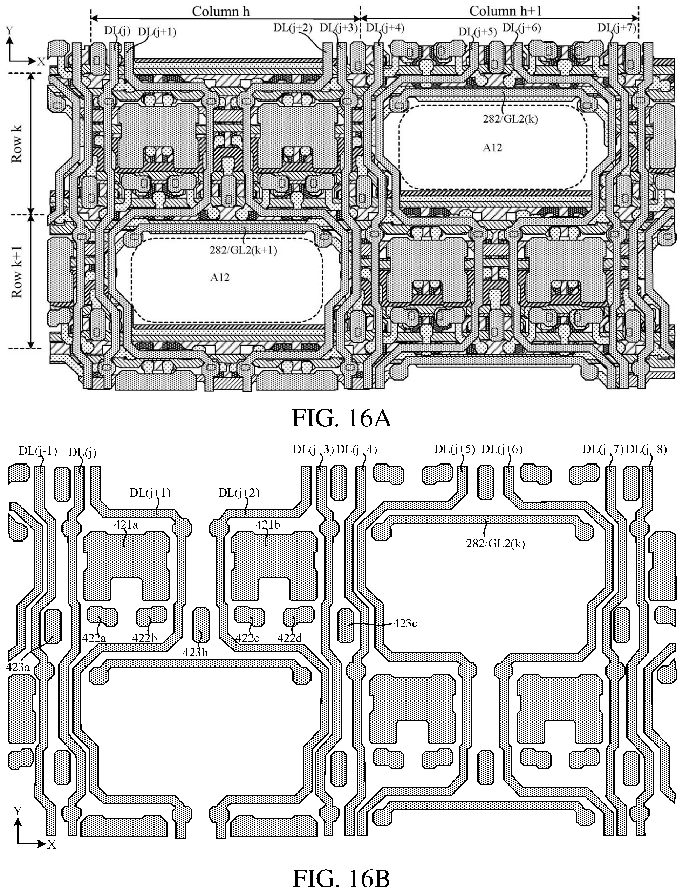

FIG. 16A is a schematic diagram of a first display region after a fifth conductive layer is formed in FIG. 6. FIG. 16B is a schematic diagram of the fifth conductive layer in FIG. 16A. In some examples, as shown in FIGS. 16A and 16B, the fifth conductive layer in the first display region may include at least: a plurality of data lines (e.g., including data lines DL(j-1), DL(j), DL(j+1), DL(j+2), DL(j+3), DL(j+4), DL(j+5), DL(j+6), DL(j+7), DL(j+8)), a plurality of first anode connection electrodes (e.g., first anode connection electrodes 422a, 422b, 422c, and 422d), a plurality of first power supply connection electrodes (e.g., first power supply connection electrodes 423a, 423b, and 423c), a plurality of first shielding electrodes (e.g., first shielding electrodes 421a and 421b), and second scan connection sections 282 of a plurality of second scan lines (e.g., second scan lines GL2(k) and GL2(k+1)) . Herein j is an integer greater than 0.

In some examples, the plurality of data lines may be substantially in bend line shape extending in the second direction Y. Four first pixel circuits in each display island region may be electrically connected with four data lines in a one-to-one correspondence. The data line DL(j) may be electrically connected with the first pixel connection electrode 401 through the forty-first via V41, thereby being electrically connected with a fourth transistor of the first pixel circuit 11a. The data line DL(j+1) may be electrically connected with the eleventh pixel connection electrode 411 through a forty-fifth via V45, thereby being electrically connected with a fourth transistor of the first pixel circuit 11b. The data line DL(j+2) may be electrically connected with a fourth transistor of the first pixel circuit 11c. The data line DL(j+3) may be electrically connected with a fourth transistor of the first pixel circuit 11d.

In some examples, four data lines electrically connected with four first pixel circuits in a display island region may be divided into two groups bypassing the light-transmitting region A12 adjacent to the display island region in the second direction Y. For example, the data line DL (j) to which the first pixel circuit 11a is connected and the data line DL (j+1) to which the first pixel circuit 11b is connected may bypass the light-transmitting region A12 located in an h-th column from a side of the light-transmitting region A12 in the opposite direction of the first direction X, and the data line DL (j+2) to which the first pixel circuit 11c is connected and the data line DL (j+3) to which the first pixel circuit 11d is connected may bypass the light-transmitting region A12 located in the h-th column from a side of the light-transmitting region A12 in the first direction X. In this example, the data line is bent to bypass the light-transmitting region, which is beneficial to reducing the space occupied by the wiring, thereby improving the light transmittance of the first display region.

In some examples, the first anode connection electrodes 422a, 422b, 422c, and 422d may be substantially in a shape of a rectangle. The first anode connection electrodes 422a and 422b may be located between the data lines DL(j) and DL(j+1), and the first anode connection electrodes 422c and 422d may be located between the data lines DL(j+2) and DL(j+3).

In some examples, the first anode connection electrode 422a may be electrically connected with the sixth pixel connection electrode 406 through a forty-third via V43, thereby achieving electrical connection with a sixth transistor of the first pixel circuit 11a. The first anode connection electrode 422b may be electrically connected with the sixteenth pixel connection electrode 416 through a forty-sixth via V46, thereby achieving electrical connection with a sixth transistor of the first pixel circuit 11b. The first anode connection electrode 422c may be electrically connected with a sixth transistor of the first pixel circuit 11c. The first anode connection electrode 422d may be electrically connected with a sixth transistor of the first pixel circuit 11d.

In some examples, the first power supply connection electrodes 423a, 423b, and 423c may be substantially in a shape of a rectangle. The first power supply connection electrode 423a may be located between the data lines DL(j) and DL(j-1), the first power supply connection electrode 423b may be located between the data lines DL(j+1) and DL(j+2), and the first power supply connection electrode 423c may be located between the data lines DL(j+3) and DL(j+4).

In some examples, the first power supply connection electrode 423a may be electrically connected with the fifth pixel connection electrode 405 through a forty-second via V42, thereby achieving electrical connection with a fifth transistor and a storage capacitor of the first pixel circuit 11a. The second power supply connection electrode 423b may be electrically connected with the fifteenth pixel connection electrode 415 through the forty-fourth via V44, thereby achieving electrical connection with fifth transistors and storage capacitors of the first pixel circuits 11b and 11c. The third power supply connection electrode 423c may be electrically connected with a fifth transistor and a storage capacitor of the first pixel circuit 11d.

In some examples, the first shielding electrodes 421a and 421b may be substantially n-shaped. The first shielding electrode 421a may be located between the data lines DL(j) and DL(j+1), and the first shielding electrode 421b may be located between the data lines DL(j+2) and DL(j+3). An orthographic projection of the first shielding electrode 421a on the base substrate may cover orthographic projections of the second pixel connection electrode 402 and the twelfth pixel connection electrode 412 on the base substrate, which may achieve shielding a first node of the first pixel circuit 11a and a first node of the first pixel circuit 11b, thereby avoiding an influence of other signals on the first nodes of the first pixel circuits 11a and 11b. The second shielding electrode 421b may achieve shielding a first node of the first pixel circuit 11c and a first node of the first pixel circuit 11d, thereby avoiding an influence of other signals on the first nodes of the first pixel circuits 11c and 11d.

In some examples, a shape of the second scan connection section 282 of the second scan line GL2(k) may be substantially in a bend line shape extending in the first direction X. The second scan connection section 282 of the second scan line GL2(k) may be located on a side of the light-transmitting region A12 in the k-th row and (h+1)-th column in the second direction Y. The second scan connection section 282 may be located, for example, within a display island region in a (k-1)-th row and (h+1)-th column. An orthographic projection of the second scan connection section 282 on the base substrate may be partially overlapped with orthographic projections of the first scan connection section 252, the first reset control line RST1(k), and the first initial signal line INIT1(k) on the base substrate. One end of the second scan connection section 282 may be connected with the first wire transition electrode 283 within the display island region in the k-th row and h-th column through a forty-seventh via V47 to achieve a connection with a second scan transmission section 281 and a second scan auxiliary transmission section 271 within the display island region in the k-th row and h-th column, and the other end of the second scan connection section 282 may be connected with a second scan transmission section 281 and a second scan auxiliary transmission section 271 within the display island region in the k-th row and (h+1)-th column. The second scan connection section 282 may be connected with second scan transmission sections within two adjacent display island regions in the first direction X, and may be connected with second scan auxiliary transmission sections within two adjacent display island regions in the first direction X, thereby achieving transmission of a second scan signal in the first direction X.

(12) An eighth insulation layer is formed. In some examples, an eighth insulation layer is coated on the base substrate on which the aforementioned patterns are formed, and the eighth insulation layer is patterned by a patterning process to form an eighth insulation layer. In some examples, the eighth insulation layer may also be referred to as a second planarization layer.

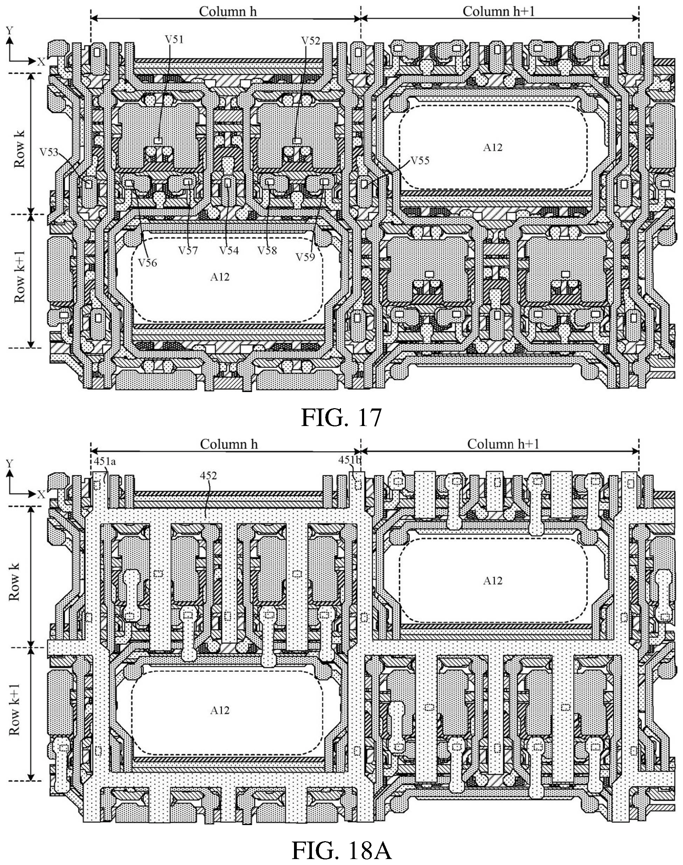

FIG. 17 is a schematic diagram of the first display region after an eighth insulation layer is formed in FIG. 6. In some examples, as shown in FIG. 17, the eighth insulation layer of the first display region may be provided with a plurality of vias, which, for example, may include a fifty-first via V51 to a fifty-ninth via V59. The eighth insulation layer within the fifty-first via V51 to the fifty-ninth via V59 may be removed to expose part of a surface of the fifth conductive layer.

(13) A sixth conductive layer is formed. In some examples, a sixth conductive thin film is deposited on the base substrate on which the aforementioned patterns are formed, and the sixth conductive thin film is patterned by a patterning process to form a sixth conductive layer on the eighth insulation layer. In some examples, the sixth conductive layer may also be referred to as a third source-drain metal layer.

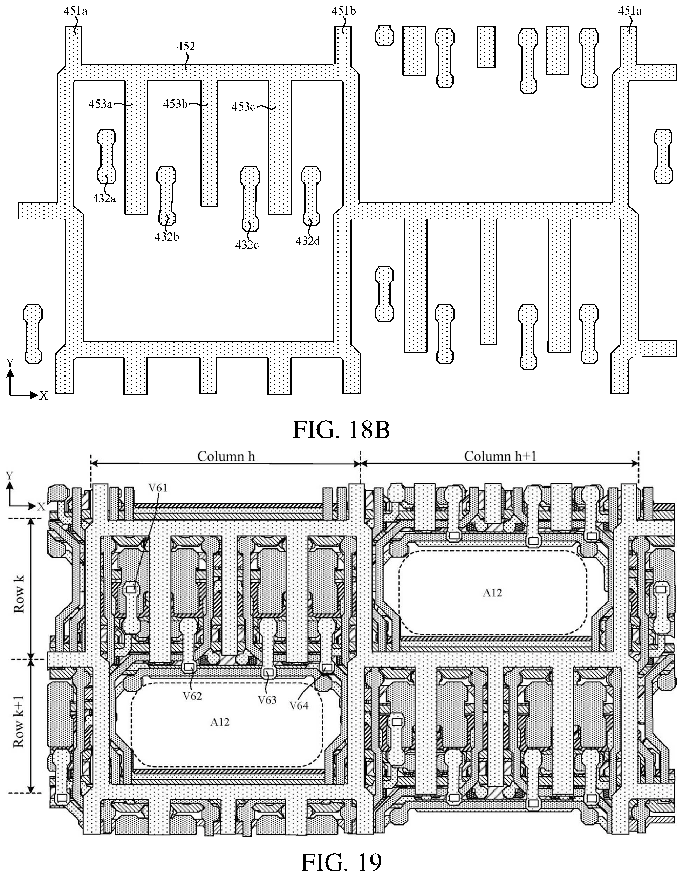

FIG. 18A is a schematic diagram of a first display region after a sixth conductive layer is formed in FIG. 6. FIG. 18B is a schematic diagram of the sixth conductive layer in FIG. 18A. In some examples, as shown in FIGS. 18A and 18B, the sixth conductive layer in the first display region may include at least a plurality of second anode connection electrodes (e.g., including second anode connection electrodes 432a, 432b, 432c, and 432d), a plurality of first voltage transmission lines (e.g., including first voltage transmission lines 451a and 451b), a plurality of power supply connection bars 452, and a plurality of second power supply connection electrodes (e.g., including second power supply connection electrodes 453a, 453b, and 453c).

In some examples, shapes of the first voltage transmission lines 451a and 451b may be a bend line shape extending in the second direction Y. The first voltage transmission lines 451a and 451b may be disposed at intervals in the first direction X. The first voltage transmission line 451a may be electrically connected with the first power supply connection electrode 423a through a fifty-third via V53, and the first voltage transmission line 451b may be electrically connected with the first power supply connection electrode 423c through a fifty-fifth via V55. The first voltage transmission lines 451a and 451b may be input a first voltage signal. For example, the first voltage transmission lines 451a and 451b may extend to a peripheral area, and be electrically connected with a first power supply line in the peripheral area to access the first voltage signal.

In some examples, a shape of a power supply connection bar 452 may be substantially in a straight line shape extending in the first direction X. A power supply connection bar 452 may connect two adjacent first voltage transmission lines 451a and 451b. A power supply connection bar 452 within a single display island region may be connected with three second power supply connection electrodes 453a, 453b, and 453c. Shapes of the second power supply connection electrodes 453a, 453b, and 453c may be substantially in a straight line shape extending in the second direction Y. The second power supply connection electrode 453a may be connected with the first shield electrode 421a through the fifty-first via V51, the second power supply connection electrode 453b may be connected with the first power supply connection electrode 432b through a fifty-fourth via V54, and the second power supply connection electrode 453c may be connected with the second shield electrode 421b through a fifty-second via V52. The power supply connection bar 452, the first voltage transmission lines 451a and 451b, and the plurality of second power supply connection electrodes 453a, 453b, and 453c may be interconnected into an integral structure, thereby forming a mesh connection structure for transmitting the first voltage signal in the first display region to ensure transmission uniformity of the first voltage signal.

In some examples, the second anode connection electrode 432a may be located between the first voltage transmission line 451a and the second power supply connection electrode 453a, the second anode connection electrode 432b may be located between the second power supply connection electrodes 453a and 453b, the second anode connection electrode 432c may be located between the second power supply connection electrodes 453b and 453c, and the second anode connection electrode 432d may be located between the second power supply connection electrode 453c and the first voltage transmission line 451b.

In some examples, shapes of the second anode connection electrodes 432a, 432b, 432c, and 432d may be substantially in a strip shape extending in the second direction Y. The second anode connection electrode 432a may be electrically connected with the first anode connection electrode 422a through a fifty-sixth via V56. The second anode connection electrode 432b may be electrically connected with the first anode connection electrode 422b through a fifty-seventh via V57. The second anode connection electrode 432c may be electrically connected with the first anode connection electrode 422c through a fifty-eighth via V58. The second anode connection electrode 432d may be electrically connected with the first anode connection electrode 422d through the fifty-ninth via V59.

In this example, the fifth conductive layer and the sixth conductive layer are disposed for arranging the data lines and the first voltage transmission lines, so that the conductive layer close to the anode layer being arranged too much wires which affect a flatness of the anode layer can be avoided. Moreover, disposing the first voltage transmission lines on the sixth conductive layer and disposing the data lines on the fifth conductive layer can increase a distance between the data lines and the anode layer, preventing signal transmission of the data lines from affecting the anode layer.

(14) A ninth insulation layer is formed. In some examples, a ninth insulation layer is coated on the base substrate on which the aforementioned patterns are formed, and the ninth insulation layer is patterned by a patterning process to form a ninth insulation layer. In some examples, the ninth insulation layer may also be referred to as a third planarization layer.

FIG. 19 is a schematic diagram of a first display region after a ninth insulation layer is formed in FIG. 6. In some examples, as shown in FIG. 19, the ninth insulation layer in the first display region may be provided with a plurality of vias, which, for example, may include a sixty-first via V61 to a sixty-fourth via V64. The ninth insulation layer within the sixty-first via V61 to the sixty-fourth via V64 may be removed to expose part of a surface of the sixth conductive layer.

So far, manufacturing for the circuit structure layer may be completed. A film structure of a circuit structure layer in the second display region is similar to a film structure of the first display region, and therefore, it will not be repeated herein. Herein, first scan lines, second scan lines, second scan auxiliary lines, light emitting control lines, and third initial signal lines in the second display region may not use a segmented transition design.

(15) A light emitting structure layer is formed. In some examples, an anode thin film is deposited on the base substrate on which the aforementioned patterns are formed, and the anode thin film is patterned by a patterning process to form an anode layer.

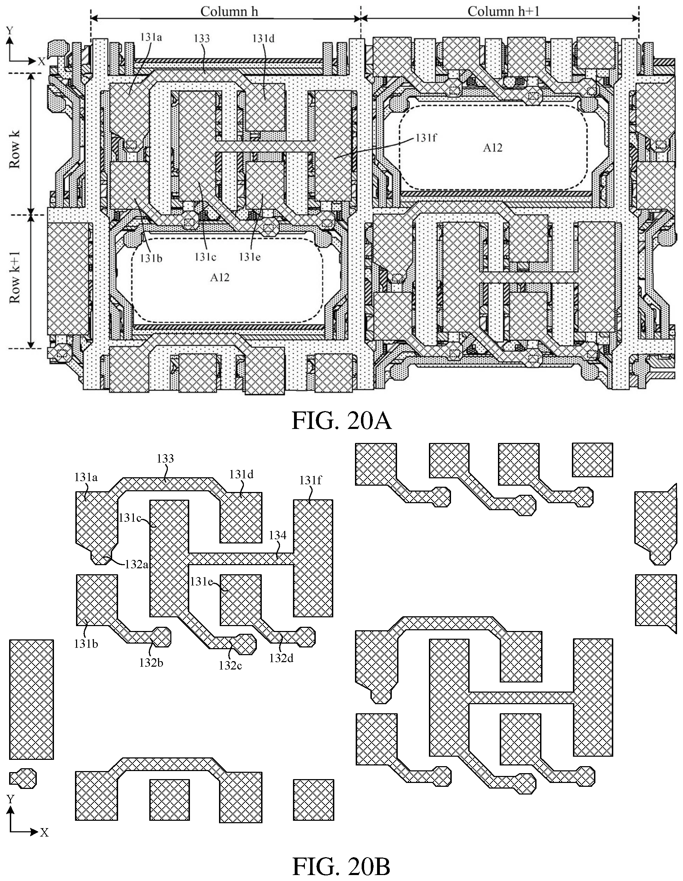

FIG. 20A is a schematic diagram of a first display region after an anode layer is formed in FIG. 6. FIG. 20B is a schematic diagram of the anode layer in FIG. 20A. In some examples, as shown in FIGS. 20A and 20B, the anode layer in the first display region may include at least anodes of a plurality of first light emitting elements (e.g., including an anode 131a of a first light emitting element 13a, an anode 131b of a first light emitting element 13b, an anode 131c of a first light emitting element 13c, an anode 131d of a first light emitting element 13d, an anode 131e of a first light emitting element 13e, an anode 131f of a first light emitting element 13f), a plurality of anode connection blocks (e.g., including anode connection blocks 132a, 132b, 132c, and 132d), and a plurality of anode connection bars (e.g., including a first anode connection bar 133 and a second anode connection bar 134).

In some examples, the anodes 131a, 131b, 131c, 131d, 131e, and 131f may be substantially rectangular in shape. The anode 131a may be located on a side of the anode 131b in the second direction Y, and the anode 131c may be located on a side of the anodes 131a and 131b in the first direction X. The anode 131d may be located on a side of the anode 131e in the second direction Y, and the anode 131f may be located on a side of the anodes 131d and 131e in the first direction X.

In some examples, the anode connection block 132a may be substantially hexagonal in shape. The anode 131a and the anode connection block 132a may be interconnected into an integral structure. The anode connection block 132a may be electrically connected with the second anode connection electrode 432a through the sixty-first via V61 to achieve electrical connection with the first pixel circuit 11a. The anode connection blocks 132b, 132c, and 132d may be substantially V-shaped. The anode 131b and the anode connection block132b may be interconnected into an integral structure. The anode connection block 132b may be electrically connected with the second anode connection electrode 432b through a sixty-second via V62 to achieve electrical connection with the first pixel circuit 11b. The anode 131c and the anode connection block132c may be interconnected into an integral structure. The anode connection block 132c may be electrically connected with the second anode connection electrode 432c through a sixty-third via V63 to achieve electrical connection with the first pixel circuit 11c. The anode 131e and the anode connection block 132d may interconnected into an integral structure. The anode connection block 132d may be electrically connected with the second anode connection electrode 432d through the sixty-fourth via V64 to achieve electrical connection with the first pixel circuit 11d.

In some examples, a shape of the first anode connection bar133 may be substantially in a bend line shape extending in the first direction X. Both ends of the first anode connection bar 133 may be connected with the anodes 131a and 131d, respectively. The first anode connection bar 133 may be located on a side of the anode 131c in the second direction Y. The first anode connection bar 133, the anodes 131a and 131d, and the anode connection block 132a may be interconnected into an integral structure.

In some examples, a shape of the second connection bar 134 may be substantially in a strip shape extending in the first direction X. Both ends of the second anode connection bar 134 may be connected with the anodes 131c and 131f, respectively. The second anode connection bar 134 may be located in the middle of the anodes 131d and 131e. The second anode connection bar 134, the anodes 131c and 131f, and the anode connection block 132c may be interconnected into an integral structure.

In some examples, a pixel definition thin film is coated on the base substrate on which the aforementioned patterns are formed, and a pixel definition layer is formed through masking, exposure, and development processes. As shown in FIG. 6, the pixel definition layer in the first display region may be formed with a plurality of first pixel openings (e.g. including: first pixel openings 130a, 130b, 130c, and 130d). The plurality of first pixel openings may be substantially rectangular in shape. A first pixel opening 130a of the first light emitting element 13a and a first pixel opening 130d of the first light emitting element 13d may have substantially a same size, a first pixel opening 130c of the first light emitting element 13c and a first pixel opening 130f of the first light emitting element 13f may have substantially a same size, and a first pixel opening 130b of the first light emitting element 13b and a first pixel opening 130e of the first light emitting element 13e may have substantially a same size. The first pixel opening 130c of the first light emitting element 13c may be larger than the first pixel opening 130a of the first light emitting element 13a and may be larger than the first pixel opening 130b of the first light emitting element 13b.

In some examples, a light emitting area of a light emitting element may be a portion of the light emitting element located at a pixel opening of the pixel definition layer. For example, an area of a light emitting area of the first light emitting element 13a may be greater than or equal to an area of a light emitting area of the first light emitting element 13b, and an area of a light emitting area of the first light emitting element 13c may be larger than an area of a light emitting area of the first light emitting element 13a and larger than an area of a light emitting area of the first light emitting element 13b.

In some examples, an organic light emitting layer is formed within a pixel opening formed above, and the organic light emitting layer is connected with the anode layer. Subsequently, a cathode thin film is deposited, the cathode thin film is patterned by a patterning process to form a cathode layer, and the cathode layer may be connected with the organic light emitting layer.

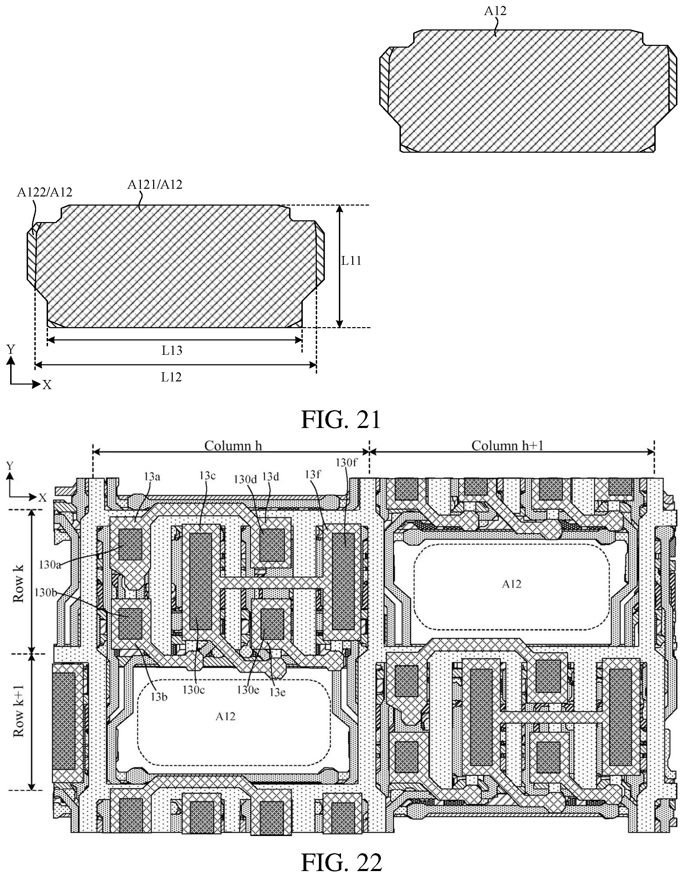

FIG. 21 is a schematic diagram of the light-transmitting region in FIG. 6. In some examples, as shown in FIG. 21, the light-transmitting region A12 may include a first area A121 and a second area A122. Orthographic projections of the first area A121 and the second area A122 on the base substrate may not overlap. The light-transmitting region A12 may be substantially elliptical as a whole, and shapes of the plurality of light-transmitting regions A12 are substantially the same, and are substantially wide at the top and narrow at the bottom. The first area A121 may have an irregular shape, and the second area A122 may be located at an edge position of the first area A121. The cathode layer within the first area A121 may be removed, and the cathode layer within the second area A122 may be retained.

In some examples, as shown in FIG. 21, a maximum length L11 of the light-transmitting region A12 in the second direction Y may be 30 micrometers to 40 micrometers, such as may be about 35 micrometers. A maximum length L12 of the first area A121 of the light-transmitting region A12 in the first direction X may be 70 micrometers to 90 micrometers, such as about 81 micrometers. A minimum length L13 of a side edge of a lower portion of the first area A121 extending in the second direction Y may be 65 micrometers to 82 micrometers in the first direction X, such as about 74 micrometers.

In some examples, an encapsulation structure layer may be formed on the cathode after the light emitting structure layer is manufactured. In some examples, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer may be disposed between the first encapsulation layer and the third encapsulation layer to form a laminated structure of inorganic material/organic material/inorganic material, which may ensure that external moisture cannot enter the light emitting structure layer. In some possible implementations, the display substrate may further include another film, such as a touch structure layer and a color filter layer, which is not limited here in this embodiment.

In some examples, the shielding layer, the first conductive layer, the second conductive layer, the third conductive layer, the fourth conductive layer, the fifth conductive layer, and the sixth conductive layer may be made of a metal material, such as, any one or more of silver (Ag), copper (Cu), aluminum (Al), and molybdenum (Mo), or an alloy material of the above metals, such as, an aluminum-neodymium alloy (AlNd), or a molybdenum-niobium alloy (MoNb), which may be in a single layer structure, or a multi-layer composite structure, such as, Mo/Cu/Mo, etc. The first insulation layer, the second insulation layer, the third insulation layer, the fourth insulation layer, the fifth insulation layer, and the sixth insulation layer may be made of any one or more of Silicon Oxide (SiOx, x>0), Silicon Nitride (SiNy, y>0), and Silicon OxyNitride (SiON), and may be a single layer, a multi-layer, or a composite layer. The seventh insulation layer, the eighth insulation layer, and the ninth insulation layer may be made of an organic material, such as polyimide, acrylic, or polyethylene terephthalate. The pixel definition layer may be made of an organic material, such as polyimide, acrylic, or polyethylene terephthalate. However, the present embodiment is not limited thereto.

The structure and the manufacturing process of the display substrate of the present embodiment are merely illustrative. In some exemplary implementations, a corresponding structure may be changed and a patterning process may be added or removed according to actual needs. The manufacturing process in the exemplary embodiment may be implemented using an existing mature manufacturing device, and may be compatible well with an existing manufacturing process, simple in process implementation, easy to implement, high in a production efficiency, low in a production cost, and high in yield.

In the display substrate of the present example, compared with the second display region, the first pixel circuits and the first light emitting elements in the first display region are reduced to form a light-transmitting region and a display island region, and the first pixel circuits and the first light emitting elements within the display island region are disposed in a combination mode of one-drive-one and one-drive-more, and an arrangement of the first light emitting elements within the display island region is different from an arrangement of the second light emitting elements in the second display region, so that the display effect of the first display region can be optimized on the basis of improving the light transmittance of the first display region.

In some examples, the first scan signal in the first display region may be transmitted through a first scan line formed by cross-layer connection of the first scan transmission section and the first scan connection section, the second scan signal may be transmitted through a second scan line formed by cross-layer connection of the second scan transmission section and the second scan connection section, and the first scan connection section and the second scan connection section may be located in different films and overlap in wiring, which may be beneficial to saving wiring space and thus increasing the area of the light-transmitting region. In some examples, the first scan connection section, the second scan connection section, the first reset control line, and the first initial signal line may be located in different films and overlap in wiring, which may be beneficial to save wiring space.

In some examples, the light emitting control signal in the first display region may be transmitted through a light emitting control line formed by cross-layer connection of the light emitting control transmission section and the light emitting control connection section. The light emitting control connection section, the first scan connection section and the second scan connection section can bypass the light-transmitting region from both sides of the light-transmitting region in the second direction, which is beneficial to rational wiring. In some examples, the light emitting control connection section, the second reset control line, and the second initial signal line may be located in different films and overlap in wiring, which may be beneficial to saving wiring space, and thus facilitate increasing the area of the light-transmitting region.

In some examples, the third initial signal in the first display region may be transmitted through a third initial signal line formed by cross-layer connection of the initial signal transmission section and the initial signal connection section. The initial signal connection section and the light emitting control connection section may be located in different films and overlap in wiring, which may be beneficial to saving wiring space.

FIG. 22 is another partial top view of a first display region according to at least one embodiment of the present disclosure. FIG. 22 illustrates a partial top view of two rows (e.g., a k-th row and a (k+1)-th row) and two columns (e.g., a h-th column and a (h+1)-th column) in display island regions, where k and h are both integers greater than 0. In some examples, as shown in FIG. 22, the first display region may include: a plurality of display island regions and a plurality of light-transmitting regions A12. A single light-transmitting region A12 is surrounded by two display island regions in the first direction X and two display island regions in the second direction Y. The number of films and the stacking order of the circuit structure layers of the display substrate of the present example are similar to those of the foregoing embodiments, and will be illustrated below by taking film structures of the display island region in the k-th row and h-th column and of the display island region in the (k+1)-th row and (h+1)-th column as example.

In some examples, k may take a value of 2d, and d is an integer greater than 0. A k-th row may be an odd-numbered row, and a (k+1)-th row and a (k-1)-th row may be even rows. In other examples, k may take a value of 2d-1, and d is an integer greater than 0. A k-th row may be an even-numbered row, and a (k+1)-th row and a (k-1)-th row may be odd rows. In this example, odd-numbered rows refer to rows whose row numbers are odd numbers; and even-numbered rows refer to rows whose row numbers are even numbers.

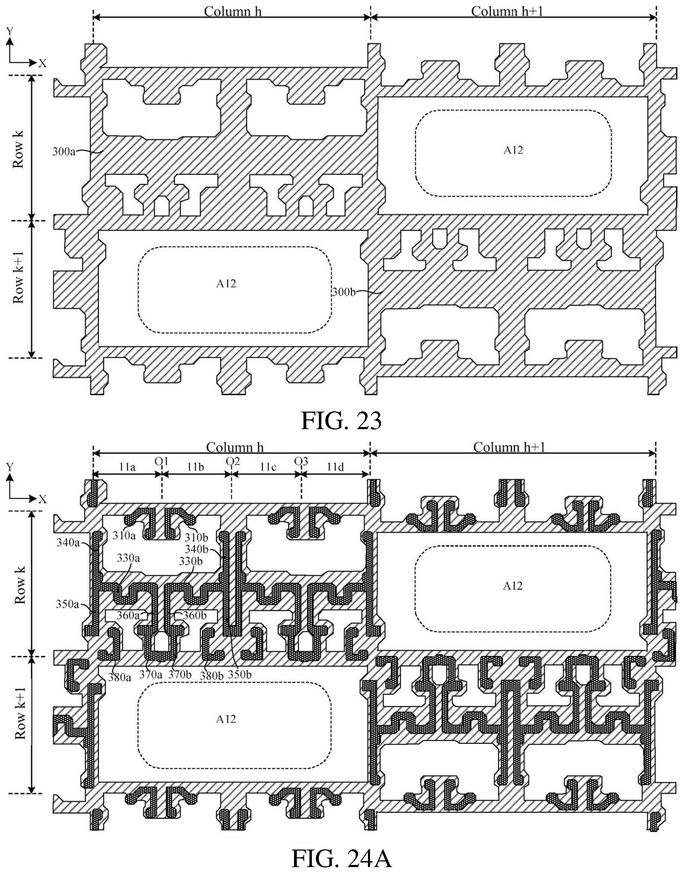

FIG. 23 is a schematic diagram of a first display region after a shielding layer is formed in FIG. 22. In some examples, as shown in FIG. 23, the shielding layer of the first display region may include at least a plurality of shielding blocks (e.g., shielding block 300a located in the display island region in the k-th row and h-th column and shielding block 300b located in the display island region in the (k+1)-th row and (h+1)-th column). Each display island region located in a k-th row may be provided with a shielding block 300a, and each display island region located in a (k+1)-th row may be provided with a shielding block 300b. A shielding block 300a and a shielding block 300b connected thereto may be centrally symmetrical about a connection point of the two. In adjacent columns of display island regions, the shielding blocks 300a and 300b of display island regions in adjacent rows may be interconnected into an integral structure. The plurality of shielding blocks 300a and 300b in the first display region may be interconnected into an integral structure. As for shapes of the shielding blocks, the description of the above-described embodiments can be referred to, and therefore, the description thereof will not be repeated here.

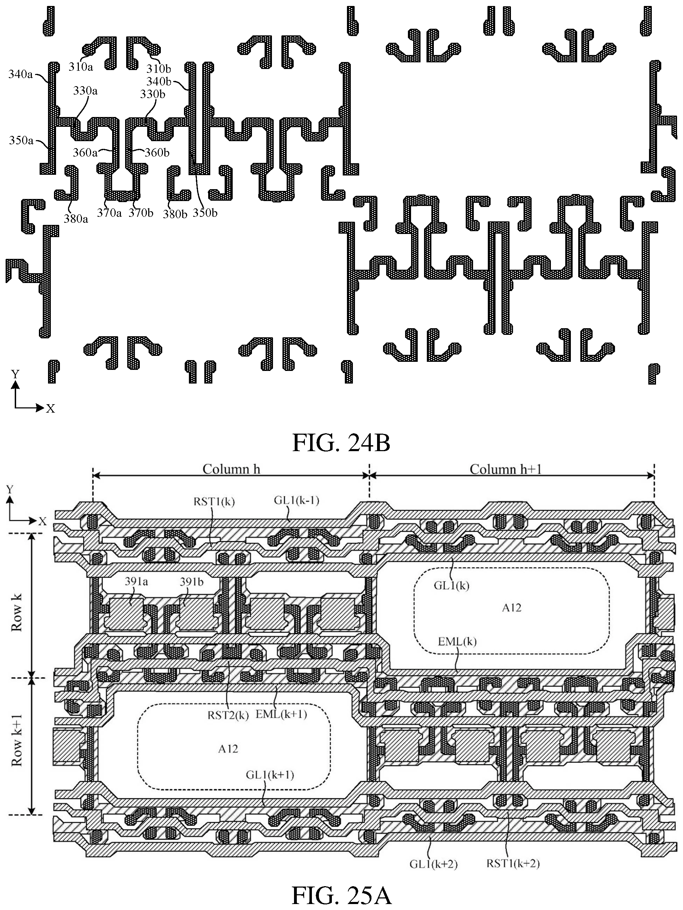

FIG. 24A is a schematic diagram of a first display region after a first semiconductor layer is formed in FIG. 22. FIG. 24B is a schematic diagram of the first semiconductor layer in FIG. 24A. In some examples, as shown in FIGS. 24A and 24B, the first semiconductor layer in the first display region may at least include active layers of a plurality of first-type transistors of a plurality of first pixel circuits. A pattern of a first semiconductor layer of four first pixel circuits located within the display island region in the k-th row and h-th column and a pattern of a first semiconductor layer of four first pixel circuits located in the display island region in the (k+1)-th row and (h+1)-th column may be centrally symmetrical about a connection point of the two. The description of a pattern of a first semiconductor layer within each display island region can be made with reference to the description of the above-described embodiments, and thus the description thereof will not be repeated herein.

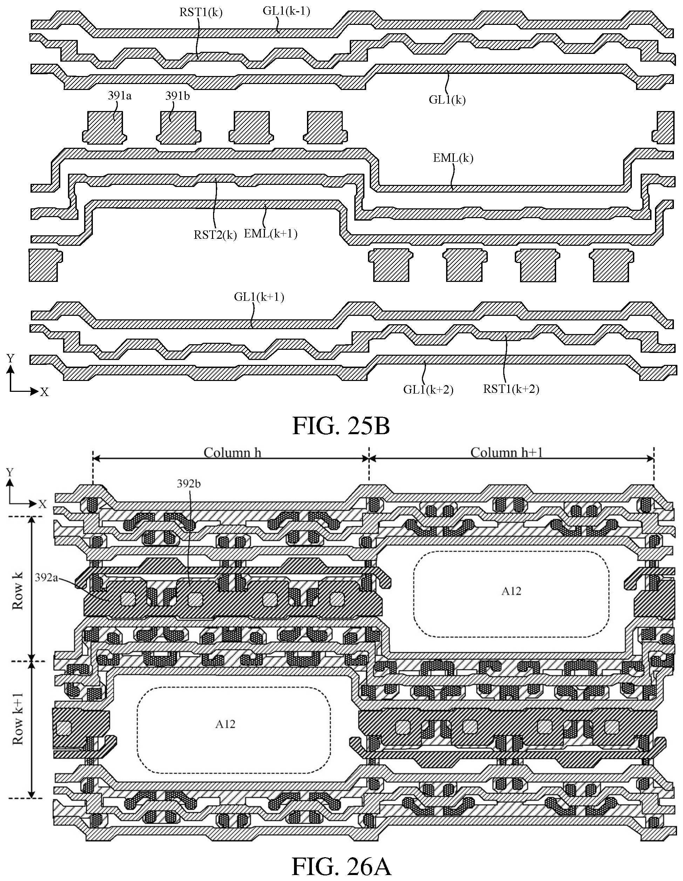

FIG. 25A is a schematic diagram of a first display region after a first conductive layer is formed in FIG. 22. FIG. 25B is a schematic diagram of the first conductive layer in FIG. 25A. In some examples, as shown in FIGS. 25A and 25B, the first conductive layer of the first display region may at least include a plurality of first scan lines (e.g., including first scan lines GL1(k-1), GL1(k), GL1(k+1), and GL1(k+2)), a plurality of light emitting control lines (e.g., including light emitting control lines EML(k) and EML(k+1)), a plurality of first reset control lines (e.g., including first reset control lines RST1(k) and RST1(k+2)), a plurality of second reset control lines (e.g., including second reset control lines RST2(k) and RST2(k+2)), and first electrodes of storage capacitors of a plurality of first pixel circuits (e.g., including first electrodes 391a and 391b)).

In some examples, the first scan line GL1(k), the first reset control line RST1(k), and the first scan line GL1(k-1) may be sequentially disposed in the second direction Y, and may be located on a side of first electrodes of storage capacitors of the first pixel circuits of display island regions in a k-th row in the second direction Y. The light emitting control line EML(k), the second reset control line RST2(k), and the light emitting control line EML(k+1) may be sequentially disposed in the second direction Y, and may be located on a side of the first electrodes of the storage capacitors of the first pixel circuits of the display island regions in the k-th row in the opposite direction of the second direction Y, and may be located on a side of first electrodes of storage capacitors of first pixel circuits of display island regions in a (k+1)-th row in the second direction Y.

In some examples, the first scan line GL1(k) may be located on a side of a light-transmitting region A12 in the k-th row in the second direction Y, and the light emitting control line EML(k) may be located on a side of the light-transmitting region A12 in the k-th row in the opposite direction of the second direction Y. The first scan line GL1(k) and the light emitting control line EML(k) may bypass the light-transmitting region A12 in the k-th row from the opposite sides of the light-transmitting region A12 in the second direction Y.

In some examples, the first pixel circuits within each display island region are arranged in a same row. First pixel circuits of display island regions in the k-th row (for example, first pixel circuits in an i-th row) and first pixel circuits of display island regions in the (k-1)-th row (for example, first pixel circuits in an (i-1)-th row) may share the first reset control line RST1(k). First pixel circuits of display island regions in the (k+1)-th row (for example, first pixel circuits in an (i+1)-th row) and the first pixel circuits of the display island regions in the k-th row (for example, the first pixel circuits in the i-th row) may share the second reset control line RST2(k). In this example, by making the pattern of the first pixel circuits of display island regions in even-numbered rows to be mirrored to the pattern of the first pixel circuits of display island regions in odd-numbered rows, the first pixel circuits of the display island regions in the even-numbered rows can share the first reset control line or the second reset control line with first pixel circuits of display island regions in adjacent odd-numbered rows, so as to save wiring space.

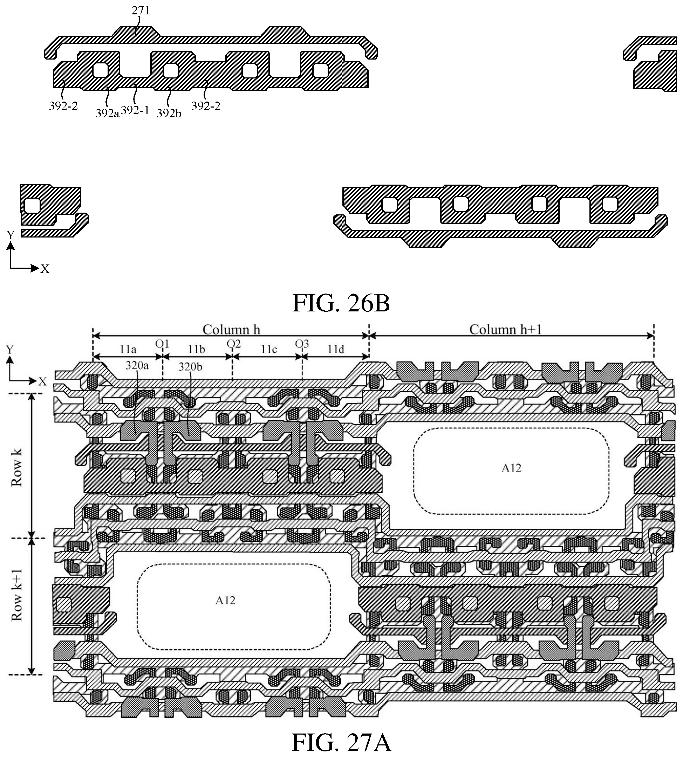

FIG. 26A is a schematic diagram of a first display region after a second conductive layer is formed in FIG. 22. FIG. 26B is a schematic diagram of the second conductive layer in FIG. 26A. In some examples, as shown in FIGS. 26A and 26B, the second conductive layer of the first display region may at least include second scan auxiliary transmission sections 271 of a plurality of second scan auxiliary lines, second electrodes of storage capacitors of a plurality of first pixel circuits (e.g., including second electrodes 392a and 392b). Second electrodes of storage capacitors of four first pixel circuits within a single island region may be interconnected into an integral structure. Within the display island region in the k-th row and h-th column, the second scan auxiliary transmission sections 271 may be located on a side of second electrodes of storage capacitors of first pixel circuits in the second direction Y; within the display island region in the (k+1)-th row and (h+1)-th column, the second scan auxiliary transmission sections 271 may be located on a side of second electrodes of storage capacitors of first pixel circuits in the opposite direction of the second direction Y.

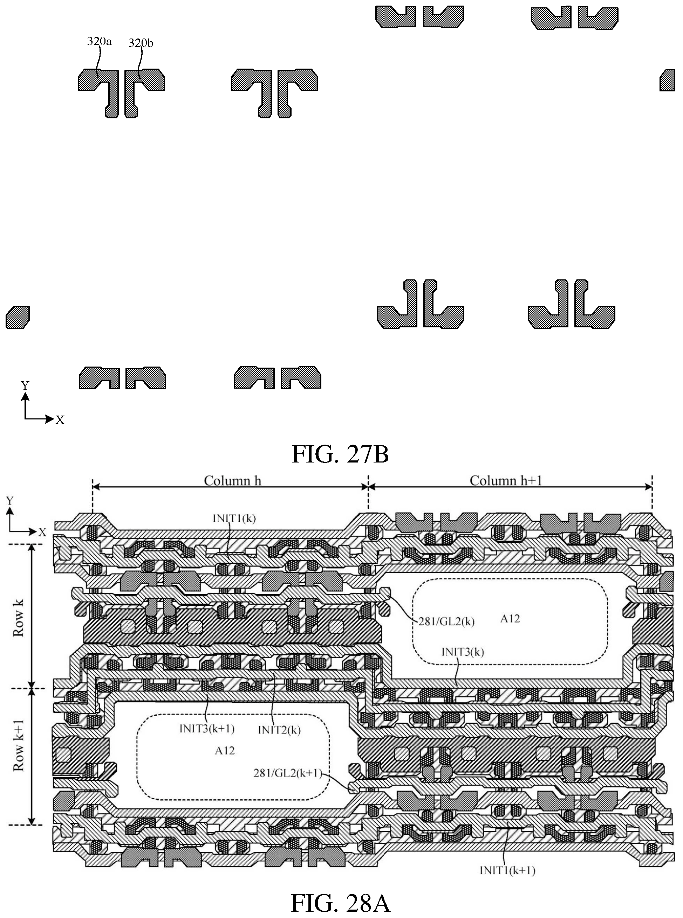

FIG. 27A is a schematic diagram of a first display region after a second semiconductor layer is formed in FIG. 22. FIG. 27B is a schematic diagram of the second semiconductor layer in FIG. 27A. In some examples, as shown in FIGS. 27A and 27B, the second semiconductor layer of the first display region may at least include active layers of second-type of transistors of a plurality of first pixel circuits. The pattern of the second semiconductor layer of the display island region in the k-th row and h-th column and the pattern of the second semiconductor layer of the display island region in the (k+1)-th row and (h+1)-th column may be centrally symmetrical about a connection point of the two display island regions.

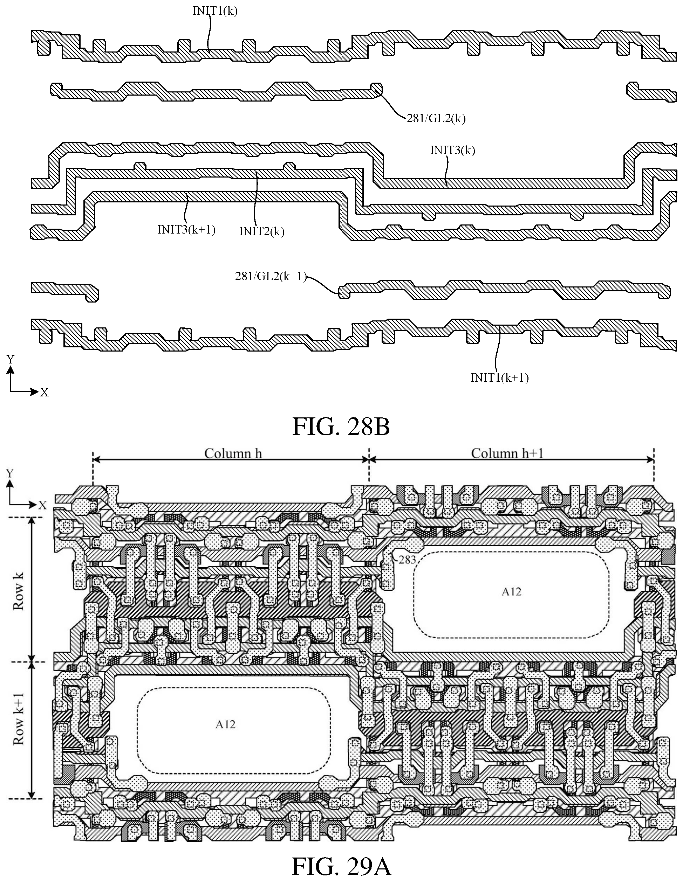

FIG. 28A is a schematic diagram of a first display region after a third conductive layer is formed in FIG. 22. FIG. 28B is a schematic diagram of the third conductive layer in FIG. 28A. In some examples, as shown in FIGS. 28A and 28B, the third conductive layer of the first display region may include at least a second scan transmission sections 281 of a plurality of second scan lines (for example, including second scan lines GL2(k), GL2(k+1)), a plurality of first initial signal lines (for example, including first initial signal lines INIT1(k), INIT1(k+1)), a plurality of second initial signal lines (for example, including second initial signal lines INIT2(k)), and a plurality of third initial signal lines (for example, including third initial signal lines INIT3(k), INIT3(k+1)).

In some examples, first pixel circuits within each display island region are arranged in a same row. The first pixel circuits within the display island regions in the k-th row (e.g., first pixel circuits in an i-th row) and the first pixel circuits within the display island regions in the (k-1)-th row (e.g., first pixel circuits in an (i-l)-th row) may share the first initial signal line INITI(k). The first pixel circuits within the display island regions in the (k+1)-th row (e.g., first pixel circuits in an (i+1)-th row) and the first pixel circuits within the display island regions in the k-th row (e.g., the first pixel circuits in the i-th row) may share the second initial signal line INIT2(k). The first pixel circuits within the display island regions in the (k+1)-th row (e.g., the first pixel circuits in the (i+1)-th row) and the first pixel circuits within display island regions in a (k+2)-th row (e.g., first pixel circuits in an (i+2)-th row) may share the first initial signal line INIT1(k+1). In this example, by making the pattern of the first pixel circuits of display island regions in even-numbered rows to be mirrored to the pattern of the first pixel circuits of display island regions in odd-numbered rows, the first pixel circuits within the display island regions in the even-numbered rows can share the first initial signal line or the second initial signal line with first pixel circuits within the display island regions in adjacent odd-numbered rows, so as to save wiring space.

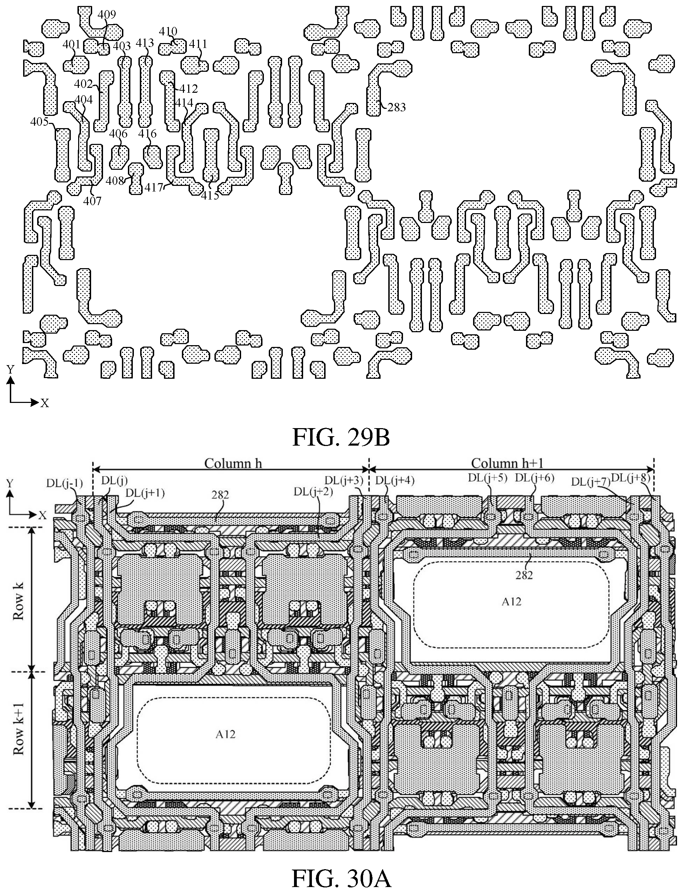

FIG. 29A is a schematic diagram of a first display region after a fourth conductive layer is formed in FIG. 22. FIG. 29B is a schematic diagram of the fourth conductive layer in FIG. 29A. In some examples, as shown in FIGS. 29A and 29B, the fourth conductive layer of the first display region may include at least a plurality of pixel connection electrodes (for example, including a first pixel connection electrode 401 to a seventeenth pixel connection electrode 417), and a plurality of wire transition electrodes (for example, including a first wire transition electrode 283). A shape of the first wire transition electrode 283 may be substantially L-shaped. The first wire transition electrode 283 may be connected with the second scan auxiliary transmission section 271 of the second scan auxiliary line GL2b(k) and the second scan transmission section 281 of the second scan line GL2(k). A pattern of the fourth conductive layer within the display island region in the k-th row and h-th column and a pattern of the fourth conductive layer within the display island region in the (k+1)-th row and (h+1)-th column may be centrally symmetrical about the connection point of the two display island regions.

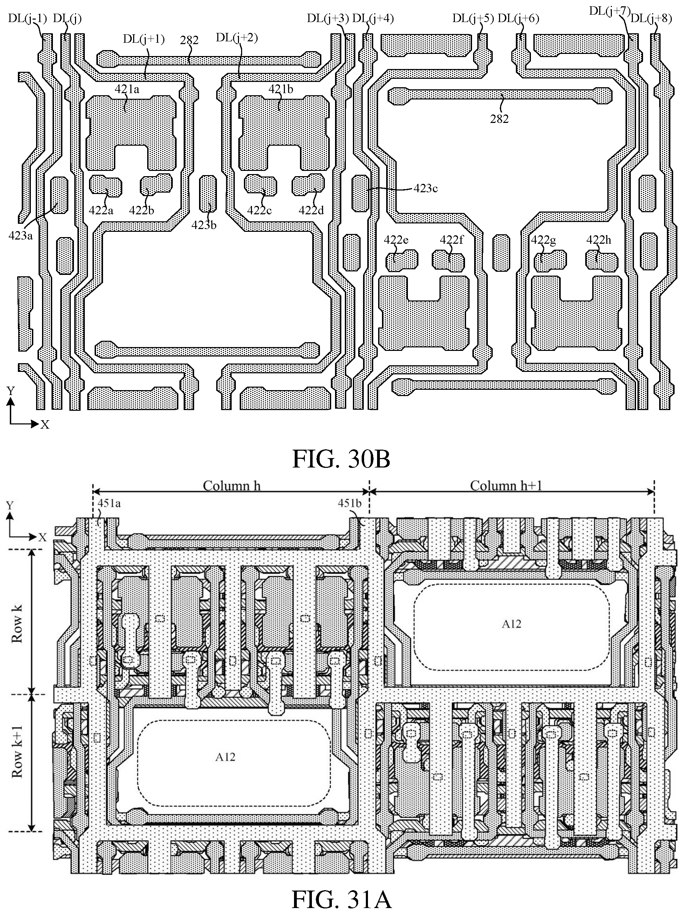

FIG. 30A is a schematic diagram of a first display region after a fifth conductive layer is formed in FIG. 22. FIG. 30B is a schematic diagram of the fifth conductive layer in FIG. 30A. In some examples, as shown in FIGS. 30A and 30B, the fifth conductive layer of the first display region may include at least: a plurality of data lines (e.g., including data lines DL(j-1), DL(j), DL(j+1), DL(j+2), DL(j+3), DL(j+4), DL(j+5), DL(j+6), DL(j+7), DL(j+8)), a plurality of first anode connection electrodes (e.g., first anode connection electrodes 422a, 422b, 422c, 422d, 422e, 422f, 422g, and 422h), a plurality of first power supply connection electrodes (e.g., first power supply connection electrodes 423a, 423b, and 423c), and a plurality of first shielding electrodes (e.g., first shielding electrodes 421a and 421b), and second scan connection sections 282 of a plurality of second scan lines. A pattern of the fifth conductive layer within the display island region in the k-th row and h-th column and a pattern of the fifth conductive layer within the display island region in the (k+1)-th row and (h+1)-th column may be centrally symmetrical about the connection point of the two display island regions. The first anode connection electrode 422e is connected with a first first pixel circuit within the display island region in the (k+1)-th row and (h+1)-th column, the first anode connection electrode 422f is connected with a second first pixel circuit within the display island region in the (k+1)-th row and (h+1)-th column, the first anode connection electrode 422g is connected with a third first pixel circuit within the display island region in the (k+1)-th row and (h+1)-th column, and the first anode connection electrode 422h is connected with a fourth first pixel circuit within the display island region in the (k+1)-th row and (h+1)-th column.

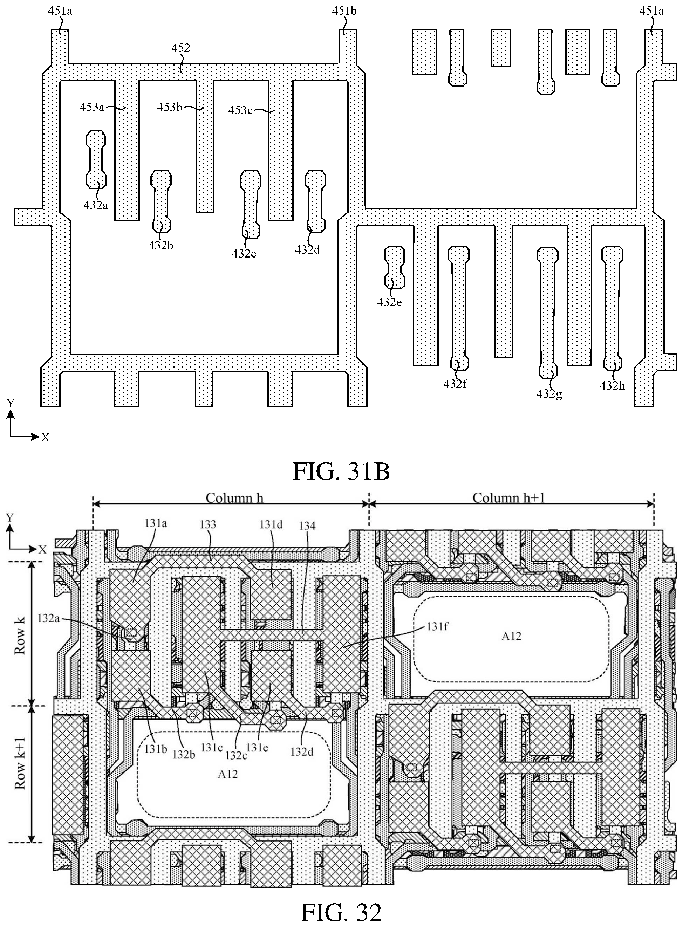

FIG. 31A is a schematic diagram of a first display region after a sixth conductive layer is formed in FIG. 22. FIG. 31B is a schematic diagram of the sixth conductive layer in FIG. 31A. In some examples, as shown in FIGS. 31A and 31B, the sixth conductive layer of the first display region may include at least a plurality of second anode connection electrodes (e.g., including second anode connection electrodes 432a, 432b, 432c, 432d, 432e, 432f, 432g, and 432h), a plurality of first voltage transmission lines (e.g., including first voltage transmission lines 451a and 451b), a plurality of power supply connection bars 452, and a plurality of second power supply connection electrodes (e.g., including second power supply connection electrodes 453a, 453b, and 453c). Shapes of the second anode connection electrodes 432e, 432f, 432g, and 432h may be substantially in a strip shape extending in the second direction Y. The second anode connection electrode 432e may be connected with the first anode connection electrode 422e, the second anode connection electrode 432f may be connected with the first anode connection electrode 422f, the second anode connection electrode 432g may be connected with the first anode connection electrode 422g, and the second anode connection electrode 432h may be connected with the first anode connection electrode 422h.

FIG. 32 is a schematic diagram of a first display region after an anode layer is formed in FIG. 22. In some examples, as shown in FIG. 32, the anode layer of the first display region may include at least anodes of a plurality of first light emitting elements (for example, including an anode 131a of the first light emitting element 13a, an anode 131b of the first light emitting element 13b, an anode 131c of the first light emitting element 13c, an anode 131d of the first light emitting element 13d, an anode 131e of the first light emitting element 13e, and an anode 131f of the first light emitting element 13f), a plurality of anode connection blocks (for example, including the anode connection blocks 132a, 132b, 132c, and 132d), a plurality of anode connection bars (for example, including a first anode connection bar 133 and a second anode connection bar 134). A pattern of the anode layer within the display island region in the k-th row and h-th column is substantially the same as a pattern of the anode layer within the display island region in the (k+1)-th row and (h+1) column. Anodes of two first light emitting elements emitting light of a first color within display island regions in the (k+1)-th row may be connected with a first first pixel circuit through the second anode connection electrode 432e and the first anode connection electrode 422e, an anode of a first light emitting element emitting light of a second color may be connected with a second first pixel circuit through the second anode connection electrode 432f and the first anode connection electrode 422f, anodes of two first light emitting elements emitting light of a third color may be connected with a third first pixel circuit through the second anode connection electrode 432g and the first anode connection electrode 422g, an anode of the other first light emitting element emitting light of the second color may be connected with a fourth first pixel circuit through the second anode connection electrode 432h and the first anode connection electrode 422h. The patterning of the anode layer in this example is similar to the patterning of the anode layer in the foregoing embodiments, and therefore the description thereof will not be repeated here.

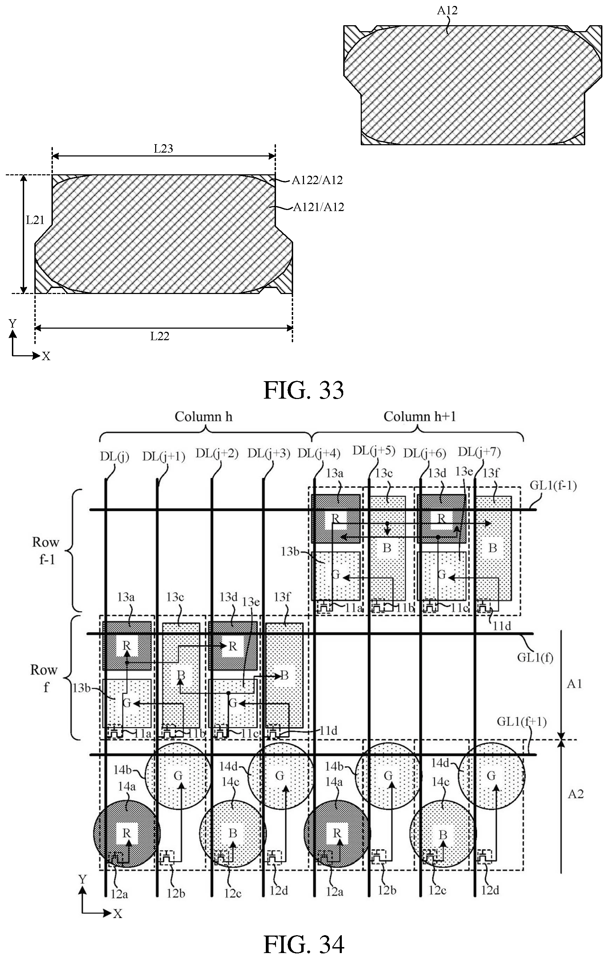

FIG. 33 is a schematic diagram of a light-transmitting region in FIG. 22. In some examples, a light-transmitting region A12 in the k-th row and (h+1)-th column and a light-transmitting region A12 in the (k+1)-th row and h-th column may be centrally symmetrical about a connection point of the display island region in the k-th row and h-th column and the display island region in the (k+1)-th row and (h+1)-th column. The light-transmitting region A12 may be in a substantially elliptical shape as a whole, for example, the light-transmitting region A12 in the (k+1)-th row and h-th column may be in a shape that is narrow at the top and wide at the bottom. A light-transmitting region A12 may include a first area A121 and a second area A122. Orthographic projections of the first region A121 and the second area A122 on the base substrate may not overlap. The first area A121 may be in an irregular shape, and the second area A122 may be located at an edge position of the first area A121. The cathode layer within the first area A121 may be removed, and the cathode layer within the second area A122 may be retained.

In some examples, as shown in FIG. 33, a maximum length L21 of the light-transmitting region A12 in the second direction Y may be 34 microns to 42 microns, such as may be about 38 microns. A maximum length L22 of the first area A121 of the light-transmitting region A12 in the first direction X may be 75 microns to 95 microns, such as about 85 microns; a minimum length L23 of a side edge of the first area A121 extending in the second direction Y may be 65 micrometers to 81 micrometers in the first direction X, such as about 73 micrometers.

Compared with the foregoing embodiments, the display substrate of the present example making the first pixel circuits within display island regions in even-numbered rows (or odd-numbered rows) to be mirrored to the first pixel circuits of display island regions in odd-numbered rows (or even-numbered rows), so that first pixel circuits of adjacent rows and adjacent columns can be centrally symmetrical, and first pixel circuits of adjacent rows can share the first reset control line and the first initial signal line, or can share the second reset control line and the second initial signal line, thereby it is beneficial to saving wiring space within the display island regions, increasing the areas of the light-transmitting regions, and improving the light transmittance of the first display region. Remaining description of the display substrate in this embodiment may be referred to the description in the aforementioned embodiments, which is not repeated here.

FIG. 34 is another schematic diagram of a signal correspondence between a first display region and a second display region according to at least one embodiment of the present disclosure. FIG. 5 is illustrated by taking a first display unit of a display island region in an f-th row and h-th column and a first display unit of the display island region in an (f-1)-th row and (h+1)-th column in the first display region A1 as examples, where f is an integer.

In some examples, as shown in FIG. 34, four first pixel circuits 11a, 11b, 11c, and 11d within the display island region in the f-th row and h-th column may be sequentially arranged in the first direction X. The first pixel circuit 11a may be connected with two first light emitting elements 13a and 13d that emit light of the first color, the first pixel circuit 11b may be connected with one first light emitting element 13b that emits light of the second color, the first pixel circuit 11c may be connected with two first light emitting elements 13c and 13f that emit light of the third color, and the first pixel circuit 11d may be connected with another first light emitting element 13e that emits light of the second color.

In some examples, as shown in FIG. 34, four first pixel circuits 11a, 11b, 11c, and 11d within a display island region in an f-th row and (h+1)-th column may be sequentially arranged in the first direction X. The first pixel circuit 11a may be connected with two first light emitting elements 13c and 13f that emit light of the third color, the first pixel circuit 11b may be connected with one first light emitting element 13b that emits light of the second color, the first pixel circuit 11c may be connected with two first light emitting elements 13a and 13d that emit light of the first color, and the first pixel circuit 11d may be connected with another first light emitting element 13e that emits light of the second color.

In this example, connection orders of the first pixel circuits and the first light emitting elements within display island regions in two adjacent rows are different. For example, within display island regions in the f-th row, a first first pixel circuit is connected with two first light emitting elements that emit light of the first color, a third first pixel circuit is connected with two first light emitting elements that emit light of the third color, and four first pixel circuits correspond to RGBG in turn; within display island regions in the (f-1)-th row, a first first pixel circuit is connected with two first light emitting elements that emit light of the third color, a third first pixel circuit is connected with two first light emitting elements that emit light of the first color, and four first pixel circuits correspond to BGRG in turn.

In this example, by disposing that connection orders of the first pixel circuits and the first light emitting elements within display island regions in adjacent rows are different, it is beneficial to improving the display uniformity of the first display region and improving the display effect of the first display region. Remaining description of the display substrate in this example may be referred to the description in the aforementioned embodiments, which is not repeated here.

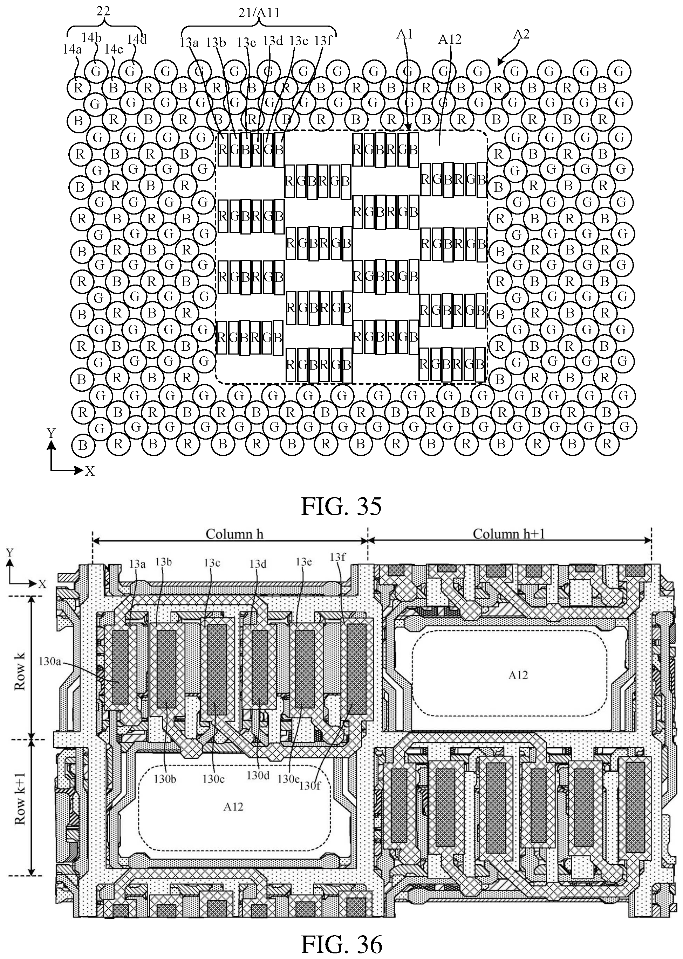

FIG. 35 is another partial schematic diagram of a display region according to at least one embodiment of the present disclosure. FIG. 35 schematically illustrates an arrangement of a plurality of first light emitting elements in a first display region A1 and a plurality of second light emitting elements in a second display region A2. FIG. 35 is illustrated by taking an eight-row and four-column display island region of the first display region A1 as an example. A quantity of display island regions of the first display region is not limited in this example.

In some examples, as shown in FIG. 35, the first display region A1 may include: a plurality of display island regions A11 and a plurality of light-transmitting regions A12 arranged in an array. The display island region A11 may include one first display unit 21, and the first display unit 21 may include six first light emitting elements and four first pixel circuits. The six first light emitting elements may include two first light emitting elements 13a and 13d that emit light of a first color, two first light emitting elements 13b and 13e that emit light of a second color, and two first light emitting elements 13c and 13f that emit light of a third color. For example, the first color light may be red light, the second color light may be green light, and the third color light may be blue light.

In some examples, the six first light emitting elements of the first display unit 21 may be divided into two groups of first light emitting elements, and each group of first light emitting elements may include three first light emitting elements that emit light of different colors. For example, a first group of first light emitting elements may include: three first light emitting elements 13a, 13b, and 13c; a second group of first light emitting elements may include three first light emitting elements 13d, 13e, and 13f. The first group of first light emitting elements and the second group of first light emitting elements may be sequentially arranged in the first direction X. In the first group of first light emitting elements, the first light emitting elements 13a, 13b, and 13c may be sequentially arranged in the first direction X. In the second group of first light emitting elements, the first light emitting elements 13d, 13e, and 13f may be sequentially arranged in the first direction X. In the present example, three first light emitting elements emitting light of different colors in each group of first light emitting elements of the first display unit 21 may be arranged in a Real RGB manner. As to the arrangement of the plurality of second light emitting elements in the second display region A2, the description of the above-described embodiments can be referred to, and thus the description thereof is repeated here.

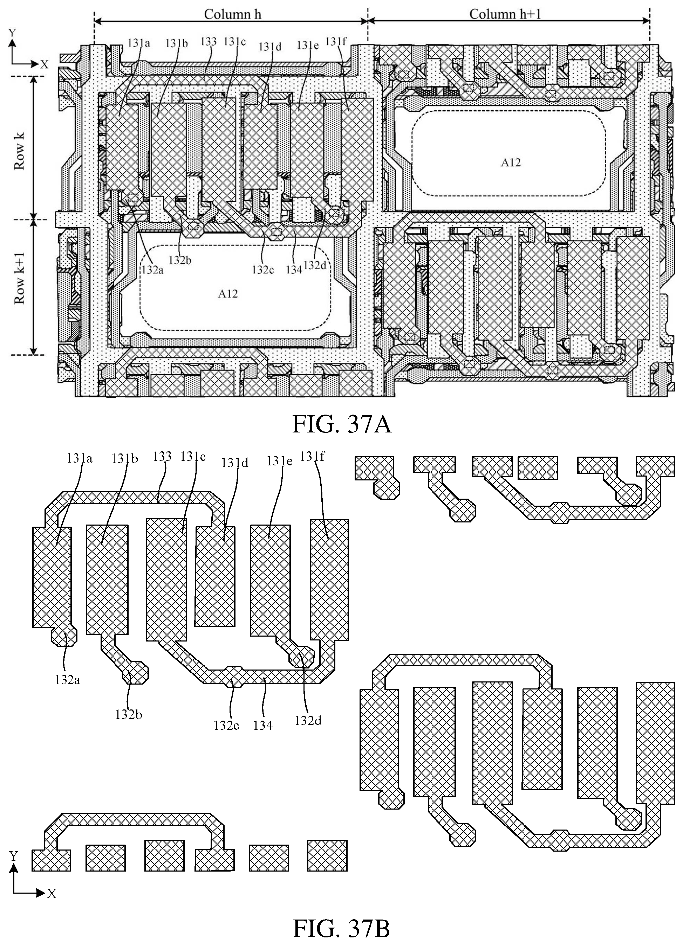

FIG. 36 is a partial top view of a first display region according to at least one embodiment of the present disclosure. FIG. 37A is a schematic diagram of a first display region after an anode layer is formed in FIG. 36. FIG. 37B is a schematic diagram of the anode layer in FIG. 37A. A partial top view of display island regions of two rows (e.g., a k-th row and a (k+1)-th row) and two columns (e.g., a h-th column and a (h+1)-th column) is illustrated in FIG. 36. The circuit structure layer of the first display region of the present example may have a structure similar to that of the embodiment shown in FIG. 22, and therefore, the description thereof will not be repeated here. In other examples, the circuit structure layer of the first display region of the present example may have the structure of the embodiment shown in FIG. 6. The present embodiment is not limited thereto.

In some examples, as shown in FIGS. 36 to 37B, the anode layer of the first display region may include at least anodes of a plurality of first light emitting elements (for example, including an anode 131a of a first light emitting element 13a, an anode 131b of a first light emitting element 13b, an anode 131c of a first light emitting element 13c, an anode 131d of a first light emitting element 13d, an anode 131e of a first light emitting element 13e, an anode 131f of a first light emitting element 13f), a plurality of anode connection blocks (for example, including anode connection blocks 132a, 132b, 132c, and 132d), and a plurality of anode connection bars (for example, including a first anode connection bar 133 and a second anode connection bar 134).

In some examples, the anodes 131a, 131b, 131c, 131d, 131e, and 131f may be substantially rectangular in shape. The anodes 131a, 131b, 131c, 131d, 131e, and 131f may be sequentially arranged in the first direction X.

In some examples, the anode connection block 132a may be substantially hexagonal in shape. The anode 131a and the anode connection block132a may be interconnected into an integral structure. The anode connection block 132a may be connected with a first first pixel circuit. A shape of the anode connection block 132b may be substantially an oblique line shape. The anode 131b and the anode connection block 132b may be interconnected into an integral structure. The anode connection block 132b may be connected with a second first pixel circuit. The anode connection block 132c may be substantially V-shaped. The anode 131c and the anode connection block 132c may be interconnected into an integral structure. The anode connection block 132c may be connected with a third first pixel circuit. A shape of the anode connection block 132d may be substantially an oblique line shape. The anode 131e and the anode connection block 132d may be interconnected into an integral structure. The anode connection block 132d may be connected with a fourth first pixel circuit.

In some examples, a shape of the first anode connection bar 133 may be substantially a bend line shape extending in the first direction X. Both ends of the first anode connection bar 133 may be connected with the anodes 131a and 131d, respectively. The first anode connection bar 133 may be located on a side of the anodes 131b and 131c in the second direction Y. The first anode connection bar 133, the anodes 131a and 131d, and the anode connection block 132a may be interconnected into an integral structure.

In some examples, a shape of the second anode connection bar134 may be substantially a bend line shape extending in the first direction X. Both ends of the second anode connection bar 134 may be connected with the anode 131f and the anode connection block 132c, respectively. The second anode connection bar 134 may be located on a side of the anodes 131d and 131e in the opposite direction of the second direction Y. The second anode connection bar 134, the anodes 131c and 131f, and the anode connection block 132c may be interconnected into an integral structure.

In the display substrate of the present example, the display effect of the first display region can be optimized by disposing the first light emitting elements in the display island regions to be in a Real RGB arrangement mode.

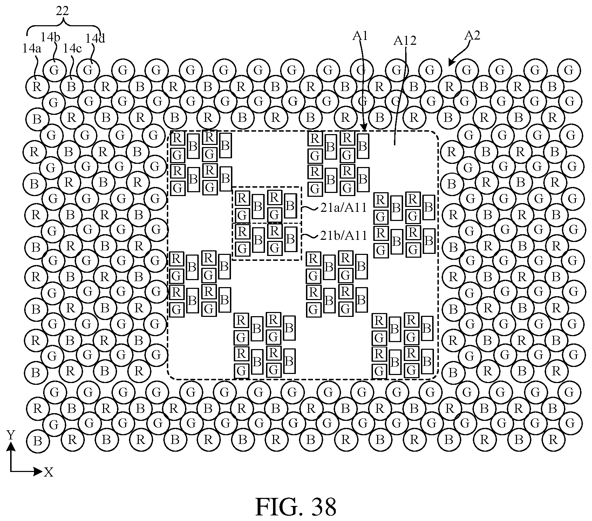

FIG. 38 is another partial schematic diagram of a display region according to at least one embodiment of the present disclosure. FIG. 38 schematically illustrates an arrangement of a plurality of first light emitting elements in the first display region A1 and a plurality of second light emitting elements in the second display region A2. FIG. 38 is illustrated by taking display island regions of four-row and four-column in the first display region A1 as an example. A quantity of display island regions in the first display region is not limited in this example.

In some examples, as shown in FIG. 38, the first display region A1 may include: a plurality of display island regions A11 and a plurality of light-transmitting regions A12 arranged in an array. The plurality of display island regions A11 and the plurality of light-transmitting regions A12 may be arranged at intervals in the first direction X and the second direction Y. A display island region A11 may include two first display units 21a and 21b. The two first display units 21a and 21b may be sequentially arranged in the second direction Y. Each first display unit may include six first light emitting elements and four first pixel circuits. The display island regions of the present example may be substantially square island-shaped. As to the arrangement of the first light emitting elements and the first pixel circuits in each first display unit, the description of the above-described embodiments can be referred to, and thus the description thereof will not be repeated herein. In other examples, each display island region may be provided with three or more first display units sequentially arranged in the second direction Y.

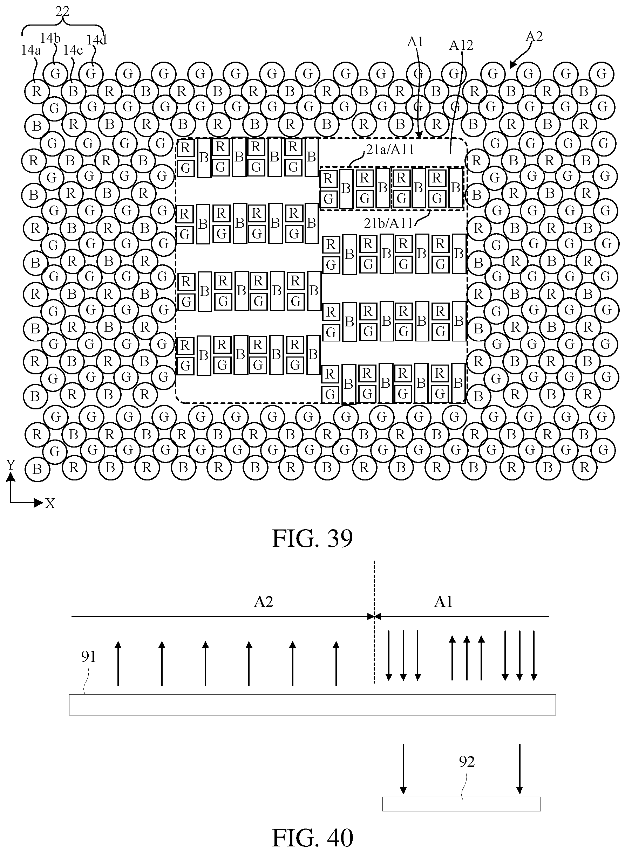

FIG. 39 is another partial schematic diagram of a display area according to at least one embodiment of the present disclosure. FIG. 39 schematically illustrates an arrangement of a plurality of first light emitting elements in a first display region A1 and a plurality of second light emitting elements in a second display region A2. FIG. 39 is illustrated by taking display island region of four-row and four-column in the first display region A1 as an example. A quantity of display island regions in the first display region is not limited in this example.

In some examples, as shown in FIG. 39, the first display region A1 may include: a plurality of display island regions A11 and a plurality of light-transmitting regions A12 arranged in an array. The plurality of display island regions A11 and the plurality of light-transmitting regions A12 may be arranged at intervals in the first direction X and the second direction Y. The display island region A11 may include two first display units 21a and 21b. The two first display units 21a and 21b may be sequentially arranged in the first direction X. Each first display unit may include six first light emitting elements and four first pixel circuits. The display island regions of the present example may be substantially rectangular island-shaped. As to the arrangement of the first light emitting elements and the first pixel circuits in each first display unit, the description of the above-described embodiments can be referred to, and thus the description thereof will not be repeated herein. In other examples, each display island region may be provided with three or more first display units sequentially arranged in the first direction X.

In other examples, at least one first pixel circuit within at least one first display unit may be connected with three or four first light emitting elements to drive the three or four first light emitting elements to emit light. In other examples, two groups of first light emitting elements in the at least one first display unit may be arranged in different ways, for example, one group of first light emitting elements is arranged in Pentile RGB, and the other group of first light emitting elements is arranged in Real RGB. In other examples, the first light emitting elements in the at least one first display unit may be arranged in Pentile RGB, and the first light emitting elements in the at least one first display unit may be arranged in Real RGB. The present embodiment is not limited thereto.

An embodiment of the present disclosure provides a display substrate including a base substrate. The base substrate includes a first display region and a second display region located on at least one side of the first display region. The first display region includes a plurality of display island regions and a plurality of light-transmitting regions arranged in an array. A display island region includes: at least one group of first pixel circuits and a plurality of first light emitting elements, each group of first pixel circuits including M first pixel circuits, and at least one of the M first pixel circuits being connected with at least two first light emitting elements; M is an integer greater than 1. The second display region includes a plurality of groups of second pixel circuits and a plurality of second light emitting elements, each group of second pixel circuits including M second pixel circuits, and at least one second pixel circuit is connected with at least one second light emitting element. A quantity of first light emitting elements to which each group of first pixel circuits are connected is greater than a quantity of second light emitting elements to which each group of second pixel circuits are connected; an arrangement density of the second pixel circuits in the second display region is greater than or equal to an arrangement density of the first pixel circuits in the first display region. The first pixel circuits and the second pixel circuits located in a same column are connected with a same data line.

The display substrate provided in this embodiment adopts a pixel circuit built-in method to reduce the first pixel circuits and the first light emitting elements in the first display region to form the light-transmitting regions, and a driving relationship of the first pixel circuits to the first light emitting elements is disposed different from a driving relationship of the second pixel circuits to the second light emitting elements, which can ensure the display effect of the first display region on the basis of improving the light transmittance of the first display region, and make up for the loss of display effect caused by reducing some light emitting elements and pixel circuits in the first display region.

In some exemplary embodiments, each group of first pixel circuits includes four first pixel circuits connected with six first light emitting elements including two first light emitting elements that emit light of a first color, two first light emitting elements that emit light of a second color, and two first light emitting elements that emit light of a third color. Each group of second pixel circuits includes four second pixel circuits connected with four second light emitting elements including one second light emitting element that emits light of the first color, two second light emitting elements that emit light of the second color, and one second light emitting element that emits light of the third color.

In some exemplary embodiments, an arrangement of the six first light emitting elements is different from an arrangement of the four second light emitting elements.

In some exemplary embodiments, an arrangement density of the first pixel circuits in the first display region in the first direction is 0.4 to 0.6 times, such as 0.45 to 0.55 times, e.g. about 0.5 times, that of the second pixel circuits in the second display region in the first direction; an arrangement density of the first pixel circuits in the first display region in the second direction is 0.4 to 0.6 times, such as 0.45 to 0.55 times, e.g. about 0.5 times, that of the second pixel circuits in the second display region in the second direction.

Relevant description of the display substrate of the present embodiment may refer to the descriptions in the aforementioned embodiments, and thus will not be repeated here.

FIG. 40 is a schematic diagram of a display apparatus according to at least one embodiment of the present disclosure. As shown in FIG. 40, a display apparatus is provided in an embodiment, which includes a display substrate 91 and a sensor 92 located on a light exit side of a light emitting structure layer away from the display substrate 91. The sensor 92 may be located on a side of a non-display surface of the display substrate 91. An orthographic projection of the sensor 92 on the display substrate 91 may be at least partially overlapped with a first display region A1. For example, the orthographic projection of the sensor 92 on the display substrate 91 may be located within a range of the first display region A1.

In some examples, the display substrate 91 may be a flexible OLED display substrate, a OLED display substrate, a Micro-LED display substrate, or a Mini-LED display substrate. The display apparatus may be a product having an image (including a still image or a moving image, where the moving image may be a video) display function. For example, the display apparatus may be any one of a display, a television, a billboard, a digital photo frame, a laser printer with display function, a telephone, a mobile phone, a picture screen, a personal digital assistant (PDA), a digital camera, a portable camcorder, a viewfinder, a navigator, a vehicle, a large-area wall, an information inquiry equipment (such as business inquiry equipment in e-government, banks, hospitals, power departments), a monitor, or the like. As another example, the display apparatus may be any one of a micro-display, a VR device or an AR device including a micro-display.

In description of the specification, reference terms such as "an embodiment," "some embodiments," "an example," or "some examples," mean that a feature, structure, material, or characteristic described in connection with the embodiment or example is included in at least one embodiment or example of the present application. In the specification, schematic expressions of the above terms do not necessarily refer to a same embodiment or example. Moreover, described features, structures, materials, or characteristics may be combined in any one or more embodiments or examples in a suitable manner. In addition, if there is no conflict, those skilled in the art may integrate and combine different embodiments or examples and features of different embodiments or examples described in the specification.

Although embodiments of the present application have been shown and described above, it may be understood that the above embodiments are exemplary, but cannot be understood as limitations on the present application. Alterations, modifications, substitutions, and variations to the above embodiments may be made by those skilled in the art within the scope of the present application.

## Claims

1.  A display substrate, comprising:
    a base substrate, comprising: a first display region and a second display region located at at least one side of the first display region, wherein:

    the first display region comprises a plurality of display island regions and a plurality of light-transmitting regions arranged in an array;
    a display island region comprises at least one first display unit; the at least one first display unit comprises: N first light emitting elements and M first pixel circuits, where M and N are both integers greater than 1, and M is less than N; at least one first pixel circuit of the M first pixel circuits is connected with at least two first light emitting elements and configured to drive the at least two first light emitting elements to emit light;
    the second display region comprises a plurality of second display units arranged in an array; at least one second display unit of the plurality of second display units comprises: M second light emitting elements and M second pixel circuits connected with the M second light emitting elements in one-to-one correspondence; and
    an arrangement of the N first light emitting elements of the at least one first display unit is different from an arrangement of the M second light emitting elements of the at least one second display unit.

2.  The display substrate according to claim **1,** wherein in the first display region, the display island regions and the light-transmitting regions are alternately disposed and arranged in alignment in a first direction, and the display island regions and the light-transmitting regions are alternately disposed and arranged in alignment in a second direction, wherein the first direction is intersected with the second direction.

3.  The display substrate according to claim **1,** wherein the M first pixel circuits of the at least one first display unit and the M second pixel circuits of the at least one second display unit are arranged in alignment in a first direction or a second direction, wherein the first direction is intersected with the second direction.

4.  The display substrate according to claim 1, wherein:

    the at least one first display unit comprises: six first light emitting elements and four first pixel circuits, wherein the four first pixel circuits are sequentially arranged in a first direction;
    the six first light emitting elements comprise: two first light emitting elements emitting light of a first color, two first light emitting elements emitting light of a second color, and two first light emitting elements emitting light of a third color; and
    the two first light emitting elements emitting light of the first color are electrically connected with a same first pixel circuit; the two first light emitting elements emitting light of the third color is electrically connected with a same first pixel circuit; and the two first light emitting elements emitting light of the second color are connected with two first pixel circuits in one-to-one correspondence.

5. The display substrate according to claim 4, wherein:

the six first light emitting elements are divided into two groups of first light emitting elements arranged sequentially in the first direction, each group of first light emitting elements comprises: one first light emitting element emitting light of the first color, one first light emitting element emitting light of the second color, and one first light emitting element emitting light of the third color; and
in each group of first light emitting elements, the first light emitting element emitting light of the first color and the first light emitting element emitting light of the second color are sequentially arranged in a second direction, and the first light emitting element emitting light of the third color is located on a same side of the first light emitting element emitting light of the first color and the first light emitting element emitting light of the second color in the first direction, wherein the second direction is intersected with the first direction.

6. The display substrate according to claim 4, wherein:

the six first light emitting elements are divided into two groups of first light emitting elements arranged sequentially in the first direction, each group of first light emitting elements comprises: one first light emitting element emitting light of the first color, one first light emitting element emitting light of the second color, and one first light emitting element emitting light of the third color; and
in each group of first light emitting elements, the first light emitting element emitting light of the first color, the first light emitting element emitting light of the second color, and the first light emitting element emitting light of the third color are sequentially arranged in the first direction.

7. The display substrate according to claim 4, wherein in the first display region, connection orders of first pixel circuits with the first light emitting elements in first display units within display island regions in adjacent rows are different.

8. The display substrate according to claim 7, wherein:

in the first display region, four first pixel circuits located in a display island region in an f-th row can be sequentially connected with two first light emitting elements emitting light of the first color, one first light emitting element emitting light of the second color, two first light emitting elements emitting light of the third color, and another first light emitting element emitting light of the second color; and
four first pixel circuits located in the first display unit within a display island region in an (f-1)-th row can be sequentially connected with two first light emitting elements emitting light of the third color, one first light emitting element emitting light of the second color, two first light emitting elements emitting light of the first color, and another first light emitting element emitting light of the second color, wherein f is an integer greater than 1.

9. The display substrate according to any one of claims 4 to 8, wherein:

the at least one second display unit comprises: four second light emitting elements and four second pixel circuits;
the four second pixel circuits are sequentially arranged in the first direction; and
the four second light emitting elements comprise one second light emitting element emitting light of the first color, two second light emitting elements emitting light of the second color, and one second light emitting element emitting light of the third color; the second light emitting element emitting light of the first color, one of the two second light emitting elements emitting light of the second color, the second light emitting element emitting light of the third color, and another of the two second light emitting elements emitting light of the second color are sequentially arranged in the first direction; the second light emitting element emitting light of the first color and the second light emitting element emitting light of the third color are arranged in a same row, and the two second light emitting elements emitting light of the second color are arranged in a same row.

10. The display substrate according to any one of claims 4 to 9, wherein the light of the first color is red light, the light of the second color is green light, and the light of the third color is blue light.

11. The display substrate according to any one of claims 1 to 10, wherein:

the M first pixel circuits of the first display unit within the display island region are connected with a first scan transmission section and a second scan transmission section extending in a first direction; the first scan transmission section is configured to transmit a first scan signal, and the second scan transmission section is configured to transmit a second scan signal;

first scan transmission sections located within adjacent display island regions in a same row are connected through first scan connection sections; second scan transmission sections located within adjacent display island regions in a same row are connected through second scan connection sections; and

the second scan connection sections are located on a side of the first scan connection sections away from the base substrate, and orthographic projections of the first scan connection sections on the base substrate are at least partially overlapped with orthographic projections of the second scan connection sections on the base substrate.

12. The display substrate according to claim **11,** wherein:

first pixel circuits of first display units located within display island regions in a same row are connected with first reset control lines and first initial signal lines extending in the first direction, the first initial signal lines are located on a side of the first reset control lines away from the base substrate; the first scan connection sections are located on a side of the first initial signal lines away from the base substrate; and

the orthographic projections of the first scan connection sections on the base substrate are at least partially overlapped with orthographic projections of the first initial signal lines on the base substrate; the orthographic projections of the first initial signal lines on the base substrate are at least partially overlapped with orthographic projections of the first reset control lines on the base substrate.

13. The display substrate according to claim **11,** wherein:

the M first pixel circuits of the first display unit within the display island region are connected with a light emitting control transmission section extending in the first direction; the light emitting control transmission section is configured to transmit a light emitting control signal; light emitting control transmission sections located within adjacent display island regions in a same row are connected through light emitting control connection sections; and

the light emitting control connection sections and the first scan connection sections are located at both sides of light-transmitting regions between adjacent display island regions in a second direction, and the second direction is intersected with the first direction.

14. The display substrate according to claim 13, wherein:

first pixel circuits of first display units located within the display island regions in the same row are connected with second reset control lines and second initial signal lines extending in the first direction, the second initial signal lines are located on a side of the second reset control lines away from the base substrate; the light emitting control connection sections are located on a side of the second initial signal lines away from the base substrate; and orthographic projections of the light emitting control connection sections on the base substrate are at least partially overlapped with orthographic projections of the second initial signal lines on the base substrate; the orthographic projections of the second initial signal lines on the base substrate are at least partially overlapped with orthographic projections of the second reset control lines on the base substrate.

15. The display substrate according to claim 13, wherein:

the M first pixel circuits of the first display unit within the display island region are connected with an initial signal transmission section extending in the first direction; the initial signal transmission section is configured to transmit a third initial signal;

initial signal transmission sections located within adjacent display island regions in a same row are connected through initial signal connection sections; and

the light emitting control connection sections are located at a side of the initial signal connection sections away from the base substrate; orthographic projections of the initial signal connection sections on the base substrate are partially overlapped with orthographic projections of the light emitting control connection sections on the base substrate.

16. The display substrate according to any one of claims 1 to 10, wherein a plurality of first pixel circuits located within the display island region in a k-th row and h-th column and a plurality of first pixel circuits located within the display island region in a (k+1)-th row and (h+1)-th column are centrally symmetrical about a connection point of the display island region in the k-th row and h-th column and the display island region in the (k+1)-th row and (h+1)-th column, wherein k and h are both integers greater than 0.

17. The display substrate according to claim 16, wherein in the first display region, the first pixel circuits located in an i-th row within display island regions in the k-th row and the first pixel circuits located in an (i-1)-th row within display island regions in a (k-1)-th row share a first reset control line, and the first pixel circuits located in an (i+e)-th row within display island regions in the k-th row and first pixel circuits located in an (i+e+1)-th row within display island regions in the (k+1)-th row share a second reset control line, wherein i is an integer greater than **1,** and e is an integer greater than or equal to 0.

18. The display substrate according to claim 17, wherein in the first display region, the first pixel circuits located in the i-th row within the display island regions in the k-th row and the first pixel circuits located in the (i-1)-th row within the display island regions in the (k-1)-th row share a first initial signal line, and the first pixel circuits located in the (i+e)-th row within the display island regions in the k-th row and the first pixel circuits located in the (i+e+1)-th row within the display island regions in the (k+1)-th row share a second initial signal line.

19. The display substrate according to any one of claims 1 to 18, wherein the display island region comprises two first display units arranged in a first direction or arranged in a second direction, wherein the first direction is intersected with the second direction.

20. A display apparatus, comprising the display substrate according to any one of claims 1 to 19, and a sensor located on a non-display side of the display substrate, wherein an orthographic projection of the sensor on the display substrate is at least partially overlapped with the first display region of the display substrate.

21. A display substrate, comprising:
a base substrate, comprising: a first display region and a second display region located at at least one side of the first display region, wherein:

the first display region comprises a plurality of display island regions and a plurality of light-transmitting regions arranged in an array;
a display island region comprises: at least one group of first pixel circuits and a plurality of first light emitting elements, each group of first pixel circuits comprises M first pixel circuits, at least one first pixel circuit of the M first pixel circuits is connected with at least two first light emitting elements; and M is an integer greater than 1;
the second display region comprises: a plurality of groups of second pixel circuits and a plurality of second light emitting elements, each group of second pixel circuits comprises M second pixel circuits, and at least one second pixel circuit is connected with at least one second light emitting element;
a quantity of first light emitting elements to which each group of first pixel circuits is connected is greater than a quantity of second light emitting elements to which each group of second pixel circuits is connected; an arrangement density of the second pixel circuits in the second display region is greater than or equal to an arrangement density of the first pixel circuits in the first display region; and
first pixel circuits and second pixel circuits located in a same column are connected with a same data line.

22. The display substrate according to claim 21, wherein:

each group of first pixel circuits comprises four first pixel circuits connected with six first light emitting elements, wherein the six first light emitting elements comprise: two first light emitting elements emitting light of a first color, two first light emitting elements emitting light of a second color, and two first light emitting elements emitting light of a third color;
each group of second pixel circuits comprises four second pixel circuits connected with four second light emitting elements, wherein the four second light emitting elements comprise one second light emitting element emitting light of the first color, two second light emitting elements emitting light of the second color, and one second light emitting element emitting light of the third color.

23. The display substrate according to claim 22, wherein an arrangement of the six first light emitting elements is different from an arrangement of the four second light emitting elements.

24. The display substrate according to claim 21, wherein an arrangement density of the first pixel circuits in the first display region in a first direction is 0.4 to 0.6 times an arrangement density of the second pixel circuits in the second display region in the first direction; an arrangement density of the first pixel circuits in the first display region in a second direction is 0.4 to 0.6 times an arrangement density of the second pixel circuits in the second display region in the second direction; and the first direction is intersected with the second direction.

FIG. 1

FIG. 2

FIG. 3

FIG. 4

FIG. 5

FIG. 6

FIG. 7

FIG. 8A

FIG. 8B

FIG. 9A

FIG. 9B

FIG. 9C

FIG. 10A

FIG. 10B

FIG. 11A

FIG. 11B

FIG. 12A

FIG. 12B

FIG. 13

FIG. 14A

FIG. 14B

FIG. 15

FIG. 16A

FIG. 16B

FIG. 17

FIG. 18A

FIG. 18B

FIG. 19

EP 4 761 538 A1

FIG. 20A

FIG. 20B

57

FIG. 21

FIG. 22

FIG. 23

FIG. 24A

FIG. 24B

FIG. 25A

FIG. 25B

FIG. 26A

FIG. 26B

FIG. 27A

FIG. 27B

FIG. 28A

INIT1(k)

281/GL2(k)

INIT3(k)

INIT3(k+1)    INIT2(k)

281/GL2(k+1)

INIT1(k+1)

Y
X

## FIG. 28B

Column h    Column h+1

Y
X

Row k

Row k+1

283

A12

A12

## FIG. 29A

FIG. 29B

FIG. 30A

FIG. 30B

FIG. 31A

FIG. 31B

FIG. 32

FIG. 33

FIG. 34

FIG. 35

FIG. 36

FIG. 37A

FIG. 37B

FIG. 38

FIG. 39

FIG. 40

## INTERNATIONAL SEARCH REPORT

| International application No. |
| --- |
| **PCT/CN2024/134124** |

| A. | CLASSIFICATION OF SUBJECT MATTER |
| --- | --- |

H10K59/121(2023.01)i;  H10K59/131(2023.01)i

According to International Patent Classification (IPC) or to both national classification and IPC

| B. | FIELDS SEARCHED |
| --- | --- |

Minimum documentation searched (classification system followed by classification symbols)

IPC: H10K59/-、H01L

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI, IEEE: 显示, 透明, 透光, 透射, 屏下摄像头, 区域, 像素, 排布, 不同, 显示岛, 像素岛, 像素电路, 驱动, 阳极, 多个, 不同, 减小, 数量, 面积, 密度, 间隔, 交替, 中心对称, 对齐, 对准, display, transparent, FDC, arrange, different, island, pixel circuit, driving, anode, reduce, depress, density, area, space, alternant, centrosymmetric, align

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| E | CN 222356880 U (BOE TECHNOLOGY GROUP CO., LTD. et al.) 14 January 2025 (2025-01-14)<br>    description, paragraphs 135-333, and figures 1-40 | 1-24 |
| Y | CN 114335074 A (WUHAN TIANMA MICRO-ELECTRONICS CO., LTD.) 12 April 2022 (2022-04-12)<br>    description, paragraphs 92-210, and figures 2-59 | 1-24 |
| Y | CN 115804261 A (LG DISPLAY CO., LTD.) 14 March 2023 (2023-03-14)<br>    description, paragraphs 85-311, and figures 1-41 | 1-24 |
| Y | CN 113178537 A (WUHAN TIANMA MICRO-ELECTRONICS CO., LTD.) 27 July 2021 (2021-07-27)<br>    description, paragraphs 52-158, and figures 1-27 | 1-24 |
| A | CN 116913929 A (BOE TECHNOLOGY GROUP CO., LTD. et al.) 20 October 2023 (2023-10-20)<br>    entire document | 1-24 |

☑ Further documents are listed in the continuation of Box C.      ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **21 February 2025** | **26 February 2025** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2024/134124** |

### C. DOCUMENTS CONSIDERED TO BE RELEVANT

| Category* | Citation of document, with indication, where appropriate, of the relevant passages | Relevant to claim No. |
| --- | --- | --- |
| A | CN 114388592 A (SAMSUNG DISPLAY CO., LTD.) 22 April 2022 (2022-04-22)<br>entire document | 1-24 |
| A | CN 114883364 A (SAMSUNG DISPLAY CO., LTD.) 09 August 2022 (2022-08-09)<br>entire document | 1-24 |
| A | CN 110867476 A (WUHAN TIANMA MICRO-ELECTRONICS CO., LTD.) 06 March 2020<br>(2020-03-06)<br>entire document | 1-24 |
| A | CN 115483250 A (BOE TECHNOLOGY GROUP CO., LTD. et al.) 16 December 2022<br>(2022-12-16)<br>entire document | 1-24 |

Form PCT/ISA/210 (second sheet) (July 2022)

**INTERNATIONAL SEARCH REPORT**
Information on patent family members

International application No.

**PCT/CN2024/134124**

| Patent document cited in search report | | | Publication date (day/month/year) | Patent family member(s) | | | Publication date (day/month/year) |
|---|---|---|---|---|---|---|---|
| CN | 222356880 | U | 14 January 2025 | None | | | |
| CN | 114335074 | A | 12 April 2022 | US | 2022077265 | A1 | 10 March 2022 |
| CN | 115804261 | A | 14 March 2023 | DE | 112021003662 | T5 | 27 April 2023 |
| | | | | WO | 2022010278 | A1 | 13 January 2022 |
| | | | | US | 2022013598 | A1 | 13 January 2022 |
| | | | | KR | 20220007009 | A | 18 January 2022 |
| CN | 113178537 | A | 27 July 2021 | CN | 113178537 | B | 17 January 2023 |
| | | | | WO | 2022227265 | A1 | 03 November 2022 |
| | | | | US | 2024074268 | A1 | 29 February 2024 |
| CN | 116913929 | A | 20 October 2023 | None | | | |
| CN | 114388592 | A | 22 April 2022 | US | 2024215309 | A1 | 27 June 2024 |
| | | | | US | 2022130915 | A1 | 28 April 2022 |
| | | | | US | 11956997 | B2 | 09 April 2024 |
| | | | | KR | 20220053756 | A | 02 May 2022 |
| CN | 114883364 | A | 09 August 2022 | KR | 20220113584 | A | 16 August 2022 |
| | | | | US | 2022254853 | A1 | 11 August 2022 |
| | | | | US | 12185583 | B2 | 31 December 2024 |
| CN | 110867476 | A | 06 March 2020 | US | 2022336550 | A1 | 20 October 2022 |
| | | | | US | 2021159286 | A1 | 27 May 2021 |
| | | | | US | 11411056 | B2 | 09 August 2022 |
| | | | | CN | 110867476 | B | 04 October 2022 |
| CN | 115483250 | A | 16 December 2022 | CN | 215451420 | U | 07 January 2022 |
| | | | | WO | 2022252502 | A1 | 08 December 2022 |
| | | | | EP | 4207300 | A1 | 05 July 2023 |
| | | | | EP | 4207300 | A4 | 17 April 2024 |
| | | | | US | 2024389384 | A1 | 21 November 2024 |

Form PCT/ISA/210 (patent family annex) (July 2022)

**REFERENCES CITED IN THE DESCRIPTION**

**Patent documents cited in the description**

- CN 202311785367